(19) Europäisches Patentamt
European Patent Office
Office européen des brevets

(11) **EP 1 744 212 B1**

(12) **EUROPEAN PATENT SPECIFICATION**


(45) Date of publication and mention of the grant of the patent:
**11.01.2012 Bulletin 2012/02**

(51) Int Cl.:
***G03F 7/004*** *(2006.01)* ***G03F 7/031*** *(2006.01)*

(21) Application number: **06014591.9**

(22) Date of filing: **13.07.2006**


(54) **Photosensitive composition**

Lichtempfindliche Zusammensetzung

Composition photosensible


(84) Designated Contracting States:
**AT BE BG CH CY CZ DE DK EE ES FI FR GB GR HU IE IS IT LI LT LU LV MC NL PL PT RO SE SI SK TR**

(30) Priority: **13.07.2005 JP 2005204538**
**13.07.2005 JP 2005204539**

(43) Date of publication of application:
**17.01.2007 Bulletin 2007/03**



(73) Proprietor: **FUJIFILM Corporation**
**Minato-ku**
**Tokyo (JP)**

(72) Inventor: **Hanaki, Naoyuki**
**Minami-Ashigara-shi,**
**Kanagawa (JP)**

(74) Representative: **HOFFMANN EITLE**
**Patent- und Rechtsanwälte**
**Arabellastraße 4**
**81925 München (DE)**



(56) References cited:
**EP-A1- 1 048 982**
**EP-A2- 1 280 006**
**EP-A2- 1 471 387**
**JP-A- 2004 272 212**
**US-B1- 6 322 950**



Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).



EP 1 744 212 B1

## Description

### FIELD OF THE INVENTION

The present invention relates to a photosensitive composition capable of being hardened in high sensitivity upon exposure, and a novel dye compound used therein. More particularly, it relates to a photosensitive composition suitable for a photosensitive layer of a lithographic printing plate precursor capable of forming an image by scanning exposure based on digital signals and a novel dye compound used therein.

### BACKGROUND OF THE INVENTION

Hitherto, a PS plate having a construction such that a lipophilic photosensitive resin layer is provided on a hydrophilic support has been broadly used as a lithographic printing plate precursor. As for the plate-making method thereof, the PS plate is ordinarily subjected to mask exposure (open-frame-exposure) through a lith film and then dissolving and removing the non-image area to obtain a desired printing plate.

In recent years, digitization techniques of electronically processing, accumulating and outputting image information using a computer have been widespread and various new image output systems corresponding thereto have been put into practical use. As a result, a computer-to-plate (CTP) technique of directly producing a printing plate without using a lith film but by scanning highly directional light such as laser light based on the digitized image information is demanded and it is now an important technical subject to obtain a printing plate precursor suitable for such a technique.

As one system for obtaining such a lithographic printing plate precursor capable of conducting scanning exposure, a system of forming an ink-receptive resin layer region on a support having a hydrophilic surface is adopted. In the system, a material comprising a support provided thereon a negative-working photosensitive layer capable of being hardened by scanning exposure to form an ink-receptive region is used, and constructions using a photopolymerizable composition having excellent photosensitive speed have been heretofore proposed and some of the constructions are put into practical use. The lithographic printing plate precursor having such a construction is subjected to development processing in a simple manner and exhibits desirable printing plate performances and printing performances, for example, excellent resolution, ink-receptive property, printing durability and resistance to stain.

The photopolymerizable composition described above fundamentally comprises a polymerizable compound having an ethylenically unsaturated bond and a photo-initiation system and, if desired, a binder resin, and in the photopolymerizable composition, the photo-initiation system absorbs light by scanning exposure to generate an active species, for example, an active radical to induce and advance a polymerization reaction of the polymerizable compound, as a result, the exposed region is hardened, thereby forming an image.

As for the photopolymerizable composition capable of conducting the scanning exposure, various photo-initiation systems excellent in photosensitivity are described (see, for example, Bruce M. Monroe et al., Chemical Review, Vol. 93, pages 435 to 448 (1993) and R S. Davidson, Journal of Photochemistry and Biology A: Chemistry, Vol. 73, pages 81 to 96 (1993)). When such photo-initiation systems are applied to a conventional CTP system using as a light source, a long wavelength visible light source, for example, an Ar laser (488 nm) or FD-YAG laser (532 nm), sufficient sensitivity can not be obtained under the present situation where output of the light source is not adequately large and thus, a photo-initiation system having high sensitivity capable of adapting exposure of higher speed has been desired.

On the other hand, a semiconductor laser capable of performing continuous oscillation in the region of 350 to 450 nm using, for example, an InGaN series material has been recently put into practical use. A scanning exposure system using such a short wavelength light source is advantageous in that an economical system can be constructed while maintaining sufficiently high output since the semiconductor laser can be produced at a low cost in view of its structure, Also, in comparison with a conventional system using an FD-YAG or Ar laser, a photosensitive material having photosensitivity in a short wavelength region which enables operation under brighter safe light can be employed. However, a photo-initiation system having sensitivity sufficient for the scanning exposure in the short wavelength region of 350 to 450 nm has not yet been known.

Under these circumstances, a photosensitive composition containing a sensitizing dye highly sensitive in such a short wavelength region has been proposed (see JP-A-2000-258910 (the term "JP-A" as used herein means an "unexamined published Japanese patent application")), but it is required for a photo-initiation system including such a sensitizing dye to further increase sensitivity.

Further, as described, for example, in J. P. Faussier, Photoinitiated Polymerization-Theory and Applications: Rapra Review, Vol. 9, Rapra Technology (1998) and M. Tsunooka et al., Prog. Polym. Sci., Vol, 21, page 1 (1996), the technique for obtaining a photo-initiation system having a high sensitivity is still keenly demanded widely in the imaging field. A photo-initiation system comprising a sensitizing dye and an initiator compound can generate an acid or a base besides the active radical, according to appropriate selection of the initiator compound and be also applied to image formation, for example, optical modeling (rapid prototyping), holography and color hard copy, to a field of production of

an electronic material, for example, photoresist, or to use as a photocurable resin material, for example, ink, paint or adhesive. It is highly desired in these industrial fields to find a sensitizing dye excellent in light-absorbing property and sensitizing ability in order to effectively induce decomposition of the initiator compound.

US-B1-6322950, EP-A-1471387, EP-A-1280006 and JP-A-2004272212 disclose photosensitive compositions containing specific sensitizing dyes.

SUMMARY OF THE INVENTION

In consideration of the above problems, an object of the present invention is to provide a photosensitive composition which is useful for a photosensitive layer of a lithographic printing plate precursor for scanning exposure adapting to the CTP system excellent in workability and profitability, which is highly sensitive to an oscillation wavelength of an inexpensive short wavelength semiconductor laser and which uses a novel photo-initiation system highly sensitive to light of a wide wavelength range from 350 to 450 nm.

As a result of extensive investigations to achieve the above-described object, the inventor has found that a novel photo-initiation system comprising a sensitizing dye having a specific structure and an initiator compound provides a high photosensitivity, particularly, in a wavelength range approximately from 350 to 450 nm, to complete the invention. Specifically, the present invention includes the following items.

(1) A photosensitive composition comprising (A) a sensitizing dye selected from the group consisting of compounds represented by formulae (1) and (2) shown below, (B) an initiator compound capable of generating a radical, an acid or a base, and (C) a compound capable of changing irreversibly its physical or chemical property with at least any one of a radical, an acid and a base:

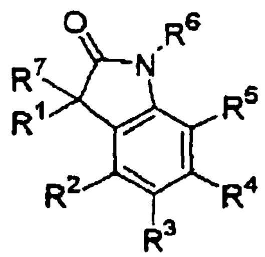

(1)

in formula (1), $R^1$, $R^2$, $R^3$, $R^4$, $R^3$, $R^6$ and $R^7$ each independently represents a hydrogen atom or a monovalent substituent, alternatively $R^1$ or $R^7$ and $R^2$, $R^5$ and $R^6$, or adjacent $R^2$ and $R^3$, $R^3$ and $R^4$ or $R^4$ and $R^5$ may be combined with each other to form a ring, or $R^1$ and $R^7$ may come together to form an atomic group connected with a double bond to the carbon atom substituted with $R^1$ and $R^7$;

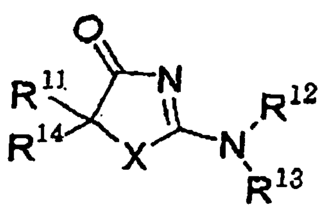

(2)

in formula (2), X represents an oxygen atom, a sulfur atom or -N($R^{15}$)-, $R^{15}$ represents a hydrogen atom or a monovalent substituent, $R^{11}$, $R^{12}$, $R^{13}$ and $R^{14}$ each independently represents a hydrogen atom or a monovalent substituent, alternatively $R^{12}$ and $R^{13}$, $R^{15}$ and $R^{12}$ or $R^{13}$, or $R^{15}$ and $R^{11}$ or $R^{14}$ may be combined with each other to form a ring, or $R^{11}$ and $R^{14}$ may come together to form an atomic group connected with a double bond to the carbon atom substituted with $R^{11}$ and $R^{14}$.

(2) The photosensitive composition as described in (1) above, which further comprises a binder polymer.

(3) The photosensitive composition as described in (1) or (2) above, wherein the initiator compound is a hexaarylbiimidazole compound.

(4) The photosensitive composition as described in any one of (1) to (3) above, which further comprises a chain transfer agent.

(5) The photosensitive composition as described in any one of (1) to (4), wherein the compound capable of changing irreversibly its physical or chemical property with at least any one of a radical, an acid and a base is an addition polymerizable compound having an ethylenically unsaturated double bond.

(6) The photosensitive composition as described in any one of (1) to (5) above, wherein the sensitizing dye has an absorption maximum wavelength from 350 to 450 nm.

(7) A photopolymerization method comprising exposing the photosensitive composition as described in any one of (1) to (6) above with a laser beam having a wavelength of 450 nm or less.

(8) A lithographic printing plate precursor comprising a support having thereon a photosensitive layer comprising the photosensitive composition as described in any one of (1) to (6) above.

Although the function mechanism according to the invention is not quite clear, the sensitizing dye represented by formula (1) or (2) is highly sensitive to light of a wavelength range from 350 to 450 nm and forms the electron excited state in high sensitivity upon irradiation (exposure) of an inexpensive short wavelength semiconductor laser, and electron transfer, energy transfer or heat generation relating to the electron excited state due to the light absorption acts on the coexistent initiator compound to cause chemical change in the initiator compound, thereby generating a radical, an acid or a base. Then, with at least one of the radical, acid or base thus-generated, the compound capable of changing irreversibly its physical or chemical property with at least one of a radical, an acid and a base undergoes irreversible change, for example, color formation, decoloration or polymerization. When an addition polymerizable compound having an ethylenically unsaturated double bond that is preferable among these compounds is used, a hardening reaction initiates and proceeds to harden the exposed region. Thus, since the photosensitive composition according to the invention has sensitivity sufficient for scanning exposure by a short wavelength semiconductor laser and do not have an absorption maximum in an ultraviolet region, the use of the photosensitive composition is advantageous in view of excellent stability under a white light and handling ability under a bright fluorescent lamp. Therefore, it is believed that a lithographic printing plate precursor having a photosensitive layer comprising the photosensitive composition containing the addition polymerizable compound is capable of conducting recording in high sensitivity, excellent in safe light stability, prevented from the occurrence of undesirable satin in the non-image area and exhibits excellent printing durability.

The photosensitive composition according to the invention is useful for a photosensitive layer of a lithographic printing plate precursor which has sufficient sensitivity suitable for scanning exposure by a short wavelength semiconductor laser, for example, InGaN and is excellent in printing durability, resistance to stain and stability. Also, when the sensitizing dye represented by formula (1) or (2) according to the invention is applied to a photo-initiation system used in the photosensitive composition, it exhibits the effect of generating a radical, an acid or a base in high sensitivity to an oscillation wavelength of the short wavelength semiconductor laser.

## DETAILED DESCRIPTION OF THE INVENTION

The present invention will be described in more detail below.

The photosensitive composition according to the invention contains (A) a sensitizing dye represented by formula (1) or (2), (B) an initiator compound capable of generating a radical, an acid or a base, and (C) a compound capable of changing irreversibly its physical or chemical property with at least any one of a radical, an acid and a base. Among them, (A) the sensitizing dye represented by formula (1) or (2) and (B) the initiator compound capable of generating a radical, an acid or a base constitute a photo-initiation system of the photosensitive composition. In the photo-initiation system, upon the function of electron transfer, energy transfer or heat generation due to the electron excited state caused by the light absorption of (A) the sensitizing dye represented by formula (1) or (2), the initiator compound undergoes chemical change to generate a radical, an acid or a base.

Now, the photo-initiation system is described below.

One of the features of (A) the sensitizing dye having the specific structure useful for the photo-initiation system according to the invention is that it has a particularly excellent absorption characteristic in a wavelength range from 350 to 450 nm. Further, (A) the sensitizing dye having the specific structure according to the invention can efficiently induce decomposition of various types of (B) the initiator compounds to exhibit extremely high sensitivity. In general, with respect to sensitization mechanism of the photo-initiation system comprising sensitizing dye/initiator compound, there are known a route (a); reductive decomposition of the initiator compound based on electron transfer from the sensitizing dye in the electron excited state to the initiator compound, a route (b): oxidative decomposition of the initiator compound based on electron transfer from the initiator compound to the sensitizing dye in the electron excited state, and a route (c): decomposition of the initiator compound in the electron excited state based on energy transfer from the sensitizing dye in the electron excited state to the initiator compound. It has been found that the sensitizing dye according to the invention causes with excellent efficiency any type of the sensitizing reactions.

The inventor has found that it is very important for the sensitizing dye to have the structure represented by formula (I) or (2) in order to achieve high sensitivity, although the function mechanism thereof is not quite clear. The

sensitizing dye according to the invention exhibits a high-intensity light emission (fluorescence and/or phosphorescence) spectrum and from the fact it is considered, as one possibility, that the sensitizing dye having the above described structure has a relatively long life in the excited state and thus, acts to allow the reaction with the initiator compound to efficiently proceed. As another possibility, it is considered that the structure represented by formula (1) or (2) contributes to promote efficiency in an early process (for example, electron transfer) of the sensitization reaction or to promote efficiency in a successive reaction leading to the decomposition of initiator compound.

The compound represented by formula (1) or (2) according to the invention is employed as a sensitizing dye.

The structure of the compound represented by formula (1) will be described in greater detail below.

In formula (1), $R^1$, $R^2$, $R^3$, $R^4$, $R^5$, $R^6$ and $R^7$ each independently represents a hydrogen atom or a monovalent substituent. Examples of the monovalent substituent (hereinafter, also referred to as substituent R) include a halogen atom, an alkyl group (including a cycloalkyl group and a bicycloalkyl group), an alkenyl group (including a cycloalkenyl group and a bicycloalkenyl group), an alkynyl group, an aryl group, a heterocyclic group, a cyano group, a hydroxy group, a nitro group, a carboxy group, an alkoxy group, an aryloxy group, a silyloxy group, a heterocyclic oxy group, an acyloxy group, a carbamoyloxy group, an alkoxycarbonyloxy group, an aryloxycarbonyloxy group, an amino group (including an aniline group), an acylamino group, an aminocarbonylamino group, an alkoxycarbonylamino group, an aryloxycarbonylamino group, a sulfamoylamino group, an alkyl or aryl sulfonylamino group, a mercapto group, an alkylthio group, an arylthio group, a heterocyclic thio group, a sulfamoyl group, a sulfo group, an alkyl or aryl sulfinyl group, an alkyl or aryl sulfonyl group, an acyl group, an aryloxycarbonyl group, an alkoxycarbonyl group, a carbamoyl group, an aryl or heterocyclic azo group, an imido group, a phosphino group, a phosphinyl group, a phosphinyloxy group, a phosphinylamino group and a silyl group.

More specifically, R represents a halogen atom (for example, a chlorine atom, a bromine atom or an iodine atom), an alkyl group [representing a straight-chain, branched or cyclic, substituted or unsubstituted alkyl group and including an alkyl group (preferably a substituted or unsubstituted alkyl group having from 1 to 30 carbon atoms, for example, methyl, ethyl, n-propyl, isopropyl, tert-butyl, n-octyl, eucosyl, 2-chloroethyl, 2-cyanoethyl or 2-ethylhexyl), a cycloalkyl group (preferably a substituted or unsubstituted cycloalkyl group having from 3 to 30 carbon atoms, for example, cyclohexyl, cyclopentyl or 4-n-dodecylcyclohexyl), a bicycloalkyl group (preferably a substituted or unsubstituted bicycloalkyl group having from 5 to 30 carbon atoms, that is, a monovalent group formed by eliminating one hydrogen atom from a bicycloalkane having from 5 to 30 carbon atoms, for example, bicycle[1,2,2]heptan-2-yl or bicycle[2,2,2]octan-3-yl) and a cycloalkyl group having more cyclic structures, for example, a tricycloalkyl group; the alkyl group included in the substituent described hereinafter (for example, the alkyl group in the alkylthio group) also having the same meaning as described above]; an alkenyl group [representing a straight-chain, branched or cyclic, substituted or unsubstituted alkenyl group and including an alkenyl group (preferably a substituted or unsubstituted alkenyl group having from 2 to 30 carbon atoms, for example, vinyl, allyl, prenyl, geranyl or oleyl), a cycloalkenyl group (preferably a substituted or unsubstituted cycloalkenyl group having from 3 to 30 carbon atoms, that is, a monovalent group formed by eliminating one hydrogen atom from a cycloalkene having from 3 to 30 carbon atoms, for example, 2-cyclopenten-1-yl or 2-cyclohexen-1-yl), and a bicycloalkenyl group (preferably a substituted or unsubstituted bicycloalkenyl group having from 5 to 30 carbon atoms, that is, a monovalent group formed by eliminating one hydrogen atom from a bicycloalkene having one double bond, for example, bicycle[2,2,1]hept-2-en-1-yl or bicycle[2,2,2]oct-2-en-4-yl)]; an alkynyl group (preferably a substituted or unsubstituted alkynyl group having from 2 to 30 carbon atoms, for example, ethynyl, propargyl or trimethylsilylethynyl); an aryl group (preferably a substituted or unsubstituted aryl group having from 6 to 30 carbon atoms, for example, phenyl, p-tolyl, naphthyl, m-chlorophenyl or o-nexadecanoylaminophenyl); a heterocyclic group (preferably a monovalent group formed by eliminating one hydrogen atom from a 5-membered or 6-membered, substituted or unsubstituted, aromatic or non-aromatic heterocyclic compound, more preferably a 5-membered or 6-membered aromatic heterocyclic group having from 5 to 30 carbon atoms, for example, 2-furyl, 2-thienyl, 2-pyrimidinyl or 2-benzothiazolyl); a cyano group; a hydroxy group; a nitro group; a carboxy group; an alkoxy group (preferably a substituted or unsubstituted alkoxy group having from 1 to 30 carbon atoms, for example, methoxy, ethoxy, isopropoxy, tert-butoxy, n-octyloxy or 2-methoxyethoxy); an aryloxy group (preferably a substituted or unsubstituted aryloxy group having from 6 to 30 carbon atoms, for example, phenoxy, 2-methyphenoxy, 4-tert-butylphenoxy, 3-nitrophenoxy or 2-tetradecanoylaminophenoxy); an silyloxy group (preferably a silyloxy group having from 3 to 20 carbon atoms, for example, trimethylsilyloxy or tert-butyldimethylsilyloxy); a heterocyclic oxy group (preferably a substituted or unsubstituted heterocyclic oxy group having from 2 to 30 carbon atoms, for example, 1-phenyltetrazol-5-oxy or 2-tetrahydropyranyloxy); an acyloxy group (preferably a formyloxy group, a substituted or unsubstituted alkylcarbonyloxy group having from 2 to 30 carbon atoms or a substituted or unsubstituted arylcarbonyloxy group having from 6 to 30 carbon atoms, for example, formyloxy, acetyloxy, pivaloyloxy, stearoyloxy, benzoyloxy or p-methoxyphenylcarbonyloxy); a carbamoyloxy group (preferably a substituted or unsubstituted carbamoyloxy group having from 1 to 30 carbon atoms, for example, N,N-dimethylcarbamoyloxy, N,N-diethylcarbamoyloxy, morpholinocarbonyloxy, N,N-di-n-octylaminocarbonyloxy or N-n-octylcarbamoyloxy); an alkoxycarbonyloxy group (preferably a substituted or unsubstituted alkoxycarbonyloxy group having from 2 to 30 carbon atoms, for example, methoxycarbonyloxy, ethoxycarbonyloxy, tert-butoxycarbonyloxy or n-octyloxycarbonyloxy), an aryloxycarbonyloxy group (preferably a substituted or unsubstituted aryloxycarbonyloxy group having from 7 to 30 carbon atoms, for example, phenoxycarbonyloxy, p-methoxyphenoxycarbonyloxy or p-n-hexadecyloxyphenoxycarbonyloxy); an amino group (preferably an amino group, a substituted or unsubstituted alkylamino group having from 1 to 30 carbon atoms or a substituted or unsubstituted anilino group having from 6 to 30 carbon atoms, for example, amino, methylamino, dimethylamino, anilino, N-methylanilino or diphenylamino); an acylamino group (preferably a formylamino group, a substituted or unsubstituted alkylcarbonylamino group having from 1 to 30 carbon atoms or a substituted or unsubstituted arylcarbonylamino group having from 6 to 30 carbon atoms, for example, formylamino, acetylamino, pivaloylamino, lauroylamino, benzoylamino or 3,4,5-tri-n-octyloxyphenylcarbonylamino); an aminocarbonylamino group (preferably a substituted or unsubstituted aminocarbonylamino group having from 1 to 30 carbon atoms, for example, carbamoylamino, N,N-dimethylaminocarbonylamino, N,N-diethylaminocarbonylamino or morpholinocarbonylamino); an alkoxycarbonylamino group (preferably a substituted or unsubstituted alkoxycarbonylamino group having from 2 to 30 carbon atoms, for example, methoxycarbonylamino, ethoxycarbonylamino, tert-butoxycarbonylamino, n-octadecyloxycarbonylamino or N-methylmethoxycarbonylamino); an aryloxycarbonylamino group (preferably a substituted or unsubstituted aryloxycarbonylamino group having from 7 to 30 carbon atoms, for example, phenoxycarbonylamino, p-chlorophenoxycarbonylamino or m-n-octyloxyphenoxycarbonylamino), a sulfamoylamino group (preferably a substituted or unsubstituted sulfamoylamino group having from 0 to 30 carbon atoms, for example, sulfamoylamino, N,N-dimethylaminosulfonylamino or N-n-octylaminosulfonylamino); an alkyl or aryl sulfonylamino group (preferably a substituted or unsubstituted alkylsulfonylamino group having from 1 to 30 carbon atoms or a substituted or unsubstituted arylsulfonylamino group having from 6 to 30 carbon atoms, for example, methylsulfonylamino, butylsulfonylamino, phenylsulfonylamino, 2,3,5-trichlorophenylsulfonylamino or p-methylphenylsulfonylamino); a mercapto group; an alkylthio group (preferably a substituted or unsubstituted alkylthio group having from 1 to 30 carbon atoms, for example, methylthio, ethylthio or n-hexadecylthio); an arylthio group (preferably a substituted or unsubstituted arylthio group having from 6 to 30 carbon atoms, for example, phenylthio, p-chlorophenylthio or m-methoxyphenylthio); a heterocyclic thio group (preferably a substituted or unsubstituted heterocyclic thio group having from 2 to 30 carbon atoms, for example, 2-benzothiazolylthio or I-phenyltetrazol-5-ylthio); a sulfamoyl group (preferably a substituted or unsubstituted sulfamoyl group having from 0 to 30 carbon atoms, for example, N-ethylsulfamoyl, N-(3-dodecyloxypropyl)sulfamoyl, N,N-dimethylsulfamoyl, N-acetylsulfamoyl; N-benzoylsulfamoyl or N-(N'-phenylcarbamoyl)sulfamoyl), a sulfo group; an alkyl or aryl sulfinyl group (preferably a substituted or unsubstituted alkylsulfinyl group having from 1 to 30 carbon atoms or a substituted or unsubstituted arylsulfinyl group having from 6 to 30 carbon atoms, for example, methylsulfinyl, ethylsulfinyl, phenylsulfinyl or p-methylphenylsulfinyl); an alkyl or aryl sulfonyl group (preferably a substituted or unsubstituted alkylsulfonyl group having from 1 to 30 carbon atoms or a substituted or unsubstituted arylsulfonyl group having from 6 to 30 carbon atoms, for example, methylsulfonyl, ethylsulfonyl, phenylsulfonyl or p-methylphenylsulfonyl); an acyl group (preferably a formyl group, a substituted or unsubstituted alkylcarbonyl group having from 2 to 30 carbon atoms, a substituted or unsubstituted arylcarbonyl group having from 7 to 30 carbon atoms or a substituted or unsubstituted heterocyclic carbonyl group having from 4 to 30 carbon atoms wherein the hetero ring is connected to the carbonyl group via a carbon atom, for example, acetyl, pivaloyl, 2-chloroacetyl, stearoyl, benzoyl, p-n-octyloxyphenylcarbonyl, 2-pyridylcarbonyl or 2-furylcarbonyl); an aryloxycarbonyl group (preferably a substituted or unsubstituted aryloxycarbonyl group having from 7 to 30 carbon atoms, for example, phenoxycarbonyl, o-chlorophenoxycarbonyl, m-nitrophenoxycarbonyl or p-tert-butylphenoxycarbonyl); an alkoxycarbonyl group (preferably a substituted or unsubstituted alkoxycarbonyl group having from 2 to 30 carbon atoms, for example, methoxycarbonyl, ethoxycarbonyl, tert-butoxycarbonyl or n-octadecyloxycarbonyl); a carbamoyl group (preferably a substituted or unsubstituted carbamoyl group having from 1 to 30 carbon atoms, for example, carbamoyl, N-methylcarbamoyl, N,N-dimethylcarbamoyl, N,N-di-n-octylcarbamoyl or N-(methylsulfonyl)carbamoyl); an aryl or heterocyclic azo group (preferably a substituted or unsubstituted aryl azo group having from 6 to 30 carbon atoms or a substituted or unsubstituted heterocyclic azo group having from 3 to 30 carbon atoms, for example, phenylazo, p-chlorophenylazo or 5-ethylthio-1,3,4-tiadiazol-2-ylazo); an imido group (preferably N-succinimide or N-phthalimido); a phosphino group (preferably a substituted or unsubstituted phosphino group having from 2 to 30 carbon atoms, for example, dimethylphosphino, diphenylphosphino or methylphenoxyphosphino); a phosphinyl group (preferably a substituted or unsubstituted phosphinyl group having from 2 to 30 carbon atoms, for example, phosphinyl, dioctyloxyphosphinyl or diehtoxyphosphinyl); a phosphinyloxy group (preferably a substituted or unsubstituted phosphinyloxy group having from 2 to 30 carbon atoms, for example, diphenylphosphinyloxy or dioctyloxyphosphinyloxy); a phosphinylamino group (preferably a substituted or unsubstituted phosphinylamino group having from 2 to 30 carbon atoms, for example, dimethoxyphosphinylamino or dimethylaminophosphinylamino); or a silyl group (preferably a substituted or unsubstituted silyl group having from 3 to 30 carbon atoms, for example, trimethylsilyl, tert-butyldimethylsilyl or phenyldimethylsilyl).

Of the substituents described above, in those having a hydrogen atom, the hydrogen atom may be substituted with the substituent described above. Examples of such functional group include an alkylcarbonylaminosulfonyl group, an arylcarbonylaminosulfonyl group, an alkylsulfonylaminocarbonyl group and an arylsulfonylaminocarbonyl group. Specific examples thereof include methylsulfonylaminocarbonyl, p-methylphenylsulfonylaminocarbonyl, acetylaminosulfonyl

and benzoylaminosulfonyl.

$R^1$ or $R^7$ and $R^2$, $R^5$ and $R^6$, or adjacent $R^2$ and $R^3$, $R^3$ and $R^4$ or $R^4$ and $R^5$ may be combined with each other to form a ring. The ring formed is preferably a 5-memberd, 6-membered or 7-membered ring together with the carbon atom or nitrogen atom described in formula (1). The ring formed may further have a substituent. Examples of the substituent include those described above for the monovalent substituent R.

$R^1$ and $R^7$ may come together to form an atomic group connected with a double bond to the carbon atom substituted with $R^1$ and $R^7$. In this case, the double bond is preferably a C=C bond or a C=N bond.

$R^1$ and $R^7$ preferably independently represents a hydrogen atom, an aryl group or a heterocyclic group. More preferably, $R^1$ and $R^7$ are come together to form an atomic group connected with a double bond to the carbon atom substituted with $R^1$ and $R^7$. In this case, as the atomic group formed, an atomic group having an atom or group selected from a hydrogen atom, an alkyl group, an aryl group and a heterocyclic group connected to a terminal atom of the double bond is preferable. Still more preferably, $R^1$ and $R^7$ are come together to form $=C(R^8)(R^9)$ wherein $R^8$ represents a hydrogen atom and $R^9$ represents an aryl group or a heterocyclic group. The aryl group or heterocyclic group may further have a substituent. Examples of the substituent include those described above for the monovalent substituent R

$R^2$, $R^3$, $R^4$ and $R^5$ independently represents preferably a hydrogen atom, an alkyl group, an aryl group, a cyano group, a carbonyl group or an alkoxy group, more preferably an alkyl group or an alkoxy group.

$R^6$ represents preferably a hydrogen atom or an alkyl group, particularly preferably an alkyl group.

The compound represented by formula (1) includes geometric isomers with respect to the double bond, and any of the E isomer, the Z isomer and a mixture thereof in an appropriate ratio can be used.

The compound represented by formula (1) also includes tautomers which are interconvertible depending on circumstances surrounding the compound. Although the compound is represented by one of the representative isomers herein, it should be noted that isomers other than the isomer described herein also included in the compound according to the invention.

The compound represented by formula (I) may contain an isotopic element, for example, $^{2}H$, $^{3}H$, $^{13}C$, $^{15}N$, $^{17}O$ or $^{18}O$.

Specific examples of the compound represented by formula (1) are set forth below, but the invention should not be construed as being limited thereto,

(1)
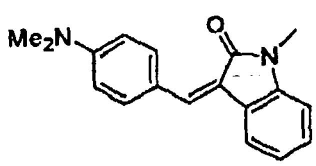

(2)
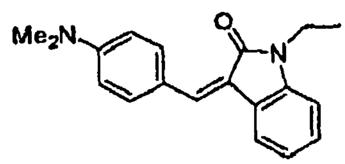

(3)
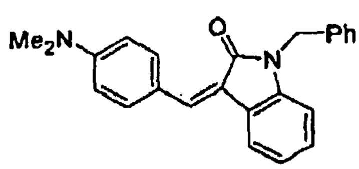

(4)
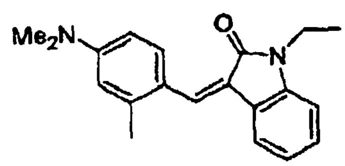

(5)
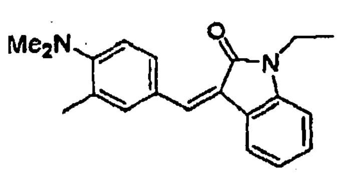

(6)
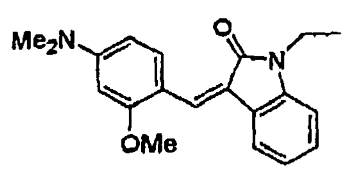

(7)

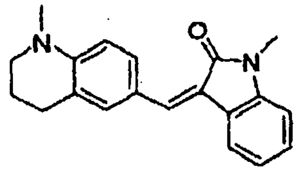

(8)

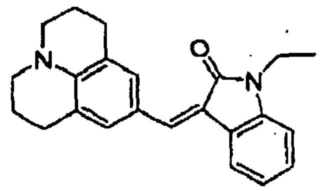

(9)

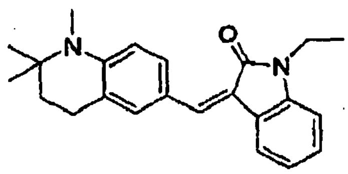

(10)

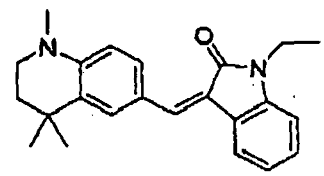

(11)

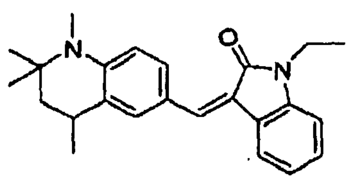

(12)

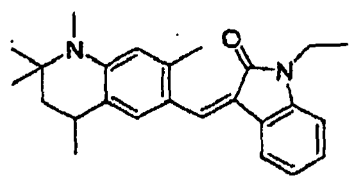

(13)

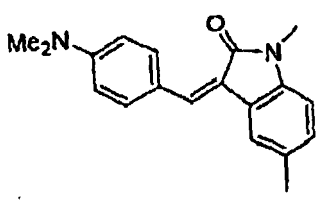

(14)

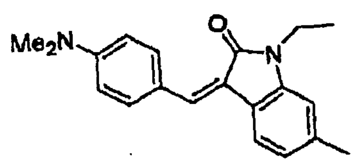

(15)

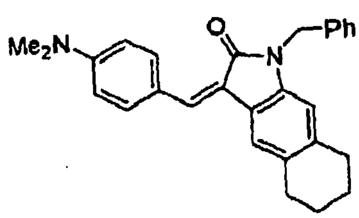

(16)

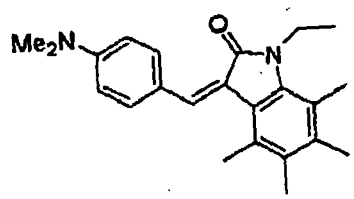

(17)

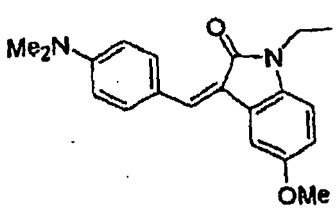

(18)

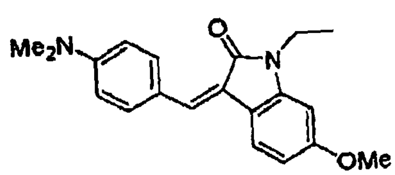

(19)

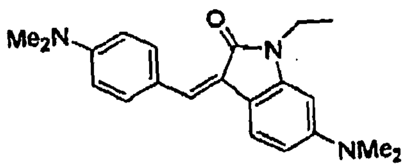

(20)

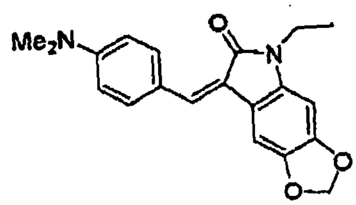

(21)

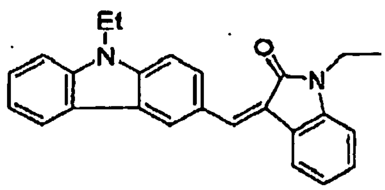

(22)

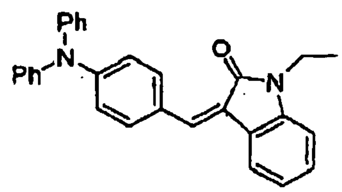

(23)

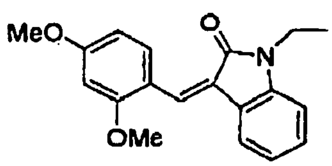

(24)

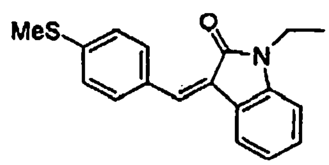

(25)

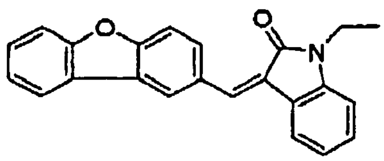

(26)

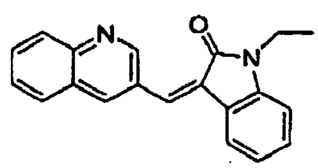

(27)

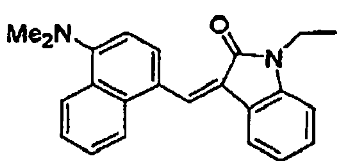

(28)

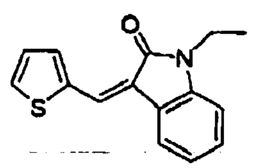

(29)

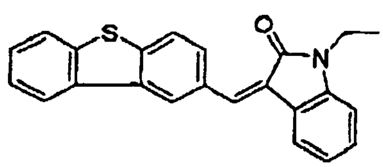

(30)

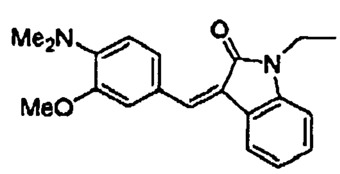

(31) 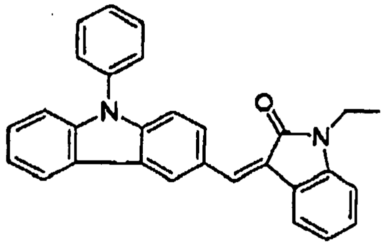

(32) 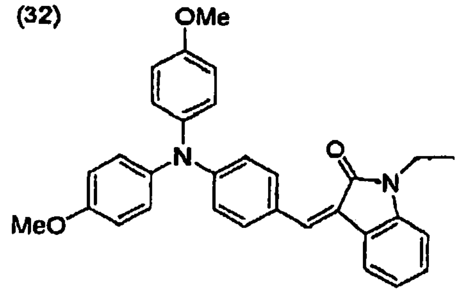

(33) 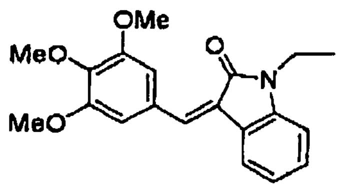

(34) 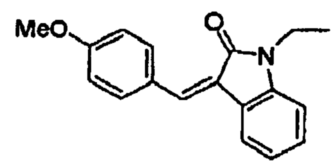

(35) 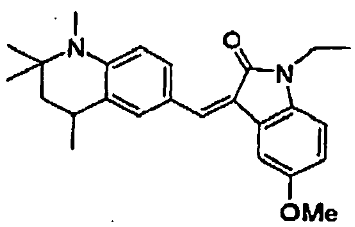

(36) 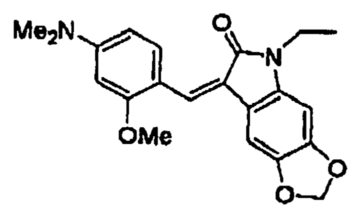

The compound represented by formula (1) can be synthesized with reference to methods described, for example, in J. Chem. Soc., 1941, 620, J. Am. Chem. Soc., 1951, 73, 5326 or J. Med. Chem., 1998, 41, 2588.

Next, the structure of the compound represented by formula (2) will be described in greater detail below.

In formula (2), $R^{11}$, $R^{12}$, $R^{13}$ and $R^{14}$ each independently represents a hydrogen atom or a monovalent substituent. The monovalent substituent is same as that described for the substituent R with respect to $R^1$ to $R^7$ in formula (1) above.

$R^{12}$ and $R^{13}$ may be combined with each other to form a ring. The ring formed is preferably a 5-memberd, 6-membered or 7-membered ring including $R^{12}$ and $R^{13}$ together with the nitrogen atom. The ring formed may further have a substituent. Examples of the substituent include those described above for the monovalent substituent R.

$R^{11}$ and $R^{14}$ may come together to form an atomic group connected with a double bond to the carbon atom substituted with $R^{11}$ and $R^{14}$. In this case, the double bond is preferably a C=C bond or a C=N bond.

$R^{11}$ and $R^{14}$ preferably independently represents a hydrogen atom, an aryl group or a heterocyclic group.

More preferably, $R^{11}$ and $R^{14}$ are come together to form an atomic group connected with a double bond to the carbon atom substituted with $R^{11}$ and $R^{14}$. In this case, as the atomic group formed, an atomic group having an atom or group selected from a hydrogen atom, an alkyl group, an aryl group and a heterocyclic group connected to a terminal atom of the double bond is preferable. The alkyl group, aryl group or heterocyclic group may further have a substituent. Examples of the substituent include those described above for the monovalent substituent R.

Still more preferably, $R^{11}$ and $R^{14}$ are come together to form =C($R^{11}$($R^{17}$) wherein $R^{16}$ represents a hydrogen atom and $R^{17}$ represents an aryl group or a heterocyclic group. The aryl group or heterocyclic group may further have a substituent. Examples of the substituent include those described above for the monovalent substituent R

$R^{12}$ and $R^{13}$ independently represents preferably an alkyl group or an aryl group, more preferably an aryl group, particularly preferably a phenyl group.

X represents an oxygen atom, a sulfur atom or -N($R^{15}$)-. $R^{15}$ represents a hydrogen atom or a monovalent substituent. Examples of the monovalent substituent for $R^{15}$ include those described above for the monovalent substituent R. X is preferably an oxygen atom or a sulfur atom, more preferably a sulfur atom.

$R^{15}$ and $R^{12}$ or $R^{13}$ may be combined with each other to form a ring. The ring formed is preferably a 5-memberd, 6-membered or 7-membered ring including $R^{15}$ and $R^{12}$ or $R^{13}$ together with the carbon atom and nitrogen atom. The ring formed may further have a substituent. Examples of the substituent include those described above for the monovalent substituent R.

$R^{15}$ and $R^{11}$ or $R^{12}$ may be combined with each other to form a ring. The ring formed is preferably a 5-memberd, 6-membered or 7-membered ring including $R^{15}$ and $R^{11}$ or $R^{12}$ together with the carbon atom and nitrogen atom. The ring formed may further have a substituent. Examples of the substituent include those described above for the monovalent substituent R.

The compound represented by formula (2) includes geometric isomers with respect to the double bond, and any of the E isomer, the Z isomer and a mixture thereof in an appropriate ratio can be used.

The compound represented by formula (2) also includes tautomers which are interconvertible depending on circumstances surrounding the compound. Although the compound is represented by one of the representative isomers herein, it should be noted that isomers other than the isomer described herein also included in the compound according to the invention.

The compound represented by formula (2) may contain an isotopic element, for example, $^{2}H$, $^{3}H$, $^{13}C$, $^{15}N$, $^{17}O$ or $^{18}O$.

Specific examples of the compound represented by formula (2) are set forth below, but the invention should not be construed as being limited thereto.

(101)

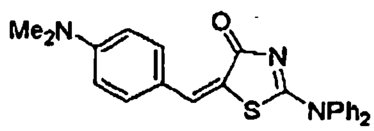

(102)

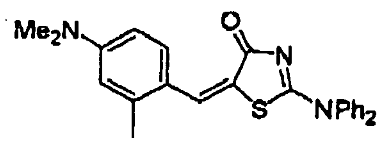

(103)

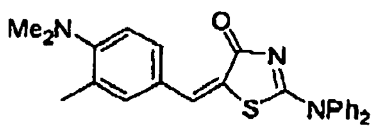

(104)

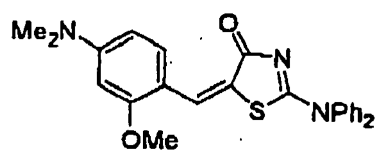

(105)

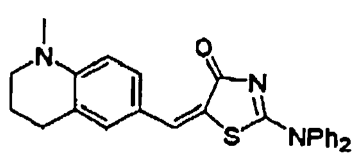

(106)

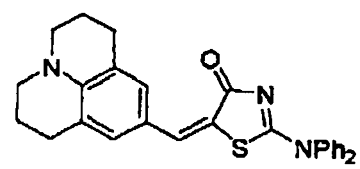

(107)

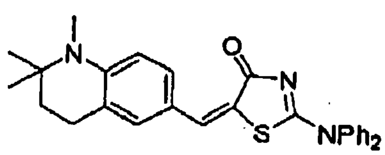

(108)

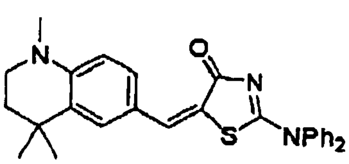

(109)

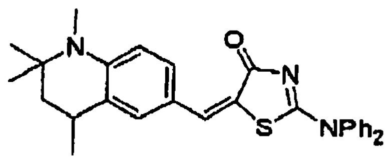

(110)

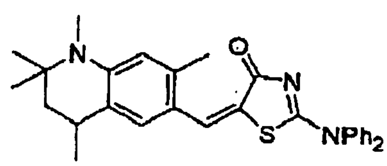

(111)

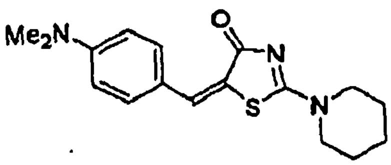

(112)

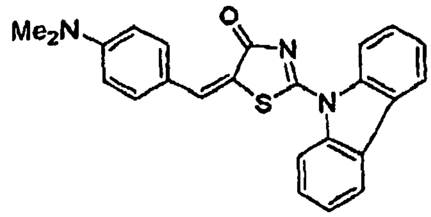

(113)

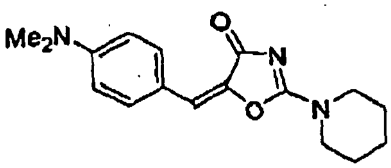

(114)

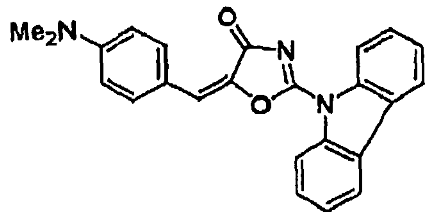

(115)

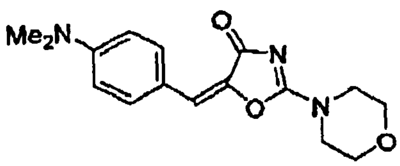

(116)

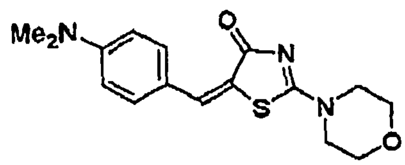

(117)

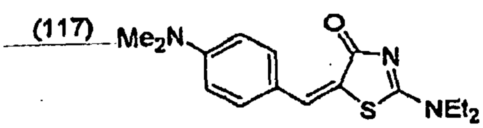

(118)

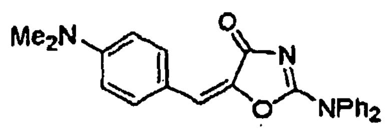

(119)

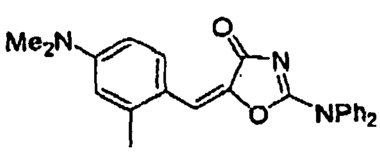

(120)

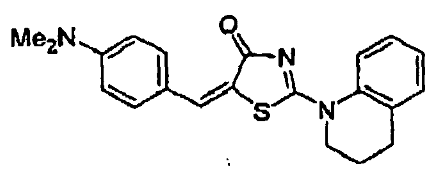

(121)

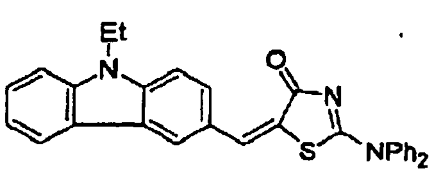

(122)

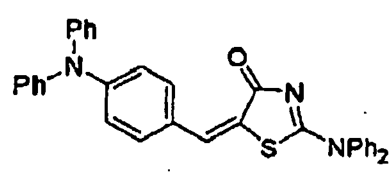

(123)
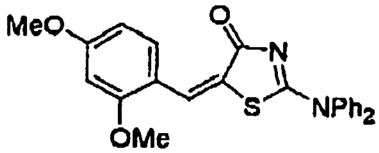

(124)
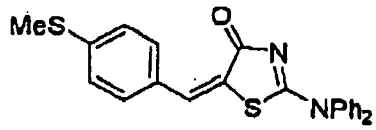

(125)
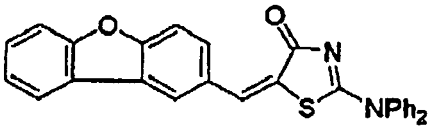

(126)
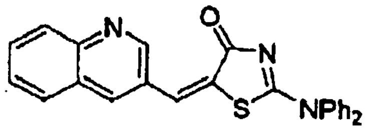

(127)
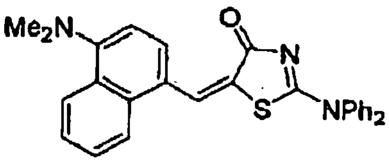

(128)
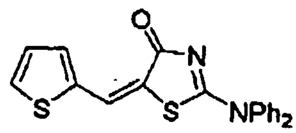

(129)
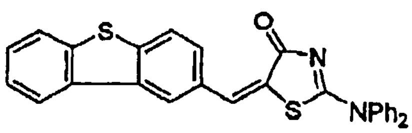

(130)
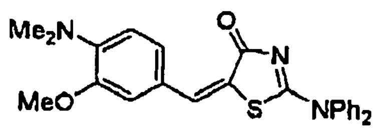

(131)
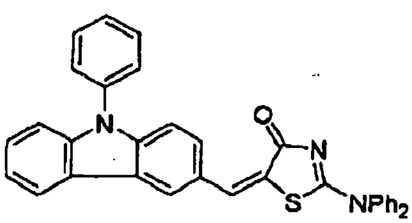

(132)
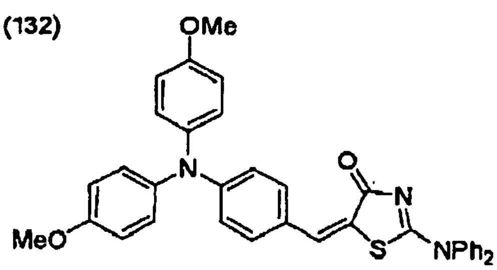

(133)
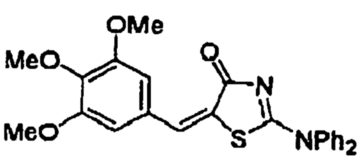

(134)
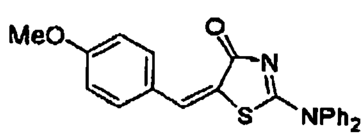

(135)

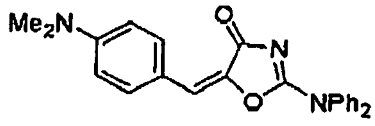

(136)

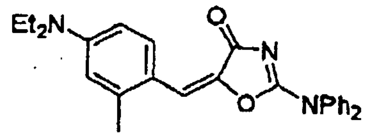

(137)

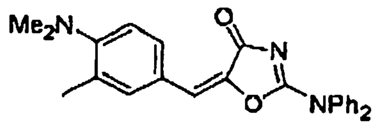

(138)

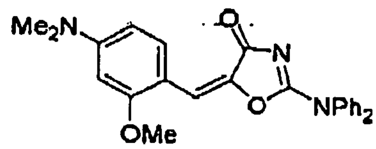

(139)

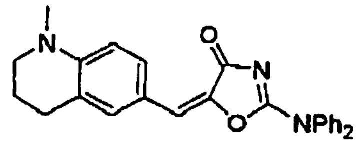

(140)

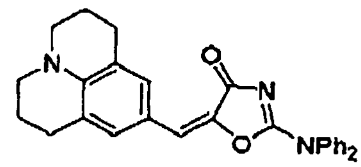

(141)

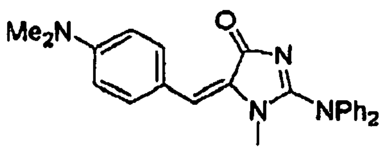

(142)

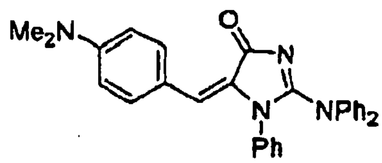

(143)

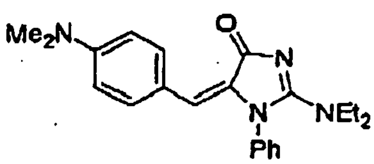

(144)

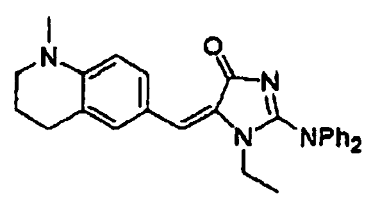

(145)

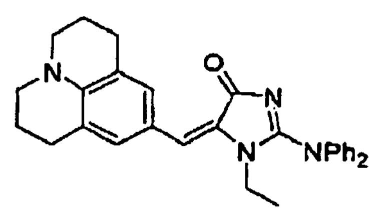

(146)

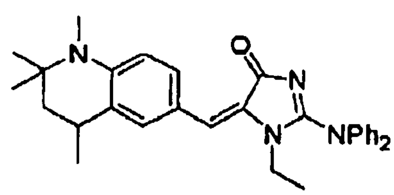

(147) 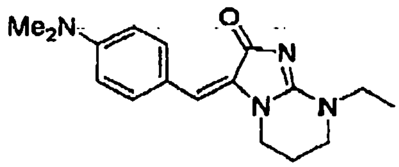

(148) 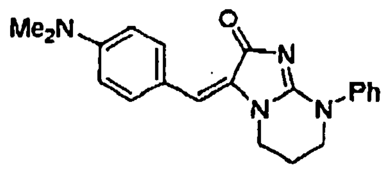

(149) 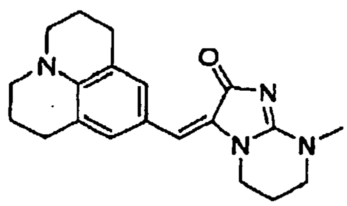

(150) 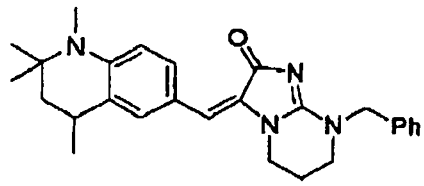

The compound represented by formula (2) can be synthesized with reference to methods described, for example, in Yakugaku Zasshi (Journal of the Pharmaceutical Society of Japan), Vol. 74, pages 199 and 1326 (1994).

It is preferred that the compound represented by formula (1) or (2) has an absorption maximum wavelength from 350 to 450 nm. The absorption maximum wavelength is more preferably from 350 to 430 nm, and still more preferably from 350 to 400 nm.

The term "absorption maximum wavelength" as used herein means a value measure under the following conditions. Specifically, an appropriate amount of the compound represented by formula (1) or (2) was weighed, dissolved in methanol, diluted so as to be within a range of the desired absorbance (within a range from 0.8 to 1.0 at the absorption maximum) and measured by a spectrophotometer based on the definition of JIS Z8120-86 using a measurement cell having a path length of 10 mm at measurement temperature selected from a range from 15 to 30°C to obtain a spectral absorption curve of the compound, from which the absorption maximum wavelength is determined.

The sensitizing dye represented by formula (1) or (2) for use in the invention may be subjected to various chemical modifications in order to improve characteristics of the photosensitive layer. For instance, the sensitizing dye may be connected to an addition-polymerizable compound structure (for example, an acryloyl group or a methacryloyl group) by a covalent bond, ionic bond, hydrogen bond or the like, whereby strength of the exposed area of a layer can be increased and undesirable deposition of the dye in the layer after exposure can be inhibited.

Also, the sensitizing dye may be connected to a partial structure having a radical generation ability (for example, a reductively decomposable site, e.g., a halogenated alkyl, onium, peroxide, biimidazole or onium, or an oxidatively cleavable site, e.g., a berate, amine, trimethylsilylmethyl, carboxymethyl, carbonyl or imine) in the initiator compound described hereinafter, whereby photosensitivity, particularly photosensitivity under a low concentration condition of the initiation system can be remarkably increased.

Further, in the case of using the photosensitive composition of the invention for a photosensitive layer of a lithographic printing plate precursor, which is a preferred use embodiment of the photosensitive composition, introduction of a hydrophilic site (an acid group or a polar group, for example, a carboxyl group or an ester thereof, a sulfonic group or an ester thereof, or an ethylene oxide group) into the dye is effective for the purpose of enhancing the processing aptitude with an alkali or aqueous developer. Particularly, the ester-type hydrophilic group has a feature in that it exhibits excellent compatibility in the photosensitive layer due to its relatively hydrophobic structure and in the developer, on the other hand, it is hydrolyzed to generate an acid group, thereby increasing hydrophilicity.

In addition, a substituent can be appropriately introduced, for example, for improving the compatibility or inhibiting the deposition of crystal in the photosensitive layer. For instance, in a certain kind of photosensitive system, an unsaturated bond, for example, an aryl group or an allyl group is sometimes very effective for improving the compatibility. Moreover, the formation of a steric hindrance between x planes of the dyes by a method, for example, introduction of a branched alkyl structure can significantly inhibit the deposition of crystal. Furthermore, adhesion to metal or an inorganic material, for example, metal oxide can be improved by the introduction of a phosphonic acid group, an epoxy group, a trialkoxysilyl group or the like. If desired, a method of polymerization of the sensitizing dye may also be used.

In the invention, it is only necessary to use at least one of the sensitizing dyes represented by formulae (1) and (2), as a sensitizing dye. Accordingly, insofar as the sensitizing dye represented by formula (1) or (2) is used, the details of the method of using the sensitizing dye, for example, selection of the structure, individual or combination use, or an amount added, can be appropriately arranged depending on the characteristic design of the final photosensitive

material. For instance, when two or more sensitizing dyes are used in combination, the compatibility with the photosensitive layer can be enhanced

For the selection of sensitizing dye, the molar absorption coefficient thereof at the emission wavelength of the light source used is an important factor in addition to the photosensitivity. Use of the dye having a large molar absorption coefficient is profitable, because the amount of dye added can be made relatively small, and is also advantageous in view of the physical properties of the photosensitive layer.

In addition to (A) the specific sensitizing dye, other conventionally used sensitizing dye can be used in combination as far as the effects of the invention do not adversely affected.

Since the photosensitivity and resolution of the photosensitive layer and the physical properties of the exposed area of the photosensitive layer are greatly influenced by the absorbance of a sensitizing dye at the wavelength of light source, the amount of the sensitizing dye added is appropriately selected in consideration of these factors. For instance, in a low absorbance region of the photosensitive layer of 0.1 or less, the sensitivity decreases. Also, the resolution decreases due to the influence of halation. However, for the purpose of hardening a layer having a large thickness, for example, of 5 μm or more, such low absorbance is sometimes rather effective for increasing the hardening degree. On the other hand, in a high absorbance region of 3 or more, the light is mostly absorbed on the surface of the photosensitive layer to inhibit hardening of the inner part and as a result, for example, when a printing plate is produced, the layer strength and the adhesion to a substrate become insufficient.

For instance, in the case of using the photosensitive composition according to the invention in a photosensitive layer of a lithographic printing plate precursor where the photosensitive layer has a relatively small thickness, the amount of the sensitizing dye added is preferably selected such that the photosensitive layer has absorbance of 0.1 to 1.5, preferably from 0.25 to 1. Since the absorbance can be determined by the amount of the sensitizing dye added and the thickness of the photosensitive layer, the desired absorbance is obtained by controlling both conditions. The absorbance of the photosensitive layer can be measured in a conventional manner. For the measurement of the absorbance, there are illustrated, for example, a method wherein a photosensitive layer is provided on a transparent or white support in a coating amount after drying to have a thickness appropriately determined in a range necessary for a lithographic printing plate precursor and the photosensitive layer is measured by a transmission optical densitometer, and a method wherein a photosensitive layer is provided on a reflective support, for example, an aluminum support in a similar manner to the above and a reflection density of the photosensitive layer is measured.

In the case of using the photosensitive composition according to the invention in the photosensitive layer of a lithographic printing plate precursor, the amount of the sensitizing dye represented by formula (1) or (2) added as component (A) is ordinarily from 0.05 to 30 parts by weight, preferably from 0.1 to 20 parts by weight, and more preferably from 0.2 to 10 parts by weight, per 100 parts by weight of the total solid component constituting the photosensitive layer.

Now, (B) initiator compound that is the second essential component of the photo-initiation system in the photosensitive composition according to the invention is described in detail below. (B) Initiator compound

The initiator compound for use in the invention is a compound undergoing chemical change upon a function, for example, electron transfer, energy transfer or heat generation resulting from the sensitizing dye in the electron excited state to generate at least one species selected from a radical, an acid or a base.

The radical, acid or base thus-generated is simply referred to as an active species, hereinafter. When the initiator compound is not present or when it is used alone, sensitivity sufficient for practical use can not be obtained. According to one embodiment of using the above-described sensitizing dye together with the initiator compound, it is possible to utilize a single compound including both compounds prepared by an appropriate chemical method (for example, a linkage of the sensitizing dye and the initiator compound by a chemical bond).

It is believed that many of the initiator compounds ordinarily generate the active species through an initial chemical process as typified by following processes (1) to (3). Specifically, there are a process (1): reductive decomposition of the initiator compound based on electron transfer from the sensitizing dye in the electron excited state to the initiator compound, a process (2): oxidative decomposition of the initiator compound based on electron transfer from the initiator compound to the sensitizing dye in the electron excited state, and a process (3): decomposition of the initiator compound in the electron excited state based on energy transfer from the sensitizing dye in the electron excited state to the initiator compound. Although it is unclear in many cases that an individual initiator compound decomposes according to which process belongs to (1) to (3), the sensitizing dye according to the invention has a great feature in that it exhibits a very large sensitizing effect even in combination with any initiator compounds decomposed according to the processes (1) to (3).

As the initiator compound according to the invention, initiator compounds known to those skilled in the art can be used without limitation. Specifically, many compounds described in literature, for example, Bruce M Monroe et al., Chemical Review, 93, 435 (1993), R. S. Davidson, Journal of Photochemistry and Biology A: Chemistry, 73, 81 (1993), J. P. Faussier, Photoinitiated Polymerization- Theory and Applications: Rapra Review, 9, Report, Rapra Technology (1998) or M. Tsunooka et al., Prog. Polym Sci., 21, 1 (1996) can be used. Further, as other compounds decomposed according to the processes (1) or (2), compounds undergoing oxidative or reductive bond cleavage as described, for

example, in F. D. Saeva, Topics in Current Chemistry, 156, 59 (1990), G. G. Maslak, Topics in Current Chemistry, 168, 1 (1993), H. B. Shuster et al., JACS, 112, 6329 (1990) or I. D. F. Eaton et al., JACS, 102, 3298 (1980) are known, and these compounds are also used as the initiator compound.

Specific examples of preferable initiator compound are described according to classifications of (a) compound undergoing bond cleavage by reduction to generate an active species, (b) compound undergoing bond cleavage by oxidation to generate an active species and (c) other compound. However, a common view is not present about an individual compound belongs to which class of (a) to (c) in many cases, and the invention should not be construed as being limited to the description regarding the reaction mechanism described above.

(a) Compound undergoing bond cleavage by reduction to generate an active species

Compound having carbon-halogen bond:

It is believed that an active species is generated by reductive cleavage of the carbon-halogen bond (described, for example, in Polymer Preprints. Jpn., 41 (3), 542 (1992)). As the active species, a radical or an acid can be generated. Specifically, for example, halomethyl-s-triazines, halomethyloxadiazoles which are easily prepared by one skilled in the art according to a synthesis method described in M. P. Hutt, E. F. Elslager and L. M Merbel, Journal of Heterocyclic Chemistry, 7, 511 (1970), and compounds described in German Patents 2,641,100, 3,333,450, 3,021,590 and 3,021,599 are preferably used.

Compound having nitrogen-nitrogen bond or nitrogen-containing hetero ring-nitrogen-containing ring bond:

It is believed that reductive cleavage of the bond occurs (described, for example, in J. Pys. Chem., 96, 207 (1992)). Specifically, hexaarylbiimidazoles are preferably used. The active species generated is a lophine radical, By combination use with a hydrogen donor, a radical chain reaction initiates, if desired. Image formation using an oxidation reaction due to the lophine radical is also known (described in J. Imaging Sci., 30, 215 (1986)).

Compound having oxygen-oxygen bond:

It is believed that an active species is generated by reductive cleavage of the oxygen-oxygen bond (described, for example, in Polym. Adv. Technol., 1, 287 (1990)). Specifically, organic peroxides are preferably used. As the active species, a radical can be generated.

Onium compound:

It is believed that an active species is generated by reductive cleavage of carbon-hetero bond or oxygen-nitrogen bond (described, for example, in J. Photopolym. Sci. Technol., 3, 149 (1990)). Specifically, for example, iodonium salts described in European Patent 104,143, U.S. Patent 4,837,124, JP-A-2-150848 and JP-A-2-96514, sulfonium salts described in European Patents 370,693, 233,567, 297,443, 297,442, 279,210 and 422,570, U.S. Patents 3,902,114, 4,933,377, 4,760,013, 4,734,444 and 2,833,827, diazonium salts (for example, benzenediazonium which may have a substituent), diazonium salt resins (for example, formaldehyde resin of diazodiphenylamine), N-alkoxypyridinium salts (for example, those described, for example, in U.S. Patent 4,743,528, JP-A-63-138345, JP-A-63-142345, JP-A-63-142346 and JP-B-46-42363 (the term "JP-B" as used herein means an "examined Japanese patent publication"), specifically including, for example, 1-methoxy-4-phenylpyridinium tetrafluoroborate), and compounds described in JP-B-52-14727, JP-B-52-14728 and JP-B-52-14729 are preferably used. As the active species, a radical or an acid can be generated.

Active esters:

Nitrobenzyl esters of sulfonic acid or carboxylic acid, esters of sulfonic acid or carboxylic acid and N-hydroxy compound (for example, N-hydroxyphthalimide or oxime), sulfonic acid esters of pyrogallol, nathtoquinonediazido-4-sulfonic acid esters and the like can be reductively decompose. As the active species, a radical or an acid can be generated. Specific examples of the sulfonic ester include nitrobenzyl ester compounds described in European Patents 290,750, 46,083, 156,153, 271,851 and 388,343, U.S. Patents 3,901,710 and 4,181,531, JP-A-60-198538 and JP-A-53-133022, iminosulfonate compounds described in European Patents 199,672, 84,515, 441,115 and 101,122, U.S. Patents 4,618,564, 4,371,605 and 4,431,774, JP-A-64-18143, JP-A-2-245756 and JP-A-4-365048, compounds described in JP-B-62-6223, JP-B-63-14340 and JP-A-59-174831, and compounds set for below.

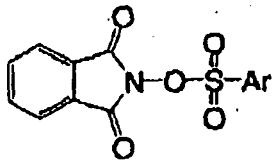 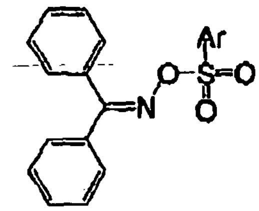 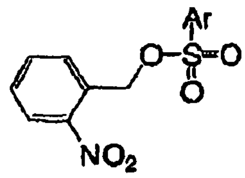

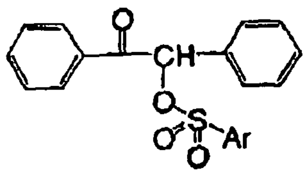 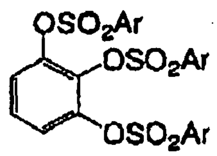 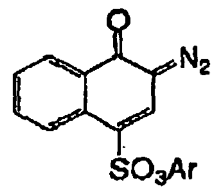

In the formulae, Ar represents an aromatic group which may be substituted or an aliphatic group which may be substituted.

As compounds capable of generating a base as the active species, for example, compounds described below are known.

Ferrocene and iron allene complexes:

An active radical can be reductively generated. Specific examples thereof are described in JP-A-1-304453 and JP-A-1-152109, and include compounds set for below.

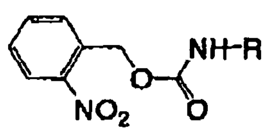 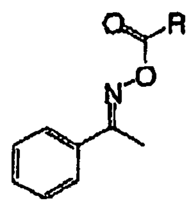

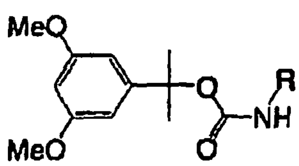 $[CO(III)(NH_3)_5Br]\ (ClO_4)_2$

In the formulae, R represents an aliphatic group which may be substituted or an aromatic group which may be substituted.

Disulfones:

By reductive cleavage of S-S bond, an acid can be generated. For example, diphenyldisuofones described in JP-A-61-166544 are known.

(b) Compound undergoing bond cleavage by oxidation to generate an active species

Alkylate complexes:

It is believed that an active radical is generated by oxidative cleavage of the carbon-hetero bond (described, for example, in J. Am. Chem. Soc., 112, 6329 (1990)). Specifically, for example, triaryl alkyl borates are preferably used.

Alkylamine compounds:

It is believed that an active radical is generated by oxidative cleavage of C-X bond on the carbon atom adjacent to a nitrogen atom, wherein X preferably represents a hydrogen atom, a carboxy group, a trimethylsilyl group or a benzyl group (described, for example, in J. Am. Chem. Soc., 116, 4211 (1994)). Specific examples of the compound include ethanolamines, N-phenylglycines and N-trimethylsilylmethylanilines.

Sulfur-containing or tin-containing compounds:

Compounds in which the nitrogen atom of the above-described amine compounds is replaced by a sulfur atom or a tin atom can generate an active radical according to the same function. Also, compounds having S-S bond are known to effect sensitization by cleavage of the S-S bond.

α-Subttituted methylcarbonyl compounds:

An active radical can be generated by oxidative cleavage of carbonyl-a carbon bond. Compounds in which the carbonyl is converted into an oxime ether also show the same function, Specific examples of the compound include 2-alkyl-1-[4-(alkylthio)phenyl]-2-morpholinopronone-1 and oxime ethers thereof obtained by reaction of the compound with a hydroxyamine and subsequent etherification of the N-OH.

Sulfinic acid salts:

An active radical is reductively generated. Specific examples of the compound include sodium arylsulfinate.

(c) Compound capable of acting as initiator compound, though sensitization mechanism is not clearly known

In addition, there are many compounds capable of acting as the initiator compound, although the sensitization mechanism thereof is not clearly known. These compounds can also be used as the initiator compound in the invention. Examples thereof include organic metallic compounds, for example, titanocene compounds or ferrocene compounds, aromatic ketones, acylphosphines or bisacylphosphines. As the active species, a radical or an acid can be generated.
Of the initiator compounds for use in the invention, preferable compounds particularly excellent in sensitivity and stability are specifically described below.

(1) Halomethyltriazines

The halomethyltriazines include a compound represented by formula [II] shown below and the compound is particularly excellent in the ability of generating a radical or an acid.

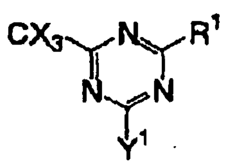

[II]

In formula [II], X represents a halogen atom, $Y^1$ represents $-CX_3$, $-NH_2$, $-NHR^{1'}$, $-N(R^{1'})_2$ or $-OR^{1'}$ (wherein $R^{1'}$ represents an alkyl group, a substituted alkyl group, an aryl group or a substituted aryl group), and $R^{1'}$ represents $-CX_3$, an alkyl group, a substituted alkyl group, an aryl group, a substituted aryl group or a substituted alkenyl group.
Specific examples of the compound include compounds described in Wakabayashi et al., Bull. Chem. Soc. Japan, 42, 2924 (1969), for example,

2-phenyl-4,6-bis(trichloromethyl)-S-triazine,
2-(p-chlorophenyl)-4,6-bis(trichloromethyl)-S-triazine,
2-(p-tolyl)-4,6-bis(trichloromethyl)-S-triazine,
2-(p-methoxyphenyl)-4,6-bis(trichloromethyl)-S-triazine,
2-(2',4'-dichlorophenyl)-4,6-bis(trichloromethyl]-S-triazine,2,4,6-tris(trichloromethyl)-S-t riazine, 2-methyl-4,6-bis (trichloromethyl)-S-triazine,
2-n-nonyl-4,6-bis(trichloromethyl)-S-triazine and
2-(α,α,β-trichloroethyl)-4,6-bis(trichloromethyl)-S-triazine; compounds described in British Patent 1,388,492, for example, 2-styryl-4,6-bis(trichloromethyl)-S-triazine,
2-(p-methylstyryl)-4,6-bis(trichloromethyl)-S-triazine,
2-(p-methoxylstyryl)-4,6-bis(trichloromethyl)-S-triazine and
2-(p-methoxylstyryl)-4-amino-6-trichloromethyl-S-triazine; compounds described in JP-A-53-133428, for example,
2-(4-methoxynaphth-1-yl)-4,6-bis(trichloromethyl)-S-triazine,
2-(4-ethoxynaphth-1-yl)-4,6-bis(trichloromethyl)-S-triazine,
2-[4-(2-ethoxyethyl)naphth-1-yl]-4,6-bis(trichloromethyl)-S-triazine,
2-(4,7-dimethoxynaphth-1-yl)-4,6-bis(trichloromethyl)-S-triazine and
2-(acenaphth-5-yl)-4,6-bis(trichloromethyl)-S-triazine; and compounds described in German Patent 3,337,024, for example, compounds set forth below:

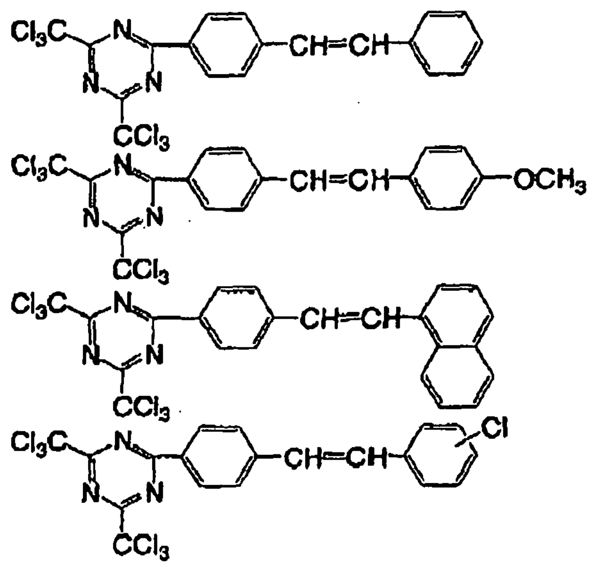

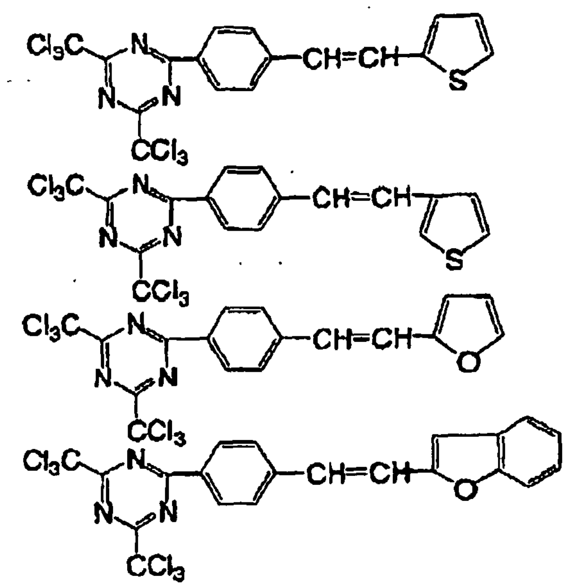

Also, compounds described in.F. C. Schaefer et al., J. Org. Chem., 29, 1527 (1964), for example, 2-methyl-4,6-bis(tribromomethyl)-S-triazine, 2,4,6-tris(tribromomethyl)-S-triazine, 2,4,6-tris(dibromomethyl)-S-triazine, 2-amino-4-methyl-6-tribromomethyl-S-triazine and 2-methoxy-4-methyl-6-tribromomethyl-S-triazine are exemplified.

Further compounds described in JP-A-62-58241, for example, compounds set forth below are exemplified.

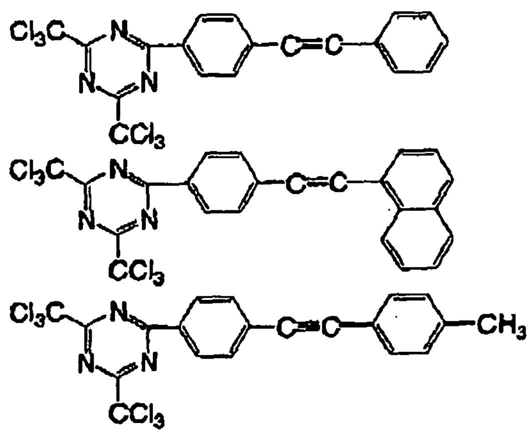

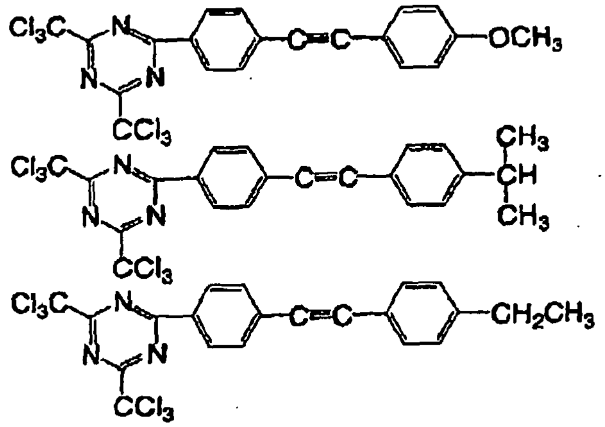

Further compounds described in JP-A-5-281728, for example, compounds set forth below are exemplified.

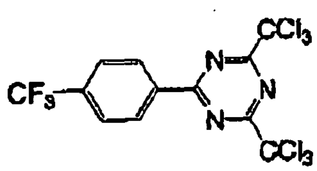

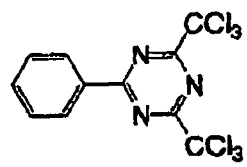

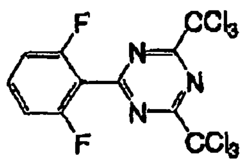

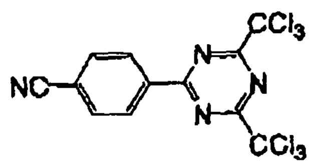

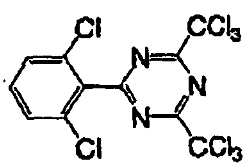

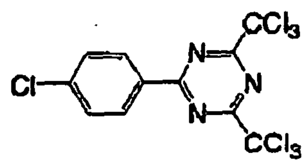

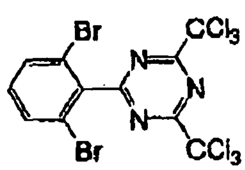

(2) Borate salt compounds

Borate salt compounds represented by formula [III] shown below are excellent in the ability of generating a radical.

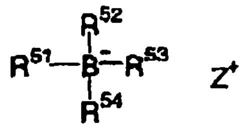

[III]

In formula [III], $R^{51}$, $R^{52}$, $R^{53}$ and $R^{54}$, which may be the same or different, each represents a substituted or unsubstituted alkyl group, a substituted or unsubstituted aryl group, a substituted or unsubstituted alkenyl group, a substituted or unsubstituted alkynyl group or a substituted or unsubstituted heterocyclic group, or at least two of $R^{51}$, $R^{52}$, $R^{53}$ and $R^{54}$ may combine with each other to form a cyclic structure, provided that at least one of $R^{51}$, $R^{52}$, $R^{53}$ and $R^{54}$ represents a substituted or unsubstituted alkyl group; and $Z^+$ represents an alkali metal cation or a quaternary ammonium cation.

The alkyl group represented by any one of $R^{51}$ to $R^{34}$ includes a straight-chain, branched or cyclic alkyl group, and preferably has from 1 to 18 carbon atoms. Specific examples thereof include methyl, ethyl, propyl, isopropyl, butyl, pentyl, hexyl, octyl, stearyl, cyclobutyl, cyclopentyl and cyclohexyl groups. The substituted alkyl group represented by any one of $R^{51}$ to $R^{54}$ includes the above-described alkyl group substituted with a halogen atom (e.g., chlorine or bromine), a cyano group, a nitro group, an aryl group (preferably, phenyl), a hydroxy group, a group shown below:

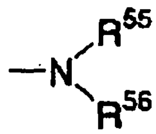

(wherein $R^{55}$ and $R^{56}$, which may be the same or different, each represents a hydrogen atom, an alkyl group having from 1 to 14 carbon atoms or an aryl group), $-COOR^{57}$ (wherein $R^{57}$ represents a hydrogen atom, an alkyl group having from 1 to 14 carbon atoms or an aryl group), $-OCOR^{58}$ (wherein $R^{58}$ represents an alkyl group having from 1 to 14 carbon atoms or an aryl group) or $-OR^{59}$ (wherein $R^{59}$ represents an alkyl group having from 1 to 14 carbon atoms or an aryl group).

The aryl group represented by any one of $R^{51}$ to $R^{54}$ includes an aryl group having from one to three rings, for example, phenyl or naphthyl. The substituted aryl group represented by any one of $R^{51}$ to $R^{54}$ includes the above-described aryl group substituted with the substituent described for the substituted alkyl group above or an alkyl group having from 1 to 14 carbon atoms.

The alkenyl group represented by any one of $R^{51}$ to $R^{54}$ includes a straight chain, branched or cyclic alkenyl group having from 2 to 18 carbon atoms. In the substituted alkenyl group, the substituent includes the substituents described for the substituted alkyl group above.

The alkynyl group represented by any one of $R^{51}$ to $R^{54}$ includes a straight-chain or branched alkynyl group having from 2 to 28 carbon atoms. In the substituted alkynyl group, the substituent includes the substituents described for the substituted alkyl group above.

The heterocyclic group represented by any one of $R^{51}$ to $R^{54}$ includes a 5-membered or more heterocyclic group, preferably a 5-membered, 6-membered or 7-membered heterocyclic group, containing at least one hetero atom selected from a nitrogen atom, a sulfur atom and an oxygen atom. The heterocyclic group may have a condensed ring. In the substituted heterocyclic group, the substituent includes the substituents described for the substituted aryl group above.

Specific examples of the compound represented by formula [III] include compounds described in U.S. Patents 3,567,453 and 4,343,891, European Patents 109,772 and 109,773, and compounds set forth below.

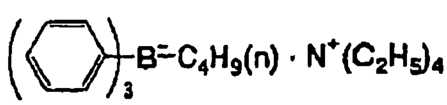

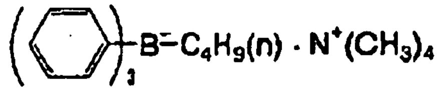

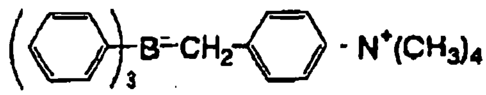

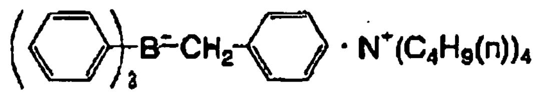

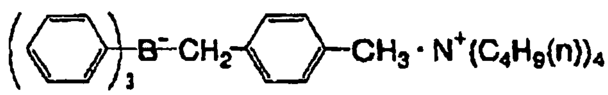

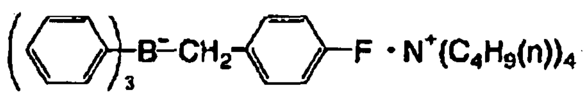

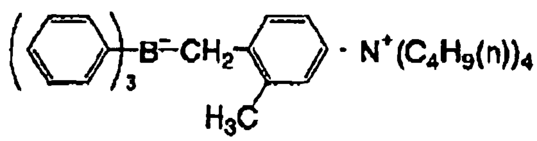

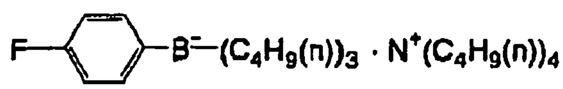

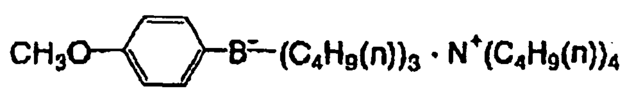

(3) Hexaarylbiimidazoles

The hexaarylbiimidazoles are excellent in stability and can generate a radical in high sensitivity. Specific examples thereof include
2,2'-bis(o-chlorophenyl)-4,4',5,5'-tetraphenylbiimidazole,
2,2'-bis(o-bromophenyl)-4,4',5,5'-tetraphenylbiimidazole,
2,2'-bis(o,p-dichlorophenyl)-4,4',5,5'-tetraphenylbiimidazole,
2,2'-bis(o-chlorophenyl)-4,4',5,5'-tetra(m-methoxyphenyl)biimidazole,
2,2'-bis(o,o'-dichlorophenyl)-4,4',5,5'-tetraphenylbiimidazole,
2,2'-bis(o-nitrophenyl)-4,4',5,5'-tetraphenylbiimidazole,

2,2'-bis(o-methylphenyl)-4,4',5,5'-tetraphenylbiimidazole and 2,2'-bis(o-trifluoromethylphenyl)-4,4',5,5'-tetraphenylbiimidazole.

(4) Onium salt compounds

Onium salt compounds of atoms belonging to Group 15 (5B), Group 16 (6B) or Group 17 (7B) of the periodic table, specifically, N, P, As, Sb, Bi, O, S, Se, Te and I are initiator compounds excellent in the sensitivity. Particularly, iodonium salts and sulfonium salts, especially, diaryliodonium salt compounds and triarylsulfonium salt compounds are extremely excellent in both points of the sensitivity and preservation stability. The onium salt compound can generate an acid and/or a radical, and is able to use by appropriately selecting use conditions in accordance with the intended use. Specific examples of the onium salt compound include compounds set forth below.

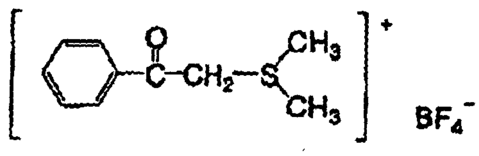

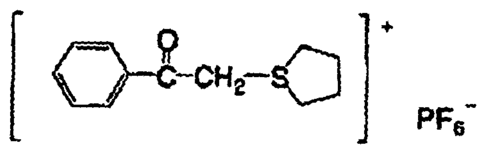

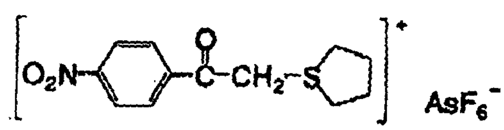

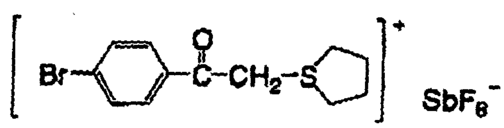

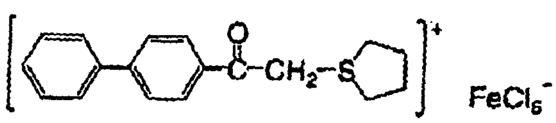

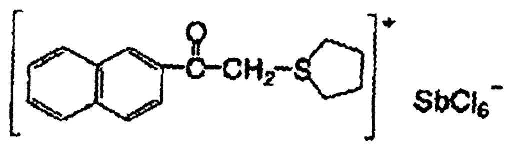

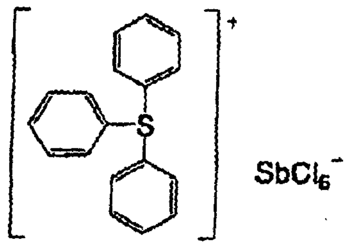

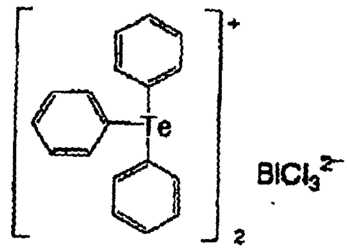

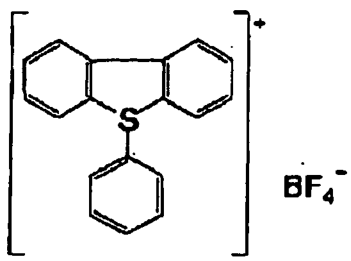

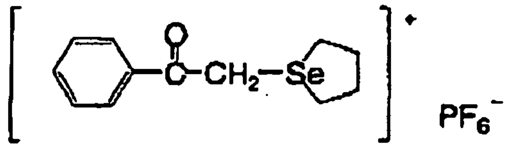

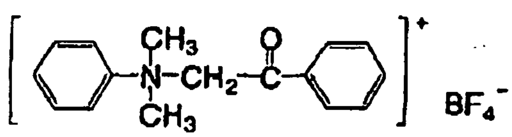

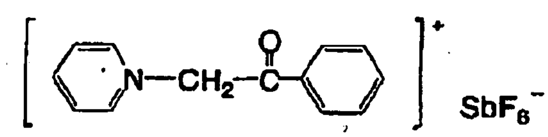

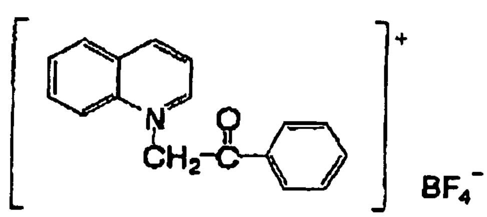

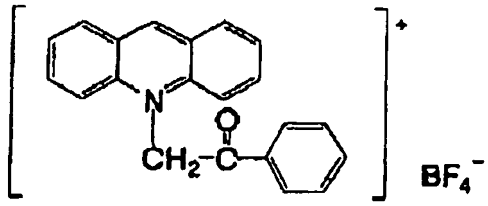

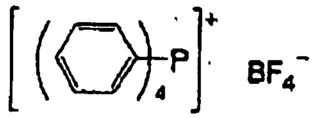

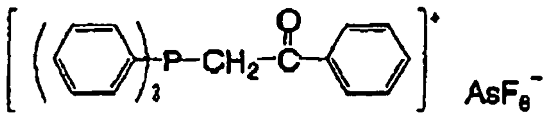

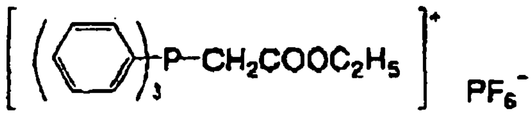

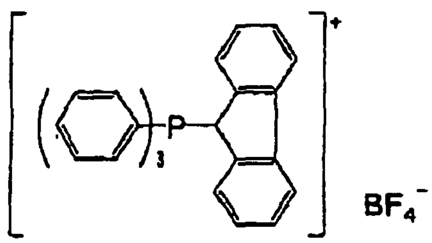

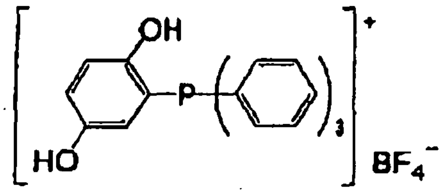

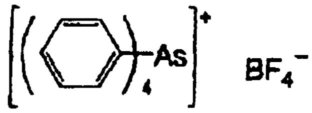

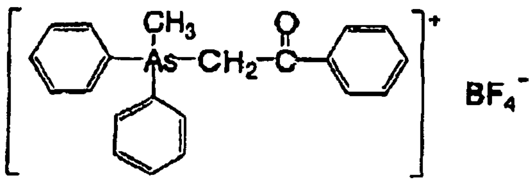

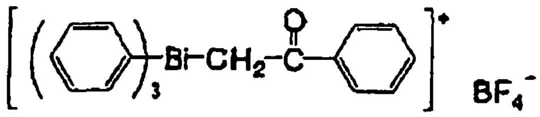

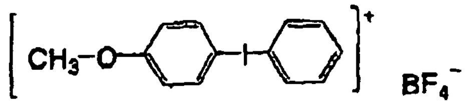

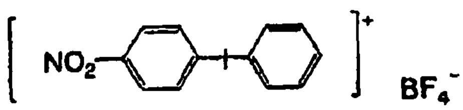

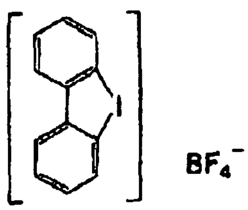

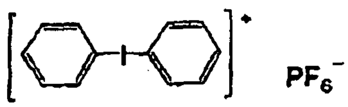

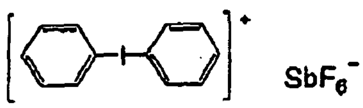

(5) Organic peroxides

When the initiator compound of organic peroxide type is used, the generation of a radical as the active species can be conducted in an extremely high sensitivity.

The organic peroxide (5), which is a still another example of the initiator compound for use in the invention, includes almost all organic compounds having at least one oxygen-oxygen bond in the molecules thereof. Specific examples of the organic peroxide include methyl ethyl ketone peroxide, cyclohexanone peroxide, 3,3,5-trimethylcyclohexanone peroxide, methylcyclohexanone peroxide, acetylacetone peroxide, 1,1-bis(tert-butylperoxy)-3,3,5-trimethylcyclohexane, 1,1-bis(tert-butylperoxy)cyclohexane, 2,2-bis(tert-butylperoxy)butane, tert-butylhydroperoxide, cumene hydroperoxide, diisopropylbenzene hydroperoxide, paramethane hydroperoxide, 2,5-dimethylhexane-2,5-dihydroperoxide, 1,1,3,3-tetramethylbutyl hydroperoxide, di-tert-butyl peroxide, tert-butylcumyl peroxide, dicumyl peroxide, bis(tert-butyperoxyisopropyl)benzene, 2,5-dimethyl-2,5-di(tert-butylperoxy)hexane, 2,5-dimethyl-2,5-di(tert-butylperoxy) hexyne-3, acetyl peroxide, isobutyryl peroxide, octanoyl peroxide, decanoyl peroxide, lauroyl peroxide, 3,5,5-trimethylhexanoyl peroxide, succinic peroxide, benzoyl peroxide, 2,4-dichlorobenzoyl peroxide, methatoluoyl peroxide, diisopropylperoxy dicarbonate, di-2-ethylhexylperoxy dicarbonate, di-2-ethoxyethylperoxy dicarbonate, dimethoxyisopropylperoxy dicarbonate, di(3-methyl-3-methoxybutyl)peroxy dicarbonate, tert-butylperoxy acetate, tert-butylperoxy pivalate, tert-butylperoxy neodecanoate, tert-butylperoxy octanoate, tert-butylperoxy-3,5,5-trimethyl hexanoate, tert-butylperoxy laurate, tert-butylperoxy benzoate, di-tert-butylperoxy isophthalate, 2,5-dimethyl-2,5-di(benzoylperoxy)hexane, tert-butylperoxy maleate, tert-butylperoxy isopropylcarbonate, 3,3',4,4'-tetra(tert-butylperoxycarbonyl)benzophenone, 3,3', 4,4'-tetra(tert-amylperoxycarbonyl)benzophenone, 3,3',4,4'-tetra(tert-hexylperoxycarbonyl)benzophenone, 3,3',4,4'-tetra(tert-octylperoxycarbonyl)benzophenone, 3,3',4,4'-tetra(cumylperoxycarbonyl)benzophenone, 3,3',4,4'-tetra(p-isopropylcumylperoxycarbonyl)benzophenone, carbonyl di(tert-butylperoxydihydrogen diphthalate) and carbonyl di(tert-hexylperoxydihydrogen diphthalate).

Of the organic peroxides, ester peroxides, for example, 3,3',4,4'-tetra(tert-butylperoxycarbonyl)benzophenone, 3,3',4,4'-tetra(tert-amylperoxycarbonyl)benzophenone, 3,3',4,4'-tetra(tert-hexylperoxycarbonyl)benzophenone, 3,3', 4,4'-tetra(tert-octylperoxycarbonyl)benzophenone, 3,3',4,4'-tetra(cumylperoxycarbonyl)benzophenone, 3,3',4,4'-tetra (p-isopropylcumylperoxycarbonyl)benzophenone and di-tert-butyldiperoxy isophthalate are preferred.

(6) Titanocene compounds

The titanocene compound preferable for the initiator compound includes titanocene compounds described, for example, in JP-A-59-152396, JP-A-61-151197, JP-A-63-41484, JP-A-2-249 and JP-A-2-4705.

Specific examples of the titanocene compound include
dicyclopentadienyl-Ti-bisphenyl,
dicyclopentadienyl-Ti-bis-2,3,4,5,6-pentafluorophen-1-yl,
dicyclopentadienyl-Ti-bis-2,3,5,6-tetrafluorophen-1-yl,
dicyclopentadienyl-Ti-bis-2,4,6-trifluorophen-1-yl,
dicyclopentadienyl-Ti-bis-2,6-difluorophen-1-yl,
dicyclopentadienyl-Ti-bis-2,4-difluorophen-1-yl,
dimethylcyclopentadienyl-Ti-bis-2,3,4,5,6-pentafluorophen-1-yl,
dimethylcyclopentadienyl- Ti-bis-2,3,5,6-tetrafluorophen-1-yl,
dimethylcyclopentadienyl-Ti-bis-2,4-difluorophen-1-yl,
bis(cyclopentadienyl)bis[2,6-difluoro-3-(pyr-1-yl)phenyl]-titanium,
bis(cyclopentadienyl)bis[2,6-difluoro-3-(methylsulfonamido)phenyl]titanium,
bis(cyclopentadienyl)bis[2,6-difluoro-3-(N-butylpivaloylamino)phenyl]titanium
bis(cyclopentadienyl)bis[2,6-difluoro-3-(N-ethylacetylamino)phenyl]titanium,
bis(cyclopentadienyl)bis[2,6-difluoro-3-(N-methylacetylamino)phenyl]titanium,
bis(cyclopentadienyl)bis[2,6-difluoro-3-(N-ethylpropionylamino)phenyl]titanium,
bis(cyclopentadienyl)bis[2,6-difluoro-3-(N-ethyl-(2,2-dimethylbutanoyl)amino)phenyl]tit anium,
bis(cyclopentadienyl)bis[2,6-difluoro-3-(N-butyl-(2,2-dimethylbutanoyl)amino)phenyl]tit anium,
bis(cyclopentadienyl)bis[2,6-difluoro-3-(N-pentyl-(2,2-dimethylbutanoyl)amino)phenyljti tanium,
bis(cyclopentadienyl)bis[2,6-difluoro-3-(N-hexyl-(2,2-dimethylbutanoyl)amino)phenyl]tit anium, bis(cyclopentadienyl) bis[2,6-difluoro-3-(N-methylbutyrylamino)phenyl]titanium,
bis(cyclopentadienyl)bis[2,6-difluoro-3-(N-methylpentanoylamino)phenyl]titanium,
bis(cyclopentadienyl)bis[2,6-difluoro-3-(N-ethylcyclohexylcarbonylamino)phenyl)titaniu m, bis(cyclopentadienyl)bis [2,6-difluoro-3-(N-ethylisobutyrylamino)phenyl]titanium, bis(cyclopentadienyl)bis[2,6-difluoro-3-(N-ethylacetylamino) phenyl]titanium,
bis(cyclopentadienyl)bis[2,6-difluoro-3-(2,2,5,5-tetramethyl-1,2,5-azadisilazan-1-yl)phen yl]titanium, bis(cyclopentadienyl)bis[2,6-difluoro-3-(octylsulfonamido)phenyl]titanium,
bis(cyclopentadienyl)bis[2,6-difluoro-3-(4-iolylsulfonamido)phenyl]titanium,
bis(cyclopentadienyl)bis[2,6-difluoro-3-(4-dodecylphenylsulfonylamido)phenyl]titanium,
bis(cyclopentadienyl)bis[2,6-difluoro-3-(4-(1-pentylheptyl)phenylsulfonylamido)phenyl]ti tanium, bis(cyclopentadienyl)bis[2,6-difluoro-3-(ethylsulfonylamido)phenyl]titanium, bis(cyclopentadienyl)bis[2,6-difluoro-3-((4-bromophenyl)sulfonylamido)phenyl]titanium, bis(cyclopentadienyl)bis[2,6-difluoro-3-(2-naphthylsulfonylamido)phenyl]titanium, bis(cyclopentadienyl)bis[2,6-difluoro-3-(hexadecylsulfonylamido)phenyl]titanium, bis(cyclopentadienyl)bis[2,6-difluoro-3-(N-methyl-(4-dodecylphenyl)sulfonylamido)phen yl]titanium, bis(cyclopentadienyl)bis[2,6-difluoro-3-(N-methyl-(4-(1-pentylheptyl)phenyl)sulfonylami do)phenyl]titanium, bis(cyclopentadienyl)bis[2,6-difluoro-3-(N-hexyl-(4-tolyl)sulfonylamido)phenyl]titanium, bis(cyclopentadienyl)bis[2,6-difluoro-3-(pyrrolidin-2,5-dion-1-yl)phenyl]titanium, bis(cyclopentadienyl)bis[2,6-difluoro-3-(3,4-dimethyl-3-pyrrolidin-2,5-dion-1-yl)phenyl]t itanium, bis(cyclopentadienyl) bis[2,6-difluoro-3-(phthalimido)phenyl]titanium, bis(cyclopentadienyl)bis[2,6-difluoro-3-(isobutoxycarbonylamino)phenyl]titanium, bis(cyclopentadienyl)bis[2,6-difluoro-3-(ethoxycarbonylamino)phenyl]titanium, bis(cyclopentadienyl)bis[2,6-difluoro-3-((2-chloroethoxy)carbonylamino)phenyl]titanium, bis(cyclopentadienyl)bis[2,6-difluoro-3-(phenoxycarbonylamino)phenyl]titanium, bis(cyclopentadienyl)bis[2,6-difluoro-3-(3-phenylthioureido)phenyl]titanium, bis(cyclopentadienyl)bis[2,6-difluoro-3-(3-butylthioureido)phenyl]titanium, bis(cyclopentadienyl)bis[2,6-difluoro-3-(3-phenylureido)phenyl]titanium, bis(cyclopentadienyl)bis[2,6-difluoro-3-(3-butylureido)phenyl]tatanium, bis(cyclopentadienyl)bis[2,6-difluoro-3-(N,N-diacetylamino)phenyl]titanium, bis(cyclopentadienyl)bis[2,6-difluoro-3-(3,3-dimethylureido)phenyl]titanium, bis(cyclopentadienyl)bis[2,6-difluoro-3-(acetylamino)phenyl]titanium, bis(cyclopentadienyl)bis[2,6-difluoro-3-(butyrylamino)phenyl]titanium, bis(cyclopentadienyl)bis[2,6-difluoro-3-(decanoylamino)phenyl]titanium, bis(cyclopentadienyl)bis[2,6-difluoro-3-(octadecanoylamino)phenyl]titanium, bis(cyclopentadienyl)bis[2,6-difluoro-3-(isobutyrylamino)phenyl]titanium, bis(cyclopentadienyl)bis[2,6-difluoro-3-(2-ethylhexanoylamino)phenyl]titanium, bis(cyclopentadienyl)bis[2,6-difluoro-3-(2-methylbutanoylamino)phenyl]titanium, bis(cyclopentadienyl)bis[2,6-difluoro-3-(pivaloylamino)phenyl]titanium, bis(cyclopentadienyl)bis[2,6-difluoro-3-(2,2-dimethylbutanoylamino)phenyl]titanium, bis(cyclopentadienyl)bis[2,6-difluoro-3-(2-ethyl-2-methylheptanoylamino)phenyl]titaniu m, bis(cyclopentadienyl)bis[2,6-difluoro-3-(cyclohexylcarbonylamino)phenyl]titanium bis(cyclopentadienyl)bis[2,6-difluoro-3-(2,2-dimethyl-3-chloropropanoylamino)phenyl]tit anium, bis(cyclopentadienyl) bis[2,6-difluoro-3-(3-phenylpropanoylamino)phenyl]titanium, bis(cyclopentadienyl)bis[2,6-difluoro-3-(2-chloromethyl-2-methyl-3-chloropropanoylami no)phenyl]titanium, bis(cyclopentadienyl)bis[2,6-difluoro-3-(3,4-xyloylamino)phenyl]titanium, bis(cyclopentadienyl)bis[2,6-difluoro-3-(4-ethylbenzoylamino)phenyl]titanium, bis(cyclopentadienyl)bis[2,6-difluoro-3-(2,4,6-mesitylcarbonylamino)phenyl]titanium, bis(cyclopentadienyl)bis[2,6-difluoro-3-(benzoylamino)phenyl]titanium, bis(cyclopentadienyl)bis[2,6-difluoro-3-(N-(3-phenylpropyl)benzoylamino)phenyl]titaniu m, bis(cyclopentadienyl)bis[2,6-difluoro-3-(N-(3-ethylheptyl)-2,2-dimethylpentanoylamino)p henyl]titanium, bis(cyclopentadienyl)bis[2,6-difluoro-3-(N-isobutyl-(4-toluyl)amino)phenyl]titanium, bis(cyclopentadienyl)bis(2,6-difluoro-3-(N-isobutylbenzoylamino)phenyl]titanium, bis(cyclopentadienyl)bis[2,6-difluoro-3-(N-cyclohexylmethylpivaloylamino)phenyl]titani um, bis(cyclopentadienyl)bis[2,6-difluoro-3-(N-(oxolan-2-ylmethyl)benzoylamino)phenyl]tita nium, bis(cyclopentadienyl)bis[2,6-difluoro-3-(N-(3-ethylheptyl)-2,2-dimethylbutanoylamino)p henyl]titanium, bis(cyclopentadienyl)bis[2,6-difluoro-3-(N-(3-phenylpropyl)-(4-tolyl)amino)phenyl]titani um, bis(cyclopentadienyl)bis[2,6-difluoro-3-(N-(oxolan-2-ylmethyl)-(4-tolyl)amino)phenyl]tit anium, bis(cyclopentadienyl)bis[2,6-difluoro-3-(N-(4-toluylmethyl)benzoylamino)phenyl]titaniu m, bis(cyclopentadienyl)bis[2,6-difluoro-3-(N-(4-toluylmethyl)-(4-toluyl)amino)phenyl]titani um, bis(cyclopentadienyl)bis [2,6-difluoro-3-(N-butylbenzoylamino)phenyl]titanium, bis(cyclopentadienyl)bis[2,6-difluoro-3-(N-butyl-(4-toluyl)amino)phenyl]titanium, bis(cyclopentadienyl)bis[2,6-difluoro-3-(N-hexyl-(4-toluyl)amino)phenyl]titanium, bis(cyclopentadienyl)bis[2,6-difluoro-3-(N-(2,4-dimethylpentyl)-2,2-dimethylbutanoylami no)phenyl]titanium, bis(cyclopentadienyl)bis[2,6-difluoro-3-(N-(2,4-dimethylpentyl)-2,2-dimethylpentanoyla mino)phenyl]titanium, bis(cyclopentadienyl)bis[2,6-difluoro-3-((4-toluyl)amino)phenyl]titanium, bis(cyclopentadienyl)bis[2,6-difluoro-3-(2,2-dimethylpentanoylamino)phenyl]titanium, bis(cyclopentadienyl)bis[2,6-difluoro-3-(2,2-dimethyl-3-ethoxypropanoylamino)phenyl]tit anium, bis(cyclopentadienyl)bis[2,6-difluoro-3-(2,2-dimethyl-3-allyloxypropanoylamino)phenyl]t itanium, bis(cyclopentadienyl)bis[2,6-difluoro-3-(N-allylacetylamino)phenyl]titanium,
bis(cyclopentadienyl)bis[2,6-difluoro-3-(2-ethylbutanoylamino)phenyl]titanium,
bis(cyclopentadienyl)bis[2,6-difluoro-3-(N-cyclohexylmethylbenzoylamino)phenyl]titaniu m,
bis(cyclopentadienyl)bis[2,6-difluoro-3-(N-cyclohexylmethyl-(4-toluyl)amino)phenyl]tita nium,
bis(cyclopentadienyl)bis[2,6-difluoro-3-(N-(2-ethylhexyl)benzoylamino)phenyl]titanium;
bis(cyclopentadienyl)bis[2,6-difluoro-3-(N-isopropylbenzoylamino)phenyl]titanium,
bis(cyclopentadienyl)bis[2,6-difluoro-3-(N-(3-phenylpropyl)-2,2-dimethylpentanoylamino )phenyl]titanium
bis(cyclopentadienyl)bis[2,6-difluoro-3-(N-hexylbenzoylamino)phenyl]titanium,
bis(cyclopentadienyl)bis[2,6-difluoro-3-(N-cyclohexylmethyl-2,2-dimethylpentanoylamin o)phenyl]titanium,
bis(cyclopentadienyl)bis[2,6-difluoro-3-(N-butylbenzoylamino)phenyl]titanium,
bis(cyclopentadienyl)bis[2,6-difluoro-3-(N-(2-ethylhexyl)-2,2-dimethylpentanoylamino)p henyl]titanium,
bis(cyclopentadienyl)bis[2,6-difluoro-3-(N-hexyl-2,2-dimethylpentanoylamino)phenyl]tit anium,
bis(cyclopentadienyl)bis[2,6-difluoro-3-(N-isopropyl-2,2-dimethylpentanoylamino)phenyl ]titanium,
bis(cyclopentadienyl)bis[2,6-difluoro-3-(N-(3-phenylpropyl)pivaloylamino)phenyl]titaniu m,
bis(cyclopentadienyl)bis[2,6-difluoro-3-(N-butyl-2,2-dimethylpentanoylamino)phenyl]tita nium,
bis(cyclopentadienyl)bis[2,6-difluoro-3-(N-(2-methoxyethyl)benzoylamino)phenyl]titaniu m,
bis(cyclopentadienyl)bis[2,6-difluoro-3-(N-benzylbenzoylamino)phenyl]titanium,
bis(cyclopentadienyl)bis[2,6-difluoro-3-(N-benzyl-(4-totuyl)amino)phenyl]titanium,
bis(cyclopentadienyl)bis[2,6-difluoro-3-(N-(2-methoxylethyl)-(4-toluyl)amino)phenyl]tita nium,
bis(cyclopentadienyl)bis[2,6-difluoro-3-(N-(4-methylphenylmethyl)-2,2-dimethylpentano ylamino)phenyl]titanium,
bis(cyclopentadienyl)bis[2,6-difluoro-3-(N-(2-methoxyethyl)-2,2-dimethylpentanoylamin o)phenyl]titanium,
bis(cyclopentadienyl)bis[2,6-difluoro-3-(N-cyclohexylmethyl-(2-ethyl-2-methylheptanoyl )amino)phenyl]titanium,
bis(cyclopentadienyl)bis[2,6-difluoro-3-(N-butyl-(4-chlorobenzoyl)amino)phenyl]titaniu m,
bis(cyclopentadienyl)bis[2,6-difluoro-3-(N-hexyl-(2-ethyl-2-methylbutanoyl)amino)pheny l]titanium,
bis(cyclopentadienyl)bis[2,6-difluoro-3-(N-cyclohexyl-2,2-dimethylpentanoylamino)phen yl]titanium,
bis(cyclopentadienyl)bis[2,6-difluoro-3-(N-(oxolan-2-ylmethyl)-2,2-dimethylpentanoylam ino)phenyl]titanium,
bis(cyclopentadienyl)bis[2,6-difluoro-3-(N-cyclohexyl-(4-chlorobenzoyl)amino)phenyl]tit anium,
bis(cyclopentadienyl)bis[2,6-difluoro-3-(N-cyclohexyl-(2-chlorobenzoyl)amino)phenyl]tit anium,
bis(cyclopentadienyl)bis[2,6-difluoro-3-(3,3-dimethyl-2-azetidinon-1-yl)phenyl]titanium,
bis(cyclopentadienyl)bis(2,6-difluoro-3-isocyanatophenyl)titanium,
bis(cyclopentadienyl)bis[2,6-difluoro-3-(N-ethyl-(4-tolylsulfonyl)amino)phenyl]titanium,
bis(cyclopentadienyl)bis[2,6-difluoro-3-(N-hexyl-(4-tolylsulfonyl)amino)phenyl]titanium,
bis(cyclopentadienyl)bis[2,6-difluoro-3-(N-butyl-(4-tolylsulfonyl)amino)phenyl]titanium,
bis(cyclopentadienyl)bis[2,6-difluoro-3-(N-isobutyl-(4-tolylsulfonyl)amino)phenyl]titaniu m,
bis(cyclopentadienyl)bis[2,6-difluoro-3-(N-butyl-(2,2-dimethyl-3-chloropropanoyl)amino )phenyl]titanium,
bis(cyclopentadienyl)bis[2,6-difluoro-3-(N-(3-phenylpropanoyl)-2,2-dimethyl-3-chloropr opanoyl)amino)phenyl]titanium,
bis(cyclopentadienyl)bis[2,6-difluoro-3-(N-cyclohexylmethyl-(2,2-dimethyl-3-chloroprop anoyl)amino)phenyl]titanium,
bis(cyclopentadienyl)bis[2,6-difluoro-3-(N-isobutyl-(2,2-dimethyl-3-chloropropanoyl)ami no)phenyl]titanium,
bis(cyclopentadienyl)bis[2,6-difluoro-3-(N-butyl-(2-chloromethyl-2-methyl-3-chloroprop anoyl)amino)phenyl]titanium,
bis(cyclopentadienyl)bis[2,6-difluoro-3-(butylthiocarbonylamino)phenyl]titanium,
bis(cyclopentadienyl)bis[2,6-difluoro-3-(phenylthiocarbonylamino)phenyl]titanium,
bis(cyclopentadienyl)bis(2,6-difluoro-3-isocyanatophenyl)titanium,
bis(cyclopentadienyl)bis[2,6-difluoro-3-(N-ethyl-(4-tolylsulfonyl)amino)phenyl]titanium,
bis(cyclopentadienyl)bis[2,6-difluoro-3-(N-hexyl-(4-tolylsulfonyl)amino)phenyl]titanium,
bis(cyclopentadienyl)bis[2,6-difluoro-3-(N-butyl-(4-tolylsulfonyl)amino)phenyl]titanium,
bis(cyclopentadienyl)bis[2,6-difluoro-3-(N-isobutyl-(4-tolylsulfonyl)amino)phenyl]titaniu me,
bis(cyclopentadienyl)bis(2,6-difluoro-3-(N-butyl-(2,2-dimethyl-3-chloropropanoyl)amino )phenyl]titanium,
bis(cyclopentadienyl)bis[2,6-difluoro-3-(N-(3-phenylpropanoyl)-(2,2-dimethyl-3-chloropr opanoyl)amino)phenyl]titanium,
bis(cyclopentadienyl)bis[2,6-difluoro-3-(N-cyclohexylmethyl-(2,2-dimethyl-3-chloroprop anoyl)amino)phenyl]titanium,
bis(cyclopentadienyl)bis[2,6-difluoro-3-(N-isobutyl-(2,2-dimethyl-3-chloropropanoyl)ami no)phenyl]titanium,
bis(cyclopentadienyl)bis[2,6-difluoro-3-(N-butyl-(2-chloromethyl-2-methyl-3-chloroprop anoyl)amino)phenyl]titanium,
bis(cyclopentadienyl)bis[2,6-difluoro-3-(butylthiocarbonylamino)phenyl]titanium,
bis(cyclopentadienyl)bis[2,6-difluoro-3-(phenylthiocarbonylamino)phenyl]titanium,
bis(methylcyclopentadienyl)bis[2,6-difluoro-3-(N-hexyl-2,2-dimethylbutanonylamino)phe nyl]titanium,
bis(methylcyclopentadienyl)bis[2,6-difluoro-3-(N-hexyl-2,2-dimethylpentanonylamino)ph enyl]titanium,
bis(methylcyclopentadienyl)bis[2,6-difluoro-3-(N-ethylacetylamino)phenyl]titanium,

bis(methylcyclopentadienyl)bis[2,6-difluoro-3-(N-ethylpropionylamino)phenyl]titanium,
bis(trimethylsilylpentadienyl)bis[2,6-difluoro-3-(N-butyl-2,2-dimethylpropanonylamino)p henyl]titanium,
bis(cyclopentadienyl)bis[2,6-difluoro-3-(N-(2-methoxyethyl)trimethylsilylamino)phenyl]t itanium,
bis(cyclopentadienyl)bis[2,6-difluoro-3-(N-butylhexyldimethylsilylamino)phenyl]titanium,
liis(cyclopentadienyl)bis[2,6-difluoro-3-(N-ethyl-(1,1,2-trimethylpropyl)dimethylsilylami no)phenyl]titanium,
bis(cyclopentadienyl)bis[2,6-difluoro-3-(3-ethoxymethyl-3-methyl-2-azetidinon-1-yl)phen yl]titanium,
bis(cyclopentadienyl)bis[2,6-difluoro-3-(3-allyloxymethyl-3-methyl-2-azetidinon-1-yl)ph enyl]titanium,
bis(cyclopentadienyl)bis[2,6-difluoro-3-(3-chloromethyl-3-methyl-2-azetidinon-1-yl)phen yl]titanium,
bis(cyclopentadienyl)bis[2,6-difluoro-3-(N-benzyl-2,2-dimethylpropanoylamino)phenyl]ti tanium,
bis(cyclopentadienyl)bis[2,6-difluoro-3-(5,5-dimethyl-2-pyrrolidinon-1-yl)phenyl]titaniu m,
bis(cyclopentadienyl)bis[2,6-difluoro-3-(6,6-diphenyl-2-piperidinon-1-yl)phenyl]titanium,
bis(cyclopentadienyl)bis[2,6-difluoro-3-(N-(2,3-dihydro-1,2-benzothiazol-3-on(1,1-dioxid o)-2-yl)phenyl]titanium,
bis(cyclopentadienyl)bis[2,6-difluoro-3-(N-hexyl-(4-chlorobenzoyl)amino)phenyl]titaniu m,
bis(cyclopentadienyl)bis[2,6-difluoro-3-(N-hexyl-(2-chlorobenzoyl)amino)phenyl]titaniu m,
bis(cyclopentadienyl)bis[2,6-difluoro-3-(N-isopropyl-(4-chlorobenzoyl)amino)phenyl]tita nium,
bis(cyclopentadienyl)bis[2,6-difluoro-3-(N-(4-methylphenylmethyl-(4-chlorobenzoyl)ami no)phenyl]titanium,
bis(cyclopentadienyl)bis[2,6-difluoro-3-(N-(4-methylphenylmethyl)-(2-chlorobenzoyl)am ino)phenyl]titanium,
bis(cyclopentadienyl)bis[2,6-difluoro-3-(N-butyl-(4-chlorobenzoyl)amino)phenyl]titaniu m,
bis(cyclopentadienyl)bis[2,6-difluoro-3-(N-benzyl-2,2-dimethylpentanoylamino)phenyl]ti tanium,
bis(cyclopentadienyl)bis[2,6-difluoro-3-(N-(2-ethylhexyl)-4-tolylsulfonylamino)phenyl]tit anium,
bis(cyclopentadienyl)bis[2,6-difluoro-3-(N-(3-oxaheptyl)benzoylamino)phenyl]titanium,
bis(cyclopentadienyl)bis[2,6-difluoro-3-(N-(3,6-dioxadecyl)benzoylamino)phenyl]titaniu m,
bis(cyclopentadienyl)bis[2,6-difluoro-3-(trifluoromethylsulfonylamino)phenyl]titanium,
bis(cyclopentadienyl)bis[2,6-difluoro-3-(trifluoroacetylamino)phenyl]titanium,
bis(cyclopentadienyl)bis[2,6-difluoro-3-(2-chlorobenzoylamino)phenyl]titanium,
bis(cyclopentadienyl)bis[2,6-difluoro-3-(4-chlorobenzoylamino)phenyl]titanium, bis(cyclopentadienyl)bis[2,6-difluoro-3-(N-(3,6-dioxadecyl)-2,2-dimethylpentanoylamino )phenyl]titanium, bis(cyclopentadienyl)bis[2,6-difluoro-3-(N-(3,7-dimethyl-7-methoxyoctyl)benzoylamino)phenyl]titanium, and
bis(cyclopentadienyl)bis[2,6-difluoro-3-(N-cyclohexylbenzoylamino)phenyl]titanium.

Preferable initiator compounds include halomethyltriazines, hexaarylbiimidazoles and titanocene compounds, and particularly preferable initiator compounds include hexaarylbiimidazoles.

Similar to the above-described sensitizing dye, the initiator compound can be subjected to various chemical modifications in order to further improve the characteristics of the photosensitive layer. Examples of the method which can be used include binding with the sensitizing dye, an addition-polymerizable unsaturated compound or other initiator compound part, introduction of a hydrophilic site, introduction of a substituent for improving the compatibility or inhibiting the deposition of crystal, introduction of a substituent for improving the adhesion, and formation of a polymer.

The use method of the initiator compound can also be appropriately arranged depending on the characteristic design of the photosensitive material similar to the above-described sensitizing dye. For instance, when two or more initiator compounds are used in combination, the compatibility with the photosensitive layer can be enhanced.

In view of the photosensitivity, use of the initiator compound in a larger amount is ordinarily more advantageous. Sufficiently high photosensitivity can be obtained by using the initiator compound in an amount from 0.5 to 80 parts by weight, preferably from 1 to 50 parts by weight, per 100 parts by weight of the photosensitive layer components. (C) Compound capable of changing irreversibly its physical or chemical property with at least any one of a radical, an acid and a base

The compound capable of changing irreversibly its physical or chemical property with at least any one of a radical, an acid and a base each generated by the initiator compound, which is the third essential component in the photosensitive composition according to the invention, is a compound capable of changing irreversibly its physical or chemical property by the action of active species generated by the photoreaction of the above-described photo-initiation system to cause a hardening reaction, a color formation reaction, a decoloration reaction or the like. Any compound can be appropriately used without any particular limitation insofar as the compound has such a property. For example, the compound described above for the initiation system each itself has such a property in many cases.

The characteristics of the compound (C), which are changed by the action of a radical, an acid and/or a base generated from the photo-initiation system, include molecular physical properties, for example, absorption spectrum (color), chemical structure and polarizability, and material physical properties, for example, solubility, strength, refractive index, fluidity and adhesive property.

For example, when a compound of changing an absorption spectrum with pH, for example, a pH indicator is used as the compound (C) and an acid or a base is generated from the photo-initiation system, the color tone can be changed only in the exposed area. Such a composition is useful as an image forming material. Similarly, when a

compound of changing an absorption spectrum by an oxidation-reduction or nucleophilic addition reaction is used as the compound (C), oxidation, reduction or the like is induced by a radical generated from the photo-initiation system and thereby image formation can be effected. These are described, for example, in J. Am. Chem. Soc., 108, 128 (1986), J. Imaging Sci., 30, 215 (1986) and Israel. J. Chem., 25, 264 (1986).

Especially, by selecting a polymerizable compound undergoing reaction by the action of a radical, an acid and/or a base (hereinafter, appropriately referred to as a polymerizable compound), specifically, a compound capable of undergoing addition-polymerization or polycondensation, as the compound (C) and combining it with the photo-initiation system, a photocurable resin composition or a negative-working photopolymer composition can be formed. Such a composition is also useful as a negative-working photosensitive layer of a lithographic printing plate precursor.

As the compound (C), a radical polymerizable compound (for example, a compound having an ethylenically unsaturated bond), a cationic polymerizable compound (for example, an epoxy compound, a vinyl ether compound or a methylol compound) or an anionic polymerizable compound (for example, an epoxy compound) is used. These are described, for example, in Photopolymer Handbook, edited by Photopolymer Konwakai, published by Kogyo Chosakai (1989), and Kobunshi (Polymer), 45, 786 (1996). A composition in which a thiol compound is used as the compound (C) and combined with a photo-radical generation system is also well known.

It is also useful to use an acid-decomposable compound as the compound (C) and combine it with a photo-acid generator. For instance, a material which comprises a polymer having a side chain or main chain decomposable with an acid and changes in the solubility or hydrophilic/hydrophobic property by light is widely used in practice as a photodecomposable photosensitive resin or a positive-working photopolymer. Specific examples thereof include those described, for example, in ACS. Symp. Ser., 242, 11 (1984), JP-A-60-3625, U.S. Patents 5,102,771, 5,206,317 and 5,212,047, JP-A-4-26850, JP-A-3-1921731, JP-A-60-10247 and JP-A-62-40450.

An embodiment using as the compound (C), the addition-polymerizable compound particularly useful for the purpose of obtaining a high-sensitive lithographic printing plate precursor, which is one of the main uses of the photosensitive composition according to the invention, is described in more detail below.

(C-1) Addition-polymerizable compound

The addition-polymerizable compound having at least one ethylenically unsaturated double bond, which is a preferable example of the compound (C) for use in the invention, is selected from compounds having at least one, preferably two or more, terminal ethylenically unsaturated double bonds. Such compounds are broadly known in the art and they can be used in the invention without any particular limitation.

The compound has a chemical form, for example, a monomer, a prepolymer, specifically, a dimer, a trimer or an oligomer, or a copolymer thereof, or a mixture thereof. Examples of the monomer include unsaturated carboxylic acids (for example, acrylic acid, methacrylic acid, itaconic acid, crotonic acid, isocrotonic acid or maleic acid) and esters or amides thereof Preferably, esters of an unsaturated carboxylic acid with an aliphatic polyhydric alcohol compound and amides of an unsaturated carboxylic acid with an aliphatic polyvalent amine compound are used. An addition reaction product of an unsaturated carboxylic acid ester or amide having a nucleophilic substituent, for example, a hydroxy group, an amino group or a mercapto group, with a monofunctional or polyfunctional isocyanate or epoxy compound, or a dehydration condensation reaction product of the unsaturated carboxylic acid ester or amide with a monofunctional or polyfunctional carboxylic acid is also preferably used. Moreover, an addition reaction product of an unsaturated carboxylic acid ester or amide having an electrophilic substituent, for example, an isocyanato group or an epoxy group with a monofunctional or polyfunctional alcohol, amine or thiol, or a substitution reaction product of an unsaturated carboxylic acid ester or amide having a releasable substituent, for example, a halogen group or a tosyloxy group with a monofunctional or polyfunctional alcohol, amine or thiol is also preferably used. In addition, compounds in which the unsaturated carboxylic acid described above is replaced by an unsaturated phosphonic acid, styrene, vinyl ether or the like can also be used.

Specific examples of the monomer, which is an ester of an aliphatic polyhydric alcohol compound with an unsaturated carboxylic acid, include acrylic acid esters, for example, ethylene glycol diacrylate, triethylene glycol diacrylate, 1,3-butanediol diacrylate, tetramethylene glycol diacrylate, propylene glycol diacrylate, neopentyl glycol diacrylate, trimethylolpropane triacrylate, trimethylolpropane tri(acryloyloxypropyl) ether, trimethylolethane triacrylate, hexanediol diacrylate, 1,4-cyclohexanediol diacrylate, tetraethylene glycol diacrylate, pentaerythritol diacrylate, pentaerythritol triacrylate, pentaerythritol tetraacrylate, dipentaerythritol diacrylate, dipentaerythritol hexaacrylate, sorbitol triacrylate, sorbitol tetraacrylate, sorbitol pentaacrylate, sorbitol hexaacrylate, tri(acryloyloxyethyl) isocyanurate or polyester acrylate oligomer;

methacrylic acid esters, for example, tetramethylene glycol dimethacrylate, triethylene glycol dimethacrylate, neopentyl glycol dimethacrylate, trimethylolpropane trimethacrylate, trimethylolethane trimethacrylate, ethylene glycol dimethacrylate, 1,3-butanediol dimethacrylate, hexanediol dimethacrylate, pentaerythritol dimethacrylate, pentaerythritol trimethacrylate, pentaerythritol tetramethacrylate, dipentaerythritol dimethacrylate, dipentaerythritol hexamethacrylate, sorbitol

trimethacrylate, sorbitol tetramethacrylate, bis[p-(3-methacryloxy-2-hydroxypropoxy)phenyl]dimethylmethane or bis[p-(methacryloxyethoxy)phenyl]dimethylmethane;
itaconic acid esters, for example, ethylene glycol diitaconate, propylene glycol diitaconate,
1,3-butanediol diitaconate, 1,4-butanediol diitaconate, tetramethylene glycol diitaconate, pentaerythritol diitaconate or sorbitol tetraitaconate;
crotonic acid esters, for example, ethylene glycol dicrotonate, tetramethylene glycol dicrotonate, pentaerythritol dicrotonate or sorbitol tetradicrotonate;
isocrotonic acid esters, for example, ethylene glycol diisocrotonate, pentaerythritol diisocrotonate or sorbitol tetraisocrotonate;
and maleic acid esters, for example, ethylene glycol dimaleate, triethylene glycol dimaleate, pentaerythritol dimaleate and sorbitol tetramaleate.

Other examples of the ester, which can be preferably used, include aliphatic alcohol esters described in JP-B-46-27926, JP-B-51-47334 and JP-A-57-196231, esters having an aromatic skeleton described in JP-A-59-5240, JP-A-59-5241 and JP-A-2-226149, and esters containing an amino group described in JP-A-1-165613.

The above-described ester monomers can also be used as a mixture,

Specific examples of the monomer, which is an amide of an aliphatic polyvalent amine compound with an unsaturated carboxylic acid, include methylene bisacrylamide, methylene bismethacrylamide, 1,6-hexamethylene bisacrylamide, 1,6-hexamethylene bismethacrylamide, diethylenetriamine trisacrylamide, xylylene bisacrylamide and xylylene bismethacrylamide.

Other preferred examples of the amide monomer include amides having a cyclohexylene structure described in JP-B-54-21726.

Urethane type addition-polymerizable compounds produced using an addition reaction between an isocyanate and a hydroxy group are also preferably used, and specific examples thereof include vinylurethane compounds having two or more polymerizable vinyl groups per molecule obtained by adding a vinyl monomer containing a hydroxy group represented by formula (V) shown below to a polyisocyanate compound having two or more isocyanate groups per molecule, described in JP-B-48-41708.

$$CH_2=C(R)COOCH_2CH(R')OH \qquad (V)$$

wherein R and R' each independently represents H or $CH_3$.

Also, urethane acrylates described in JP-A-51-37193, JP-B-2-32293 and JP-B-2-16765, and urethane compounds having an ethylene oxide skeleton described in JP-B-58-49860, JP-B-56-17654, JP-B-62-39417 and JP-B-62-39418 are preferably used.

Furthermore, a photosensitive composition having remarkably excellent photo-speed can be obtained by using an addition polymerizable compound having an amino structure or a sulfide structure in its molecule, described in JP-A-63-277653, JP-A-63-260909 and JP-A-1-103238.

Other examples include polyfunctional acrylates and methacrylates, for example, polyester acrylates and epoxy acrylates obtained by reacting an epoxy resin with (meth)acrylic acid, described in JP-A-48-64183, JP-B-49-43191 and JP-B-52-30490. Specific unsaturated compounds described in JP-B-46-43946, JP-B-1-40337 and JP-B-1-40336, and vinylphosphonic acid type compounds described in JP-A-2-25493 can also be exemplified. In some cases, structure containing a perfluoroalkyl group described in JP-A-61-22048 can be preferably used. Moreover, photocurable monomers or oligomers described in Nippon Secchaku Kyokaishi (Journal of Japan Adhesion Society), Vol. 20, No. 7, pages 300 to 308 (1984) can also be used.

Details of the method of using the addition-polymerizable compound, for example, selection of the structure, individual or combination use or an amount added, can be appropriately arranged depending on the characteristic design of the final lithographic printing plate precursor. For instance, the compound is selected from the following standpoints. In view of the photo-speed, a structure having a large content of unsaturated groups per molecule is preferred and in many cases, a difunctional or more functional compound is preferred. Also, in order to increase the strength of image area, that is, hardened layer, a trifunctional or more functional compound is preferred. A combination use of compounds different in the functional number or in the kind of polymerizable group (for example, an acrylic acid ester, a methacrylic acid ester, a styrene compound or a vinyl ether compound) is an effective method for controlling both the sensitivity and the strength. The polymerizable compound having a large molecular weight or the polymerizable compound of high hydrophobicity is excellent in the layer strength but it may not be preferable in some cases from the standpoint of the development speed or deposition in a developer. The selection and use method of the addition-polymerizable compound are also important factors for the compatibility and dispersibility with other components (for example, a binder polymer, an initiator or a coloring agent) in the photosensitive layer. For instance, the compatibility may be improved in some cases by using the compound of low purity or using two or more kinds of the compounds in combination. A specific structure may be selected for the purpose of improving an adhesion property to a support or a protective layer described

hereinafter. With respect to a ratio of the addition-polymerizable compound used in the photosensitive layer, a larger ratio is advantageous in view of the sensitivity but when the ratio is too large, undesirable phase separation may occur, a problem may arise in the production step due to tackiness of the photosensitive layer (for example, production failure due to transfer or adhesion of the components of photosensitive layer), and a problem of the deposition in the developer may occur. In view of these points, the ratio of the addition-polymerizable compound is in many cases preferably from 5 to 80% by weight, more preferably from 25 to 75% by weight, based on the nonvolatile components of the photosensitive layer. The addition-polymerizable compounds may be used individually or in combination of two or more thereof. In the method of using the addition-polymerizable compound, the structure, blend and amount added can be appropriately selected by taking account of the degree of polymerization inhibition due to oxygen, resolution, fogging property, change in refractive index, surface tackiness and the like. Further, depending on the case, a layer construction, for example, an undercoat layer or an overcoat layer, and a coating method, may also be considered.

In case of using a compound other than the addition-polymerizable compound (C-1) as the compound (C), an optimum amount of the compound can be appropriately determined depending on the desired change in the properties or the compound used. Ordinarily, when the compound undergoing the change in the absorption spectrum thereof due to oxidation, reduction or nucleophilic addition reaction is used, it is preferred that the amount thereof is approximately from 10 to 80% by weight based on the total solid content of the photosensitive composition.

(D) Binder polymer

In the application of the photosensitive composition according to the invention to a photosensitive layer of a lithographic printing plate precursor as a preferred embodiment of the invention, it is preferred to further use a binder polymer in the photosensitive composition in view of improving a layer property or the like.

The binder polymer is preferably a linear organic high molecular polymer. The "linear organic high molecular polymer" may be any linear organic high molecular polymer. Preferably, a linear organic high molecular polymer soluble or swellable in water or alkalescent water, which enables water development or alkalescent water development, is selected. The linear organic high molecular polymer is selected not only as a film forming agent of the composition but also in consideration of the use of water, alkalescent water or organic solvent as a developer. For instance, when a water-soluble organic high molecular polymer is used, water development can be performed. Examples of the linear organic high molecular polymer include addition polymers having a carboxylic acid group in the side chain thereof, for example, methacrylic acid copolymers, acrylic acid copolymers, itaconic acid copolymers, crotonic acid copolymers, maleic acid copolymers and partially esterified maleic acid copolymers described in JP-A-59-44615, JP-B-54-34327, JP-B-58-12577, JP-B-54-25957, JP-A-54-92723, JP-A-59-53836 and JP-A-59-71048. Further, acidic cellulose derivatives having a carboxylic acid group in the side chain thereof may also be used. In addition, polymers obtained by adding a cyclic acid anhydride to addition polymers having a hydroxy group are also useful.

Among them, [benzyl (meth)acrylate/(meth)acrylic acid/if desired, other addition-polymerizable vinyl monomer] copolymers and [allyl (meth)acrylate/(meth)acrylic acid/if desired, other addition-polymerizable vinyl monomer] copolymers are preferred because of their excellent balance in the film strength, sensitivity and developing property.

Also, acid group-containing urethane binder polymers described in JP-B-7-120040, JP-B-7-120041, JP-B-7-120042, JP-B-8-12424, JP-A-63-287944, JP-A-63-287947, JP-A-1-271741 and Japanese Patent Application No. 10-116232 are advantageous in view of printing durability and low exposure aptitude because of their very excellent strength.

Moreover, a binder having an amido group described in JP-A-11-171909 is preferable because of both of the excellent developing property and the film strength.

Furthermore, polyvinyl pyrrolidone, polyethylene oxide and the like are useful as the water-soluble linear organic polymer. Also, an alcohol-soluble nylon and a polyether of 2,2-bis-(4-hydroxyphenyl)propane with epichlorohydrin are useful for the purpose of increasing the strength of hardened layer. The linear organic high molecular polymer can be mixed in an appropriate amount to the photosensitive composition. However, when the amount exceeds 90% by weight, the preferable results are not obtained in view of the strength of image formed or the like. The amount added is preferably from 30 to 85% by weight. Also, the addition-polymerizable compound having an ethylenically unsaturated double bond and the linear organic high molecular polymer are preferably used in a weight ratio of 1/9 to 7/3. According to a preferred embodiment, the binder polymer is substantially insoluble in water and soluble in alkali. By using such a binder polymer, an organic solvent which is not preferable in view of the environmental concern can be avoided or limited to a very small amount. In such a case, an acid value (acid content per g of polymer, indicated by the chemical equivalent number) and molecular weight of the binder polymer are appropriately selected by taking account of the image strength and the developing property. The acid value is preferably in a range from 0.4 to 3.0 meq/g, more preferably from 0.6 to 2.0 meq/g, and the molecular weight is preferably in a range from 3,000 to 500,000, more preferably from 10,000 to 300,000.

(E) Other components

To the photosensitive composition according to the invention, other components suitable for the use, production method and the like are appropriately added. Preferred additives are described below.

(E-1) Co-sensitizer

The sensitivity can be further improved by using a certain additive (hereinafter referred to as a "co-sensitizer"). The operation mechanism of the co-sensitizer is not quite clear but may be considered to be mostly based on the following chemical process. Specifically, the co-sensitizer reacts with various intermediate active species (for example, a radical or a cation) generated during the process of photo-reaction initiated by the initiator compound and subsequent addition-polymerization reaction to produce new active radicals. Such compounds are roughly classified into (a) compound which is reduced to produce an active radical, (b) compound which is oxidized to produce an active radical and (c) compound which reacts with a radical having low activity to convert it into a more highly active radical or acts as a chain transfer agent. However, in many cases, a common view about which an individual compound belongs to which type is not present.

(a) Compound which is reduced to produce an active radical

Compound having carbon-halogen bond:

An active radical is considered to be generated by the reductive cleavage of the carbon-halogen bond. Specific examples of the compound preferably used include a trihalomethyl-s-triazine and a trihalomethyloxadiazole.

Compound having nitrogen-nitrogen bond:

An active radical is considered to be generated by the reductive cleavage of the nitrogen-nitrogen bond. Specific examples of the compound preferably used include a hexaarylbiimidazole.

Compound having oxygen-oxygen bond:

An active radical is considered to be generated by the reductive cleavage of the oxygen-oxygen bond. Specific examples of the compound preferably used include an organic peroxide.

Onium compound:

An active radical is considered to be generated by the reductive cleavage of a carbon-hetero bond or oxygen-nitrogen bond. Specific examples of the compound preferably used include a diaryliodonium salt, a triarylsulfonium salt and an N-alkoxypyridinium (azinium) salt.

Ferrocene and iron allene complexes:

An active radical can be reductively generated.

(b) Compound which is oxidized to produce an active radical

Alkylate complex:

An active radical is considered to be generated by the oxidative cleavage of a carbon-hetero bond. Specific examples of the compound preferably used include a triaryl alkyl borate.

Alkylamine compound:

An active radical is considered to be generated by the oxidative cleavage of a C-X bond on the carbon adjacent to nitrogen, wherein X is preferably a hydrogen atom, a carboxy group, a trimethylsilyl group or a benzyl group. Specific examples of the compound include an ethanolamine, an N-phenylglycine and an N-trimethylsilylmethylaniline.

Sulfur-containing or tin-containing compound:

A compound in which the nitrogen atom of the above-described amine is replaced by a sulfur atom or a tin atom is considered to generate an active radical in the same manner. Also, a compound having an S-S bond is known to effect sensitization by the cleavage of the S-S bond.

α-Substituted methylcarbonyl compound:

An active radical can be generated by the oxidative cleavage of carbonyl-α-carbon bond. The compound in which the carbonyl is converted into an oxime ether also shows the similar function. Specific examples of the compound include an 2-alkyl-1-[4-(alkylthio)phenyl]-2-morpholinopronone-1 and an oxime ether obtained by a reaction of the 2-alkyl-1-[4-(alkylthio)phenyl]-2-morpholinopronone-1 with a hydroxyamine and subsequent etherification of the N-OH.

Sulfinic acid salt:

An active radical can be reductively generated. Specific examples of the compound include sodium arylsulfinate.

(c) Compound which reacts with a radical to convert it into a more highly active radical or acts as a chain transfer agent:

For example, a compound having SH, PH, SiH or GeH in its molecule is used as the compound which reacts with a radical to convert it into a more highly active radical or acts as a chain transfer agent. The compound donates hydrogen to a low active radical species to generate a radical or is oxidized and deprotonized to generate a radical. Specific examples of the compound include a 2-mercaptobenzimidazole.

A large number of examples of the co-sensitizer are more specifically described, for example, in JP-A-9-236913 as additives for the purpose of increasing sensitivity, and they are used in the invention. Some of them are set forth below, but the invention should not be construed as being limited thereto.

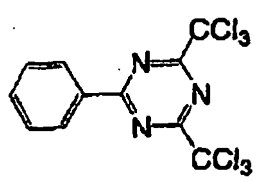
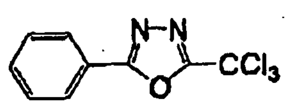
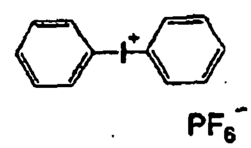

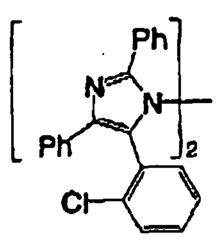
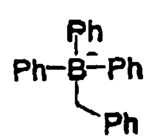
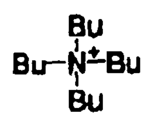
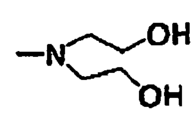

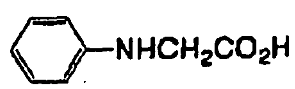
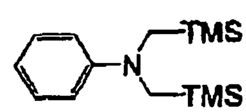

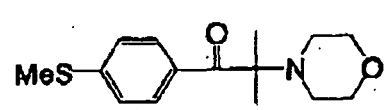
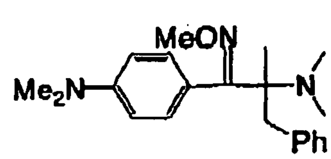

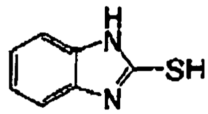

Similarly to the above-described sensitizing dye, the co-sensitizer can be subjected to various chemical modifications so as to improve the characteristics of the photosensitive layer. For instance, methods, for example, binding to the sensitizing dye, initiator compound, addition-polymerizable unsaturated compound or other part, introduction of a hydrophilic site, introduction of a substituent for improving compatibility or inhibiting deposition of crystal, introduction of a substituent for improving adhesion, and formation of a polymer, may be used.

The co-sensitizers may be used individually or in combination of two or more thereof. The amount of the co-sensitizer used is ordinarily from 0.05 to 100 parts by weight, preferably from 1 to 80 parts by weight, more preferably from 3 to 50 parts by weight, per 100 parts by weight of the polymerizable compound having an ethylenically unsaturated double bond.

(E-2) Thermal polymerization inhibitor

It is preferred to add a small amount of a thermal polymerization inhibitor to the photosensitive composition according to the invention in addition to the above-described basic components, in order to prevent undesirable thermal polymerization of the polymerizable compound having an ethylenically unsaturated double bond during the production or preservation of the photosensitive composition. Suitable examples of the thermal polymerization inhibitor include hydroquinone, p-methoxyphenol, di-tert-butyl-p-cresol, pyrogallol, tert-butylcatechol, benzoquinone, 4,4'-thiobis(3-methyl-6-tert-butylphenol), 2,2'-methylenebis(4-methyl-6-tert-butylphenol) and N-nitrosophenylhydroxyamine cerium(III) salt. The amount of the thermal polymerization inhibitor added is preferably from about 0.01 to about 5% by weight, based on the total photosensitive composition. In the case of coating the photosensitive composition as a photosensitive layer of a lithographic printing plate precursor, in order to avoid polymerization inhibition due to oxygen, a higher fatty acid derivative, for example, behenic acid or behenic amide may be added and allowed to localize on the photosensitive layer surface during the drying step after the coating thereof, if desired. The amount of the higher fatty acid derivative added is preferably from about 0.5 to about 10% by weight based on the total photosensitive composition.

(E-3) Coloring agent

In the case of using the photosensitive composition according to the invention for the photosensitive layer of the lithographic printing plate precursor, a coloring agent of a dye or a pigment may further be added for the purpose of coloring the photosensitive layer. By the coloring, a so-called plate inspection property, for example, visibility of a printing plate after the plate-making or aptitude for an image density measurement apparatus can be improved. Since many dyes cause reduction in the sensitivity of photopolymerizable photosensitive layer, a pigment is preferably used as the coloring agent. Specific examples thereof include pigments, for example, a phthalocyanine pigment, an azo pigment, carbon black or titanium oxide, and dyes, for example, Ethyl Violet, Crystal Violet, an azo dye, an anthraquinone dye or a cyanine dye. The amount of the coloring agent added is preferably from about 0.5 to about 5% by weight based on the total photosensitive composition.

(E-4) Other additives

In the case of using the photosensitive composition according to the invention for the photosensitive layer of the lithographic printing plate precursor, known additives, for example, an inorganic filler or a plasticizer for improving physical properties of the hardened layer, or an oil-sensitizer capable of improving the inking property on the surface of photosensitive layer may be further added.

Examples of the plasticizer include dioctyl phthalate, didodecyl phthalate, triethylene glycol dicaprylate, dimethyl glycol phthalate, tricresyl phosphate, dioctyl adipate, dibutyl sebacate and triacetyl glycerol. In the case of using a binder, the plasticizer can be added in an amount of 10% by weight or less based on the total weight of the compound having an ethylenically unsaturated double bond and the binder.

Also, an UV initiator, a heat crosslinking agent or the like may be added in order to increase the effect of heating or exposure after the development, which will be described hereinafter, for the purpose of improving the film strength (printing durability) of the photosensitive layer of the lithographic printing plate precursor.

In addition, for improving the adhesion between the photosensitive layer and a support or increasing developing and removing property of the unexposed photosensitive layer, an additive may be added or an interlayer may be provided.

For instance, a compound exhibiting a relatively strong interaction with the substrate, for example, a compound having a diazonium structure or a phosphone compound may be added or undercoated, whereby the adhesion is strengthened and the printing durability can be increased. Also, by the addition or undercoating of a hydrophilic polymer, for example, polyacrylic acid or polysulfonic acid, the developing property of the non-image area is improved and resistance to stain can be increased.

In the case of coating the photosensitive composition according to the invention on a support to provide the photosensitive layer of the lithographic printing plate precursor, the photosensitive composition is used after dissolving it in various organic solvents. Examples of the solvent used include acetone, methyl ethyl ketone, cyclohexane, ethyl acetate, ethylene dichloride, tetrahydrofuran, toluene, ethylene glycol monomethyl ether, ethylene glycol monoethyl ether, ethylene glycol dimethyl ether, propylene glycol monomethyl ether, propylene glycol monoethyl ether, acetylacetone, cyclohexanone, diacetone alcohol, ethylene glycol monomethyl ether acetate, ethylene glycol ethyl ether acetate, ethylene glycol monoisopropyl ether, ethylene glycol monobutyl ether acetate, 3-methoxypropanol, methoxymethoxyethanol, diethylene glycol monomethyl ether, diethylene glycol monoethyl ether, diethylene glycol dimethyl ether, diethylene glycol diethyl ether, propylene glycol monomethyl ether acetate, propylene glycol monoethyl ether acetate, 3-methoxypropyl acetate, N,N-dimethylformamide, dimethyl sulfoxide, γ-butyrolactone, methyl lactate and ethyl lactate. The solvents may be used individually or as a mixture of two or more thereof The concentration of solid content in the coating solution is suitably from 2 to 50% by weight.

The coating amount of the photosensitive layer on the support is appropriately determined depending on the use taking influences on the sensitivity and developing property of the photosensitive layer, the strength of the exposed layer, the printing durability and the like into consideration. When the coating amount is too small, the printing durability is not sufficient, whereas when it is excessively large, the sensitivity decreases and as a result, not only the exposure but also the development processing disadvantageously take a longer time. In the case of a lithographic printing plate precursor for scanning exposure, which is one of the preferable embodiments of the photosensitive composition according to the invention, the coating amount of the photosensitive layer is preferably from about 0.1 to about 10 $g/m^2$, more preferably from 0.5 to 5 $g/m^2$, in terms of the weight after drying.

In the case of using the photosensitive composition according to the invention for the photosensitive layer of the lithographic printing plate precursor, it is preferable to use an initiation system comprising as the sensitizer, the compound represented by formula (1) or (2) in combination with a hexaarylbiimidazole, as the initiator compound. Particularly, an embodiment containing such an initiation system and the addition-polymerizable compound (C-1) is preferable.

(Support)

In order to obtain a lithographic printing plate precursor using the photosensitive composition according to the invention, the photosensitive layer is desirably provided on a support having a hydrophilic surface. As for the hydrophilic support, conventionally known hydrophilic supports used for lithographic printing plate precursors can be used without any limitation. The support used is preferably a dimensionally stable plate-like material and includes, for example, paper, paper laminated with plastic (e.g., polyethylene, polypropylene or polystyrene), a metal plate (e.g., an aluminum, zinc or copper plate) and a plastic film (e.g., a cellulose diacetate, cellulose triacetate, cellulose propionate, cellulose butyrate, cellulose acetate butyrate, cellulose nitrate, polyethylene terephthalate, polyethylene, polystyrene, polypropylene, polycarbonate or polyvinyl acetal film). The support may be a sheet of a single component, for example, a resin film or a metal plate, or a laminate of two or more materials, for example, paper or a plastic film having laminated or deposited thereon the above-described metal or a laminate sheet of different plastic films. If desired, the surface of the support may be appropriately subjected to a known physical or chemical treatment for the purpose of imparting hydrophilicity, improving the strength or the like.

As the support particularly preferred, paper, a polyester film and an aluminum plate are exemplified. Among them, the aluminum plate is especially preferable, because it has good dimensional stability, is relatively inexpensive and can provide a surface having excellent hydrophilicity and strength by a surface treatment, if desired. Also, a composite sheet comprising an aluminum sheet having bonded thereon a polyethylene terephthalate film described in JP-B-48-18327 is preferable.

The aluminum plate is preferably a pure aluminum plate or an alloy plate mainly comprising aluminum and containing a trace amount of hetero element. A plastic film laminated or deposited with aluminum may also be used. Examples of the hetero element contained in the aluminum alloy include silicon, iron, manganese, copper, magnesium, chromium, zinc, bismuth, nickel and titanium. The content of the hetero element in the alloy is at most 10% by weight. The aluminum particularly preferred in the invention is pure aluminum. However, since perfectly pure aluminum is difficult to produce in view of the refining technique, the aluminum may contain a trace amount of hetero element. The composition of the aluminum plate for use in the invention is not specified and conventionally known and used aluminum plates can be appropriately employed. The thickness of the aluminum plate for use in the invention is approximately from 0.1 to

0.6 mm, preferably from 0.15 to 0.4 mm, and particularly preferably from 0.2 to 0.3 mm.

In the case of a support having a metal surface, particularly an aluminum surface, the support is preferably subjected to a surface treatment, for example, surface roughening (graining) treatment, immersing treatment in an aqueous solution of sodium silicate, potassium fluorozirconate, a phosphate or the like, or anodizing treatment.

If desired, in order to remove rolling oil adhered on the surface, a degreasing treatment with a surfactant, an organic solvent, an alkali aqueous solution or the like is performed in advance of the surface roughening of the aluminum plate.

The surface roughening treatment of the aluminum plate may be performed by various methods, for example, a method of mechanically roughening the surface, a method of electrochemically dissolving and roughening the surface or a method of chemically dissolving the surface selectively. Examples of the mechanical method which can be used include known methods, for example, a ball graining method, a brush graining method, a blast graining method or a buff graining method. Examples of the electrochemical surface roughing method include a method of performing the surface roughening in an electrolytic solution, for example, hydrochloric acid or nitric acid by passing an alternating current or a direct current. A combination of both of these two methods described in JP-A-54-63902 may also be used. The aluminum plate subjected to the surface roughening treatment and, if desired, to an alkali etching treatment and a neutralizing treatment, can be subjected to an anodizing treatment. As an electrolyte for use in the anodizing treatment of aluminum plate, various electrolytes capable of forming a porous oxide film can be employed and sulfuric acid, phosphoric acid, oxalic acid, chromic acid or a mixed acid thereof is ordinarily used. The concentration of electrolyte is appropriately determined according to the kind of electrolyte used.

Further, an aluminum plate subjected to the surface roughening and then an immersing treatment in an aqueous sodium silicate solution can be preferably used. An aluminum plate subjected to the anodizing treatment and then to an immersing treatment in an aqueous alkali metal silicate solution described in JP-B-47-5125 is preferably used. The anodizing treatment is performed by passing a current using the aluminum plate as an anode in an electrolytic solution of an aqueous or non-aqueous solution of an inorganic acid, for example, phosphoric acid, chromic acid, sulfuric acid or boric acid, an organic acid, for example, oxalic acid or sulfamic acid, or a salt thereof, individually or in combination of two or more thereof

The silicate electrodeposition described in U.S. Patent 3,658,662 is also effective for the hydrophilizing treatment of the support. A surface treatment in which a support subjected to electrolytic graining is combined with the above-described anodizing treatment and sodium silicate treatment, described in JP-B-46-27481, JP-A-52-58602 and JP-A-52-30503 is also useful. Further; a support subjected to mechanical roughening, chemical etching, electrolytic graining, anodizing and sodium silicate treatment in this order described in JP-A-56-28893 is preferably used.

A support which is subjected to, after these treatments, undercoating with a water-soluble resin (for example, polyvinylphosphonic acid, a polymer or copolymer having a sulfonic acid group on its side chain or polyacrylic acid), a water-soluble metal salt (for example, zinc borate), a yellow dye, an amine salt or the like, is also preferably used.

In addition, a substrate subjected to a sol-gel treatment, where a functional group capable of undergoing an addition reaction by a radical is covalently bonded, described in JP-A 7-159983 can also be preferably used.

Other preferred examples include a support provided with a water-resistant hydrophilic layer as a surface layer on an appropriate support. Examples of the surface layer include a layer comprising an inorganic pigment and a binder described in U.S. Patent 3,055,295 and JP-A-56-13168, a hydrophilic swellable layer described in JP-A-9-80744 and a sol-gel film comprising titanium oxide, polyvinyl alcohol and an silicic acid described in JP-W-8-507727 (the term "JP-W" as used herein means an "unexamined published Japanese international patent application").

The hydrophilizing treatment is performed not only to render the support surface hydrophilic but also to prevent a detrimental reaction of the photosensitive composition provided thereon and to increase the adhesion of the photosensitive layer.

(Protective layer)

In the case of using the photosensitive composition according to the invention in a lithographic printing plate precursor for scanning exposure, a protective layer is provided on the photosensitive layer containing a polymerizable compound, if desired. As for such a lithographic printing plate precursor, exposure is ordinarily performed in the atmosphere and the protective layer prevents a low molecular weight compound, for example, oxygen or a basic substance present in the atmosphere, which inhibits the image-forming reaction initiated in the photosensitive layer upon the exposure, from permeating into the photosensitive layer, whereby the protective layer prevents the inhibition of the image-forming reaction at the exposure in the atmosphere. Accordingly, the characteristics required for the protective layer include to have a low permeability of the low molecular weight compound, for example, oxygen, to well transmit light used for the exposure, to exhibit good adhesion to the photosensitive layer and to be easily removed in a developing step after the exposure.

Various investigations on the protective layer have been made and are described in detail, for example, in U.S.

Patent 3,458,311 and JP-A-55-49729. The material which can be used in the protective layer is preferably, for example, a water-soluble polymer compound having relatively excellent crystallinity. Specifically, a water-soluble polymer, for example, polyvinyl alcohol, polyvinyl pyrrolidone, an acidic cellulose, gelatin, gum arabic and a polyacrylic acid are known. Among them, when polyvinyl alcohol is used as the main component, most excellent results can be obtained in view of fundamental characteristics, for example, an oxygen blocking property and a removability by development. The polyvinyl alcohol used for the protective layer may be partially substituted with an ester, an ether or an acetal as far as it contains the unsubstituted vinyl alcohol units sufficient for ensuring the necessary oxygen blocking property and water solubility. Similarly, a part of the polyvinyl alcohol may have other copolymer component. In particular, a mixture of polyvinyl alcohol and polyvinyl pyrrolidone wherein an amount of the polyvinyl pyrrolidone is from 15 to 50% by weight is preferable in view of preservation stability.

Examples of the polyvinyl alcohol include those having a hydrolysis degree of 71 to 100% and a polymerization degree of 300 to 2,400. Specific examples thereof include PVA-105, PVA-110, PVA-117, PVA-117H, PVA-120, PVA-124, PVA-124H, PVA-CS, PVA-CST, PVA-HC, PVA-203, PVA-204, PVA-205, PVA-210, PVA-217, PVA-220, PVA-224, PVA-217EE, PVA-217E, PVA-220E, PVA-224E, PVA-405, PVA-420, PVA-613 and L-8, produced by Kuraray Co., Ltd.

The components (selection of PVA, use of additives) and coating amount of the protective layer are determined by taking account of the oxygen blocking property, removability by development, fogging property, adhesion and scratch resistance. In general, as the hydrolysis degree of PVA used is higher (as the unsubstituted vinyl alcohol unit content in the protective layer is higher) and as the layer thickness is larger, the oxygen blocking property becomes higher, which is advantageous in view of the sensitivity. However, when the oxygen blocking property is excessively increased, there arise problems, for example, in that an undesirable polymerization reaction takes place during the production or preservation of the lithographic printing plate precursor, or in that undesirable fogging or thickening of image lines is caused at the time of image exposure. The adhesion to the photosensitive layer and scratch resistance are also important factors in view of handling of the lithographic printing plate precursor. More specifically, when a hydrophilic layer comprising a water-soluble polymer is laminated on a lipophilic polymerizable layer, peeling is liable to occur due to insufficient adhesion and the peeled part causes a defect, for example, hardening failure of the layer due to polymerization inhibition by oxygen.

To overcome such a problem, various proposals have been made with an attempt to improve the adhesion between these two layers. For instance, the sufficient adhesion can be obtained by mixing from 20 to 60% by weight of an acrylic emulsion, a water-insoluble vinyl pyrrolidone-vinyl acetate copolymer or the like in a hydrophilic polymer mainly comprising a polyvinyl alcohol and laminating the mixture on the photosensitive layer. Every known technique can be applied to the protective layer according to the invention. A coating method of the protective layer is described in detail, for example, in U. S. Patent 3,458,311 and JP-A-55-49729.

Furthermore, other functions may also be imparted to the protective layer. For instance, when a coloring agent (for example, a water-soluble dye) having excellent transmittance of light for use in the exposure (for example, light having a wavelength of 760 to 1,200 nm in the case of using an infrared laser) and capable of efficiently absorbing light having a wavelength irrelevant to the exposure is added, a safe light aptitude can be more improved without causing decrease in the sensitivity.

In the case where the lithographic printing plate precursor using the photosensitive composition according to the invention is subjected to plate-making to prepare a lithographic printing plate, an image is ordinarily obtained by performing the exposure process (image exposure) and then removing the unexposed area of the photosensitive layer with a developer. Examples of the developer preferably employed in the case of using the photosensitive composition in the preparation of a lithographic printing plate include a developer described in JP-B-57-7427. The developer is suitably an aqueous solution of an inorganic alkali agent, for example, sodium silicate, potassium silicate, sodium hydroxide, potassium hydroxide, lithium hydroxide, sodium tertiary phosphate, sodium secondary phosphate, ammonium tertiary phosphate, ammonium secondary phosphate, sodium metasilicate, sodium bicarbonate or aqueous ammonia, or an aqueous solution of an organic alkali agent, for example, monoethanolamine or diethanolamine. The alkali agent is added so as to form an alkali solution having the concentration from 0.1 to 10% by weight, preferably from 0.5 to 5% by weight.

The aqueous alkaline solution may contain a small amount of a surfactant or an organic solvent, for example, benzyl alcohol, 2-phenoxyethanol and 2-butoxyethanol, if desired. Examples thereof include those described in U.S. Patents 3,375,171 and 3,615,480.

Further, the developers described in JP-A-50-26601, JP-A-58-54341, JP-B-56-39464 and JP-B-56-42860 are also excellent.

As a particularly preferable developer, a developer containing a nonionic compound represented by formula (VI) shown below and having pH of 11.5 to 12.8 and conductivity of 3 to 30 mS/cm described in JP-A-2002-202616 is exemplified.

A - W (VI)

In formula (VI), A represents a hydrophobic organic group forming A - H having log P of 1.5 or more, and W represents a nonionic hydrophilic organic group forming W - H having log P of less than 1.0.

The term "log P" is ordinarily used as a hydrophobicity parameter which is described in C. Hansch and A Leo, Substituent Constants for Correlation Analysis in Chemistry and Biology, J. Wiley & Sons (1979). The log P is defined as a logarithm of an equilibrium concentration ratio P calculated from the proportion of objective molecules (A-H and W-H) distributed to each layer of an octanol/water two-layer system.

The log P value is used here as an index for specifying each organic group of A and W in formula (VI), and for the convenience's sake, assuming that an A-H or W-H structure is formed by bonding a hydrogen atom to each organic group A or W, the log P value is determined by calculation from known data according to the method described in A. K. Ghose, et al., J. Comput. Chem., 9, 80 (1988).

More specifically, regarding the structure, the organic groups represented by A and W are different from each other and represent monovalent organic residues satisfying the above described log P values, respectively. Preferably, A and W, which may be the same or different, each represents a hydrogen atom, a halogen atom, a hydrocarbon group which may have a substituent and/or an unsaturated bond, a heterocyclic group, a hydroxy group, a substituted oxy group, a mercapto group, a substituted thio group, an amino group, a substituted amino group, a substituted carbonyl group, a carboxylato group, a sulfo group, a sulfonato group, a substituted sulfinyl group, a substituted sulfonyl group, a phosphono group, a substituted phosphono group, a phosphonato group, a substituted phosphonato group, a cyano group or a nitro group.

The hydrocarbon group which may have a substituent and/or an unsaturated bond includes an alkyl group, a substituted alkyl group, an aryl group, a substituted aryl group, an alkenyl group, a substituted alkenyl group an alkynyl group and a substituted alkynyl group.

As the alkyl group and substituted alkyl group, those described for preferable specific examples of $R^1$, $R^2$ or $R^3$ hereinbefore are exemplified.

An alkyl group included in the substituents includes a straight-chain, branched or cyclic alkyl group having from 1 to 20 carbon atoms. Specific examples thereof include methyl, ethyl, propyl, butyl, pentyl, hexyl, heptyl, octyl, nonyl, decyl, undecyl, dodecyl, tridecyl, hexadecyl, octadecyl, eicosyl, isopropyl, isobutyl, sec-butyl, tert-butyl, isopentyl, neopentyl, 1-methylbutyl, isohexyl, 2-ethylhexyl, 2-methylhexyl, cyclohexyl, cyclopentyl and 2-norbornyl groups. Of the alkyl groups, a straight-chain alkyl group having from 1 to 12 carbon atoms, a branched alkyl group having from 3 to 12 carbon atoms and a cyclic alkyl group having from 5 to 10 carbon atoms are preferred.

Specific examples of the aryl group include phenyl, biphenyl, naphthyl, tolyl, xylyl, mesityl, cumenyl, fluorophenyl, chlorophenyl, bromophenyl, chloromethylphenyl, hydroxyphenyl, methoxyphenyl, ethoxyphenyl, phenoxypnenyl, acetoxyphenyl, benzoyloxyphenyl, methylthiophenyl, phenylthiophenyl, methylaminophenyl, dimethylaminophenyl, acetylaminophenyl, carboxyphenyl, methoxycarbonylphenyl, ethoxycarbonylphenyl, phenoxycarbonylphenyl, N-phenylcarbamoylphenyl, phenyl, nitrophenyl, cyanophenyl, sulfophenyl, sufonatophenyl, phosphonophenyl and phosphonatophenyl groups.

Specific examples of the alkenyl group include vinyl, 1-propenyl, 1-butenyl, cinnamyl and 2-chloro-1-ethenyl groups. Specific examples of the alkynyl group include ethynyl, 1-propynyl, 1-butynyl, trimethylsilylethynyl and phenylethynyl groups.

In the acyl group ($R^4CO$-) described above, $R^4$ represents a hydrogen atom, or the above-described alkyl, aryl, alkenyl or alkynyl group.

In the substituted alkyl group, an alkylene group includes a divalent organic residue obtained by eliminating any one of hydrogen atoms on the alkyl group having from 1 to 20 carbon atoms described above, and preferably a straight-chain alkylene group having from 1 to 12 carbon atoms, a branched alkylene group having from 3 to 12 carbon atoms and a cyclic alkylene group having from 5 to 10 carbon atoms. Specific preferred examples of the substituted alkyl group include chloromethyl, bromomethyl, 2-chloroethyl, trifluoromethyl, methoxymethyl, methoxyethoxyethyl, allyloxymethyl, phenoxymethyl, methyltiomethyl, tolylthiomethyl, ethylaminoethyl, diethylaminopropyl, morpholinopropyl, acetyloxymethyl, benzoyloxymethyl, N-cyclohexylcarbamoyloxyethyl, N-phenylcarbamoyloxyethyl, acetylaminoethyl, N-methylbenzoylaminopropyl, 2-oxoethyl, 2-oxopropyl, carboxypropyl, methoxycarbonylethyl, methoxycarbonylmethyl, methoxycarbonylbutyl, ethoxycarbonylmethyl, butoxycarbonylmethyl, allyloxycarbonylmethyl, benzyloxycarbonylmethyl, methoxycarbonylphenylmethyl, trichloromethylcarbonylmethyl, allyloxycarbonylbutyl, chlorophenoxycarbonylmethyl, carbamoylmethyl, N-methylcarbamoylethyl, N,N-dipropylcarbamoylmethyl, N-(methoxyphenyl)carbamoylethyl, N-methyl-N-(sulfophenyl)carbamoylmethyl, sulfopropyl,sulfobutyl, sulfonatobutyl, sulfamoylbutyl, N-ethylsulfamoylmethyl, N,N-dipropylsulfamoylpropyl, N-tolylsulfamoylpropyl, N-methyl-N-(phosphonophenyl)sulfamoyloctyl, phosphonobutyl, phosphonatohexyl, diethylphosphonobutyl, diphenylphosphonopropyl, methylphosphonobutyl, methylphosphonatobutyl, tolylphosphonohexyl, tolylphosphonatohexyl, phosphonoxypropyl, phosphonatoxybutyl, benzyl, phenethyl, α-methylbenzyl, 1-methyl-1-phenylethyl, p-methylbenzyl, cinnamyl, allyl, 1-propenylmethyl, 2-butenyl, 2-methylallyl, 2-methylpropenylmethyl, 2-propynyl, 2-butynyl and 3-butynyl groups and functional groups shown below.

$CH_3CONHSO_2(CH_2)_4$-

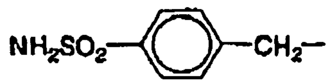

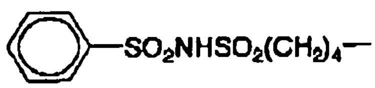

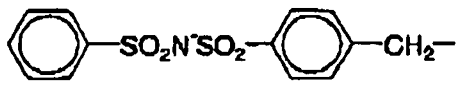

HS-$(CH_2)_4$-

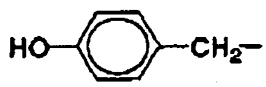

The aryl group includes a condensed ring of one to three benzene rings and a condensed ring of a benzene ring and a 5-membered unsaturated ring. Specific examples of the aryl group include phenyl, naphthyl, anthryl, phenanthryl, indenyl, acenaphthenyl and fluorenyl groups. A phenyl group and a naphthyl group are preferred.

The substituted aryl group includes groups having a monovalent non-metallic atomic group, as a substituent, on the ring-forming carbon atom of the above-described aryl group. Examples of the substituent include the above-described alkyl and substituted alkyl group and the substituents for the substituted alkyl group.

Specific preferred examples of the substituted aryl group include biphenyl, tolyl, xylyl, mesityl, cumenyl, chlorophenyl, bromophenyl, fluorophenyl, chloromethylphenyl, trifluoromethylphenyl, hydroxyphenyl, methoxyphenyl, methoxyethoxyphenyl, allyloxyphenyl, phenoxyphenyl, methylthiophenyl, tolylthiophenyl, phenylthiophenyl, ethylaminophenyl, diethylaminophenyl, morpholinophenyl, acetyloxyphenyl, benzoyloxyphenyl, N-cyclohexylcarbamoyloxyphenyl, N-phenylcarbamoyloxyphenyl, acetylaminophenyl, N-methylbenzoylaminophenyl, carboxyphenyl, methoxycarbonylphenyl, allyloxycarbonylphenyl, chlorophenoxycarbonylphenyl, carbamoylphenyl, N-methylcarbamoylphenyl, N,N-dipropylcarbamoylphenyl, N-(methoxyphenyl)carbamoylphenyl, N-methyl-N-(sulfophenyl)carbamoylphenyl, sulfophenyl, sulfonatophenyl, sulfamoylphenyl, N-ethylsulfamoylphenyl, N,N-dipropylsulfamoylphenyl, N-tolylsulfamoylphenyl, N-methyl-N-(phosphonophenyl)sulfamoylphenyl, phosphonophenyl, phosphonatophenyl, diethylphosphonophenyl, diphenylphosphonophenyl, methylphosphonophenyl, methylphosphonatophenyl, tolylphosphonophenyl, tolylphosphonatophenyl, allylphenyl, 1-propenylmethylphenyl, 2-butenylphenyl, 2-methylallylphenyl, 2-methylpropenylphenyl, 2-propynylphenyl, 2-butynylphenyl and 3-butynylphenyl groups.

AS the alkenyl group, the alkenyl groups described with respect to the substituent capable of being introduced are exemplified. The substituted alkenyl group is a group formed by replacing a hydrogen atom of the alkenyl group with a substituent. Examples of the substituent include the substituents for the substituted alkyl group described above, and the alkenyl group is that described above. Preferred examples of the substituted alkenyl group include groups having structures shown below.

$CH_3OCOCH_2CH=CHCH_2$-

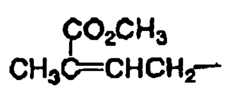

$HOCOCH_2CH=CHCH_2$-

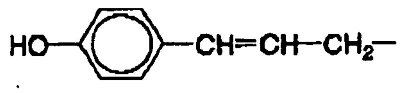

$CH_2$=CH-CH=CH-$CH_2$- Cl-$CH_2$CH=$CHCH_2$-

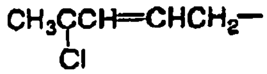

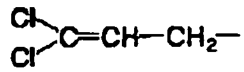

HS-$CH_2$CH=$CHCH_2$-

AS the alkynyl group, the alkynyl groups described with respect to the substituent capable of being introduced are exemplified. The substituted alkynyl group is a group formed by replacing a hydrogen atom of the alkynyl group with a substituent. Examples of the substituent include the substituents for the substituted alkyl group described above, and the alkynyl group is that described above.

The heterocyclic group includes a monovalent group formed by eliminating one hydrogen atom on the hetero ring and a monovalent group (a substituted heterocyclic group) formed by further eliminating one hydrogen atom from the above-described monovalent group and bonding a substituent selected from the substituents for the substituted alkyl group described above. Preferred examples of the hetero ring include hetero rings having structures shown below.

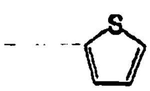

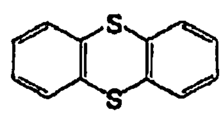

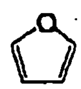

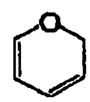

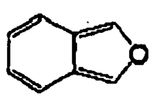

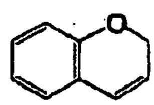

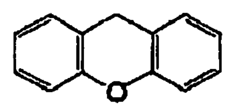

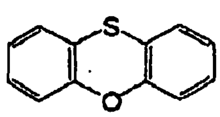

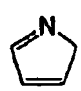

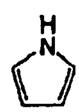

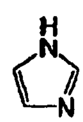

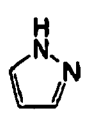

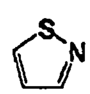

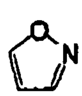

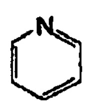

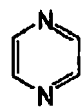
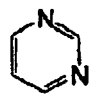
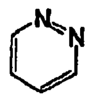
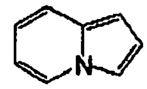

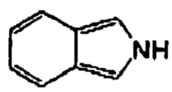
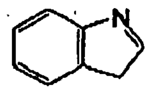
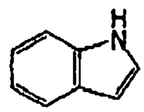
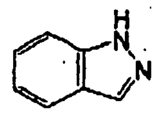

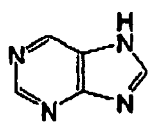
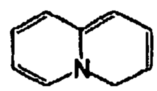
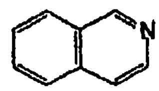
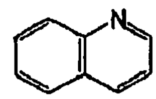

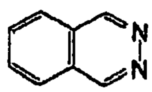
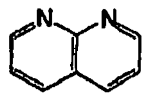
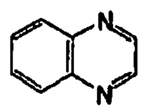
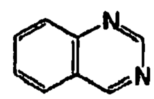

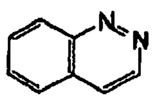
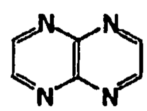
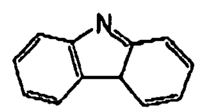

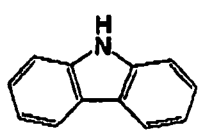
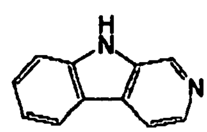
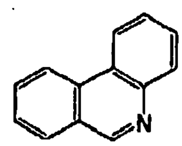

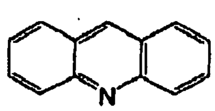
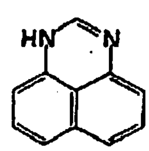
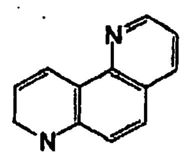

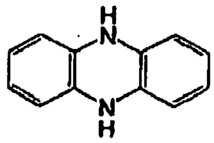 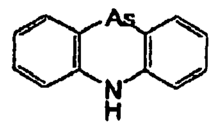 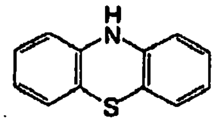

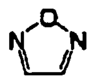 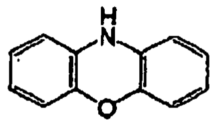 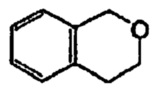

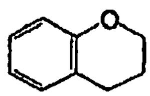 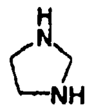 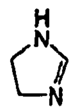 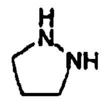

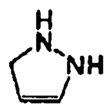 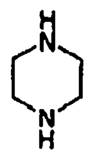 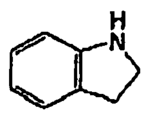 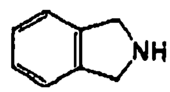

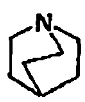 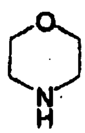 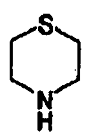 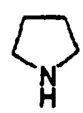

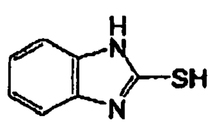 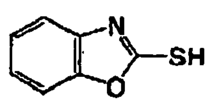 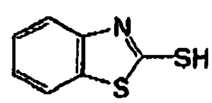

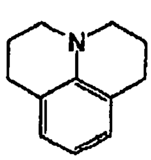 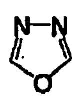 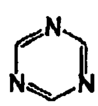 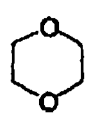

In the substituted oxy group ($R^5O$-), $R^5$ represents a monovalent non-metallic atomic group. Preferred examples of the substituted oxy group include an alkoxy group, an aryloxy group, an acyloxy group, a carbamoyloxy group, an N-alkylcarbamoyloxy group, an N-arylcarbamoyloxy group, an N,N-dialkylcarbamoyloxy group, an N,N-diarylcarbamoyloxy

group, an N-alkyl-N-arylcarbamoyloxy group, an alkylsulfoxy group, an arylsulfoxy group, a phosphonoxy group and a phosphonatoxy group. The alkyl group and aryl group in the above-described substituted oxy group include those described for the alkyl group, substituted alkyl group, aryl group and substituted aryl group above.

In an acyl group ($R^6CO$-) in the acyloxy group, $R^6$ represents the alkyl group, substituted alkyl group, aryl group or substituted aryl group described above. Of the substituted oxy groups, an alkoxy group, an aryloxy group, an acyloxy group and an arylsulfoxy group are more preferred. Specific preferred examples of the substituted oxy group include methoxy, ethoxy, propyloxy, isopropyloxy, butyloxy, pentyloxy, hexyloxy, dodecyloxy, benzyloxy, allyloxy, phenethyloxy, carboxyethyloxy, methoxycarbonylethyloxy, ethoxycarbonylethyloxy, methoxyethoxy, phenoxyethoxy, methoxyethoxyethoxy, ethoxyethoxyethoxy, morpholinoethoxy, morpholinopropyloxy, allyloxyethoxyethoxy, phenoxy, tolyloxy, xylyloxy, mesityloxy, cumenyloxy, methoxyphenyloxy, ethoxyphenyloxy, chlorophenyloxy, bromophenyloxy, acetyloxy, benzoyloxy, naphthyloxy, phenylsulfonyloxy, phosphonoxy and phosphonatoxy groups.

In the substituted thio group ($R^7S$-), $R^7$ represents a monovalent non-metallic atomic group. Preferred examples of the substituted thio group include an alkylthio group, an arylthio group, an alkyldithio group, an aryldithio group and an acylthio group. The alkyl group and aryl group in the above-described substituted thio group include those described for the alkyl group, substituted alkyl group, aryl group and substituted aryl group above. In an acyl group ($R^6CO$-) in the acylthio group described above, $R^6$ has the same meaning as described above. Of the substituted thio groups, an alkylthio group and an arylthio group are more preferred. Specific preferred examples of the substituted thio group include methylthio, ethylthio, phenylthio, ethoxyethylthio, carboxyethylthio and methoxycarbonylthio groups.

In the substituted amino group ($R^8NH$- or $(R^9)(R^{10})N$-), $R^8$, $R^9$ and $R^{10}$ each represents a monovalent non-metallic atomic group. Preferred examples of the substituted amino group include an N-alkylamino group, an N,N-dialkylamino group, an N-arylamino group, an N,N-diarylamino group, an N-alkyl-N-arylamino group, an acylamino group, an N-alkylacylamino group, an N-arylacylamino group, a ureido group, an N'-alkylureido group, an N',N'-dialkylureido group, an N'-arylureido group, an N',N'-diarylureido group, an N'-alkyl-N'-arylureido group, an N-alkylureido group, an N'-arylureido group, an N'-alkyl-N-alkylureido group, an N'-alkyl-N-arylureido group, an N',N'-dialkyl-N-alkylureido group, an N',N'-dialkyl-N-arylureldo group, an N'-aryl-N-alkylureido group, an N'-aryl-N-arylureido group, an N', N'-diaryl-N-alkylureido group, an N',N'-diaryl-N-arylureido group, an N'-alkyl-N'-aryl-N-alkylureido group, an N'-alkyl-N'-aryl-N-arylureido group, an alkoxycarbonylamino group, an aryloxycarbonylamino group, an N-alkyl-N-alkoxycarbonylamino group, an N-alkyl-N-aryloxycarbonylamino group, an N-aryl-N- alkoxycarbonylamino group and an N-aryl-N-aryloxycarbonylamino group.

The alkyl group and aryl group in the above-described substituted amino group include those described for the alkyl group, substituted alkyl group, aryl group and substituted aryl group above. In an acyl group ($R^6CO$-) in the acylamino group, N-alkylacylamino group or N-arylacylamino group described above, $R^6$ has the same meaning as described above. Of the substituted amino groups, an N-alkylamino group, an N,N-dialkylamino group, an N-arylamino group and an acylamino group are more preferred. Specific preferred examples of the substituted amino group include methylamino, ethylamino, diethylamino, morpholino, piperidino, pyrrolidino, phenylamino, benzoylamino and acetylamino groups.

In the substituted carbonyl group ($R^{11}$-CO-), $R^{11}$ represents a hydrogen atom or a monovalent non-metallic atomic group. Preferred examples of the substituted carbonyl group include a formyl group, an acyl group, a carboxy group, an alkoxycarbonyl group, an aryloxycarbonyl group, a carbamoyl group, an N-alkylcarbamoyl group, an N,N-dialkylcarbamoyl group, an N-arylcarbamoyl group, an N,N-diarylcarbamoyl group and an N-alkyl-N-arylcarbamoyl group. The alkyl group and aryl group in the above-described substituted carbonyl group include those described for the alkyl group, substituted alkyl group, aryl group and substituted aryl group above. Of the substituted carbonyl groups, a formyl group, an acyl group, a carboxy group, an alkoxycarbonyl group, an aryloxycarbonyl group, a carbamoyl group, an N-alkylcarbamoyl group, an N,N-dialkylcarbamoyl group and an N-arylcarbamoyl group are more preferred, and a formyl group, an acyl group, an alkoxycarbonyl group and an aryloxycarbonyl group are still more preferred. Specific preferred examples of the substituted carbonyl group include formyl, acetyl, benzoyl, carboxy, methoxycarbonyl, allyloxycarbonyl, N-methylcarbamoyl, N-phenylcarbamoyl, N,N-diethylcarbamoyl and morpholinocarbonyl groups.

In the substituted sulfinyl group ($R^{12}$-SO-), $R^{12}$ represents a monovalent non-metallic atomic group. Preferred examples of the substituted sulfinyl group include an alkylsulfinyl group, an arylsulfinyl group, a sulfinamoyl group, an N-alkyl sulfinamoyl group, an N,N-dialkylsulfinamoyl group, an N-arylsulfinamoyl group, an N,N-diarylsulfinamoyl group and an N-alkyl-N-arylsulfinamoyl group. The alkyl group and aryl group in the above-described substituted sulfinyl group include those described for the alkyl group, substituted alkyl group, aryl group and substituted aryl group above. Of the substituted sulfinyl groups, an alkylsulfinyl group and an arylsulfinyl group are more preferred. Specific examples of the substituted sulfinyl group include hexylsulfinyl, benzylsulfinyl and tolylsulfinyl groups.

In the substituted sulfonyl group ($R^{13}$-$SO_2$-), $R^{13}$ represents a monovalent non-metallic atomic group. Preferred examples of the substituted sulfonyl group include an alkylsulfonyl group and an arylsulfonyl group. The alkyl group and aryl group in the above-described substituted sulfonyl group include those described for the alkyl group, substituted alkyl group, aryl group and substituted aryl group above. Specific examples of the substituted sulfonyl group include

butylsulfonyl and chlorophenylsulfonyl groups.

The sulfonato group ($-SO_3^-$) means a conjugate base anion, group of a sulfo group ($-SO_3H$) as described above. Ordinarily, it is preferred to use together with a counter cation. Examples of the counter cation include those conventionally known, for example, various oniums (e.g., ammonium, sulfonium, phosphonium iodonium or azinium) and metal ions (e.g., $Na^+$, $K^+$, $Ca^{2+}$ or $Zn^{2+}$).

The calboxylato group ($-CO_2^-$) means a conjugate base anion group of a carboxy group ($-CO_2H$) as described above. Ordinarily, it is preferred to use together with a counter cation. Examples of the counter cation include those conventionally known, for example, various oniums (e.g., ammonium, sulfoniuin, phosphonium iodonium or azinium) and metal ions (e.g., $Na^+$, $K^+$, $Ca^{2+}$ or $Zn^{2+}$).

The substituted phosphono group means a group formed by substituting one or two hydroxy groups of a phosphono group with one or two other organic oxy groups. Preferred examples of the substituted phosphono group include a dialkylphosphono group, a diarylphosphono group, an alkylarylphosphono group, a monoalkylphosphono group and a monoarylphosphono group as described above. Of the substituted phosphono groups, a dialkylphosphono group and a diarylphosphono group are more preferred. Specific examples of the substituted phosphono group include diethylphosphono, dibutylphosphono and diphenylphosphono groups.

The phosphonato group ($-PO_3^{2-}$ or $-PO_3H^-$) means a conjugate base anion group of a phosphono group ($-PO_3H_2$) resulting from primary acid dissociation or secondary acid dissociation as described above. Ordinarily, it is preferred to use together with a counter cation. Examples of the counter cation include those conventionally known, for example, various oniums (e.g., ammonium, sulfonium, phosphonium iodonium or azinium) and metal ions (e.g., $Na^+$, $K^+$, $Ca^{2+}$ or $Zn^{2+}$).

The substituted phosphonato group means a conjugate base anion group of a group formed by substituting one hydroxy group of the phosphonato group with another organic oxy group. Specific examples of the substituted phosphonato group include a conjugate base group of a monoalkylphosphono group ($-PO_3H(alkyl)$) and a conjugate base group of a monoarylphosphono group ($-PO_3H(aryl)$). Ordinarily, it is preferred to use together with a counter cation. Examples of the counter cation include those conventionally known, for example, various oniums (e.g., ammonium, sulfonium, phosphonium iodonium or azinium) and metal ions (e.g., $Na^+$, $K^+$, $Ca^{2+}$ or $Zn^{2+}$).

In formula (VI) described above, as for preferred examples of the structures represented by A and W, A is an organic group having an aromatic group and W is a nonionic organic group having a polyoxyalkylene group.

In order to more clarify the structures represented by A and W, specific examples of the compounds represented by A - H and W - H are set forth below, respectively.

[Examples of the compound represented by A - H]

① 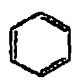 logP = 2.05

② 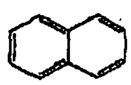 3.05

③ 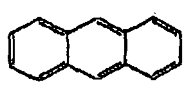 4.05

④ 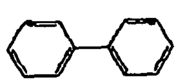 3.73

⑤ 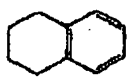 3.27

⑥ 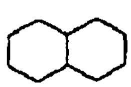 3.33

(continued)

| | | |
|---|---|---|
| ⑦ | 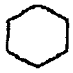 | 2.38 |
| ⑧ | Straight-chain or branched $C_nH_{2n+2}$ (n: integer of 4 or more) | 2.09 (in case of butane) |
| ⑨ | Straight-chain or branched $C_nH_{2n}$ (n: integer of 4 or more) | |
| ⑩ | Straight-chain or branched $C_nH_{2n-2}$ (n: integer of 4 or more) | |

Further, in the structures I to 10, the hydrogen atom may be substituted with the substituent for the hydrocarbon group described above.

[Examples of the compound represented by W - H]

① $HO-(CH_2CH_2O)_n-H$ (n: integer of 1 or more)

logP { -0. 71 (n=1), -1. 37 (n=5)
-2. 19 (n=10), -3. 02 (n=15), -2. 69 (n=13)

② 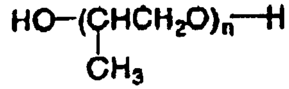 (n: integer of 1 or more)

(-0. 30 (n=1), 0. 70 (n-51)) 0. 95 (n=6)

③ $HO-(CH_2CH_2O)_n-$ 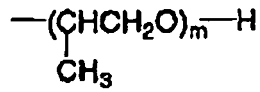 (n: integer of 1 or more, m: integer of 1 or more)

④ $HS-(CH_2CH_2O)_n-H$ (n: integer of 1 or more)

⑤ $HO-(CH_2CH_2CH_2O)_n-H$ (n: integer of 1 or more)

⑥ $HO-(CH_2CH_2NH)_n-H$ (n: integer of 1 or more)

⑦ $H_2N-(CH_2CH_2NH)_n-H$ (n: integer of 1 or more)

⑧ 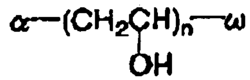 (n: integer of 1 or more)

⑨ 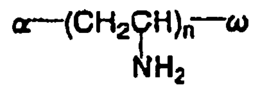 (n: integer of 1 or more)

⑩ 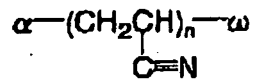 (n: integer of 1 or more)

⑪ 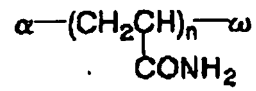 (n: integer of 1 or more)

⑫ 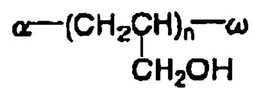 (n: integer of 1 or more)

⑬ 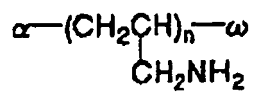 (n: integer of 1 or more)

(continued)

⑭ 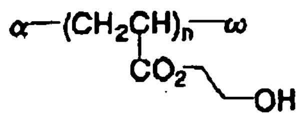

(n: integer of 1 or more)

In the above formulae, a and ω each represents -OH, -H, -SH or $-NH_2$.

Further, in the structures 1 to 14, the hydrogen atom may be substituted with the substituent for the hydrocarbon group described above.

Specific examples (Y-1 to Y-22) of the nonionic compound represented by formula (VI) are set forth below.

[A-W]

Y-1

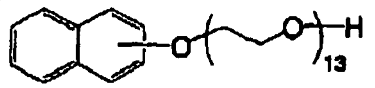

Y-2

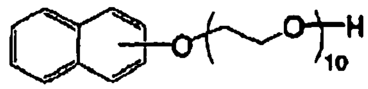

Y-3

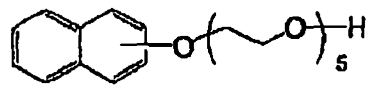

Y-4

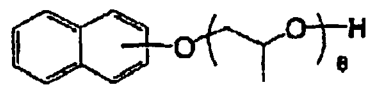

Y-5

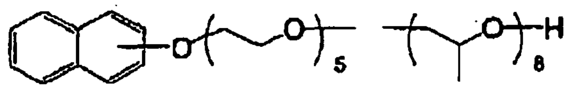

Y-6

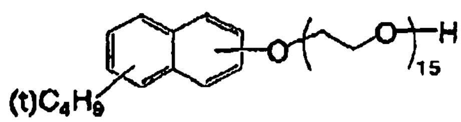

Y-7

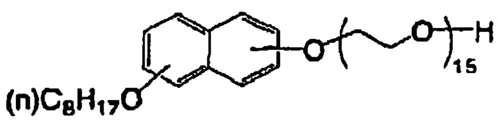

Y-8

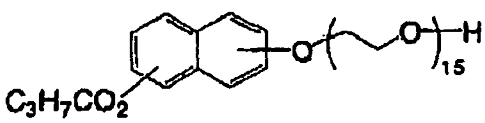

Y-9

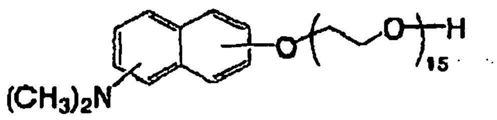

[A-W]

Y-10

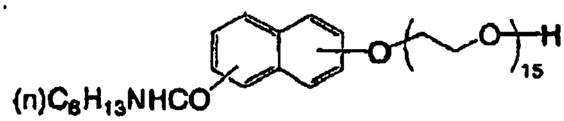

Y-11

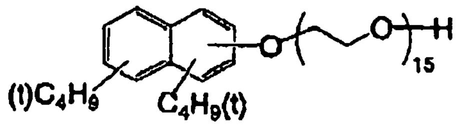

Y-12

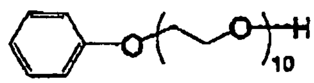

Y-13

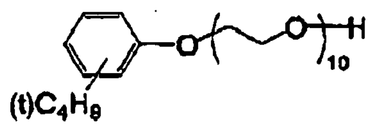

Y-14

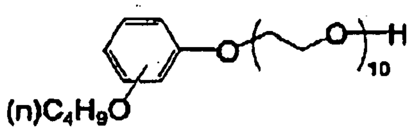

Y-15

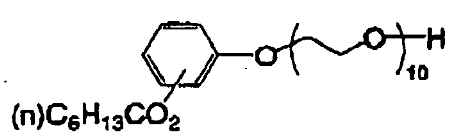

Y-16

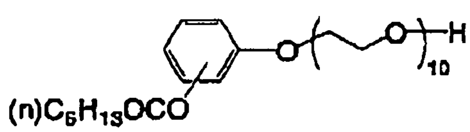

[A-W]

Y-17

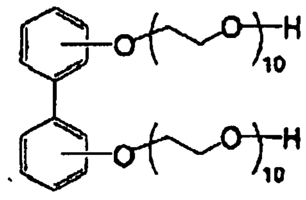

Y-18

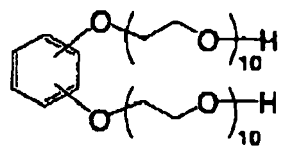

Y-19

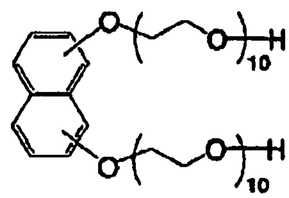

Y-20

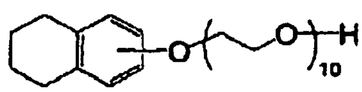

Y-21

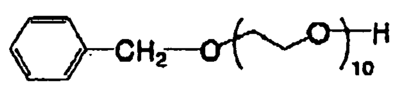

Y-22

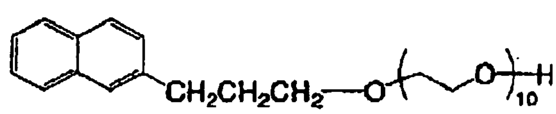

Of the nonionic compounds represented by formula (VI), compounds represented by formulae (I-A) and (I-B) shown below are more preferable.

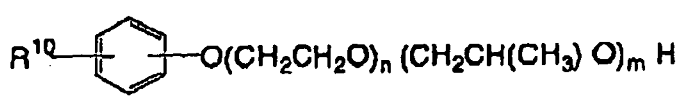

(I-A)

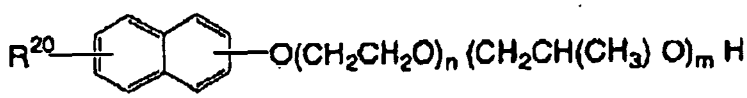

(I-B)

In formulae (I-A) and (I-B), $R^{10}$ and $R^{20}$ each represents a hydrogen atom or a hydrocarbon group having from 1 to 100 carbon atoms, and n and m each represents an integer of 0 to 100, provided that n and m are not 0 at the same time. The hydrocarbon group includes, for example, an alkyl group, an aryl group and an aralkyl group, and the hydrocarbon groups connecting via an ether bond, an ester bond or an amido bond.

Preferably, $R^{10}$ and $R^{20}$ each represents a hydrogen atom or a straight-chain or branched alkyl group having from 1 to 100 carbon atoms. Also, $R^{10}$ and $R^{20}$ each may represent $R^{30}$-X- (wherein $R^{30}$ represents a straight-chain or branched alkyl group having from 1 to 100 carbon atoms, and X represents -O-, -OCO-, -COO-, -NHCO- or -CONH-).

More preferably, $R^{10}$ and $R^{20}$ each represents a hydrogen atom, a straight-chain or branched alkyl group having from 1 to 10 carbon atoms or $R^{30}$-X- (wherein $R^{30}$ represents a straight-chain or branched alkyl group having from 1 to 10 carbon atoms, and X represents -O-, -OCO-, -COO-, -NHCO- or -CONH-).

Examples of the compound represented by formula (I-A) include polyoxyethylene phenyl ether, polyoxyethylene methylphenyl ether, polyoxyethylene octylphenyl ether and polyoxyethylene nonylphenyl ether.

Examples of the compound represented by formula (I-B) include polyoxyethylene naphthyl ether, polyoxyethylene methylnaphthyl ether, polyoxyethylene octylnaphthyl ether and polyoxyethylene nonylnaphthyl ether,

In the compounds represented by formulae (I-A) and (I-B), a number of the repeating unit ofpolyoxyethylene chain is preferably from 3 to 50, more preferably from 5 to 30, and a number of the repeating unit of polyoxypropylene chain is preferably from 0 to 10, more preferably from 0 to 5. The polyoxyethylene part and polyoxypropylene part may form a random copolymer or a block copolymer.

The nonionic aromatic ether surfactants represented by formulae (I-A) and (I-B) may be used individually or in combination of two or more thereof

According to the invention, it is effective to add the nonionic compound represented by formula (VI) to a developer in an amount ordinarily from 0.1 to 15% by weight, preferably from 1.0 to 8.0% by weight. When the amount added is too small, deterioration of the developing property and decrease in solubility of the photosensitive layer component may be incurred. On the other hand, when the amount added is too large, the printing durability of a printing plate may be decreased.

In a plate-making process of the lithographic printing plate precursor according to the invention, the entire surface of the lithographic printing plate precursor may be heated, if desired, before or during the exposure or between the exposure and the development. By the heating, the image-forming reaction in the photosensitive layer is accelerated and advantages, for example, improvement in the sensitivity and printing durability and stabilization of the sensitivity are achieved. For the purpose of increasing the image strength and printing durability, it is also effective to perform entire after-heating or entire exposure of the image after the development. Ordinarily, the heating before the development is preferably performed under a mild condition of 150˚C or lower. When the temperature is too high, a problem may arise in that undesirable hardening reaction in the non-image area arises. On the other hand, the heating after the development can be performed using a very strong condition. Ordinarily, the heat treatment is carried out in a temperature range of 200 to 500˚C. When the temperature is too low, a sufficient effect of strengthening the image may not be obtained, whereas when it is excessively high, problems of deterioration of the support and thermal decomposition of the image area may occur.

As for the exposure method of the lithographic printing plate precursor for scanning exposure according to the invention, known methods can be used without limitation. A wavelength of the light source used is preferably from 350 to 450 nm. Specifically, an InGaN semiconductor laser is preferably used. The exposure mechanism may be any of an internal drum system, an external drum system and a flat bed system. When the photosensitive layer composition according to the invention used has high water solubility, the photosensitive layer can be made soluble in neutral water or alkalescent water, and the lithographic printing plate precursor having such a construction can also be applied to a system wherein it is loaded on a printing machine and then subjected to exposure and development on the printing machine.

As the available laser light source of 350 to 450 nm, the followings can be employed.

A gas laser, for example, Ar ion laser (364 nm, 351 nm, 10 mW to 1 W), Kr ion laser (356 nm, 351 nm, 10 mW to 1 W) and He-Cd laser (441 nm, 325 nm, 1 mW to 100 mW); a solid laser, for example, a combination of Nd:YAG ($YVO_4$) with SHG crystalsxtwice (355 nm, 5 mW to 1 W) and a combination of Cr:LiSAF with SHG crystal (430 nm, 10 mW); a semiconductor laser system, for example, a $KNBOb_3$ ring resonator (430 nm, 30 mW), a combination of a waveguide-type wavelength conversion element with an AlGaAs or InGaAs semiconductor (380 nm to 450 nm, 5 mW-100 mW), a combination of a waveguide-type wavelength conversion element with an AlGaInP or AlGaAs semiconductor (300 nm to 350 nm, 5 mW to 100 mW), and AlGaInN (350 nm to 450 nm, 5 mW to 30 mW); a pulse laser, for example, $N_2$ laser (337 nm, pulse 0.1 to 10 mJ) and XeF (351 nm, pulse 10-250 mJ) can be used.

Among the light sources, the AlGaInN semiconductor laser (commercially available InGaN semiconductor laser, 400 to 410 nm, 5 to 30 mW) is particularly preferable in view of the wavelength characteristics and cost.

As for the exposure apparatus for the lithographic printing plate precursor of scanning exposure system, the exposure mechanism includes an internal drum system, an external drum system and a flat bed system. As the light source, all light sources described above other than the pulse laser can be utilized. In practice, the following exposure apparatuses are particularly preferred in view of the relationship between the sensitivity of photosensitive material and the time for plate-making.

· A single-beam exposure apparatus of internal drum system using one gas laser or solid laser light source
· A multi-beam exposure apparatus of flat bed system using many (10 or more) semiconductor light sources
· A multi-beam exposure apparatus of external drum system using many (10 or more) semiconductor light sources

In the laser direct drawing-type lithographic printing plate precursor, the following equation (eq 1) is ordinarily established among the sensitivity X (J/cm$^2$) of photosensitive material, the exposure area S (cm$^2$) of photosensitive material, the power q (W) of one laser light source, the number n of lasers and the total exposure time t (s):

$$X \cdot S = n \cdot q \cdot t \qquad \text{(eq 1)}$$

i) In the case of the internal drum (single beam) system, the following equation (eq 2) is ordinarily established among the laser revolution number f (radian/s), the sub-scanning length Lx (cm) of photosensitive material, the resolution Z (dot/cm) and the total exposure time t (s):

$$f \cdot Z \cdot t = Lx \qquad \text{(eq 2)}$$

ii) In the case of the external drum (multi-beam) system, the following equation (eq 3) is ordinarily established among the drum revolution number F (radian/s), the sub-scanning length Lx (cm) of photosensitive material, the resolution Z (dot/cm), the total exposure time t (s) and the number (n) of beams:

$$F \cdot Z \cdot n \cdot t = Lx \qquad \text{(eq 3)}$$

iii) In the case of the flat bed (multi-beam) system, the following equation (eq 4) is ordinarily established among the revolution number H (radian/s) of polygon mirror, the sub-scanning length Lx (cm) of photosensitive material, the resolution Z (dot/cm), the total exposure time t (s) and the number (n) of beams:

$$H \cdot Z \cdot n \cdot t = Lx \qquad \text{(eq 4)}$$

When the resolution (2,560 dpi) required for a practical printing plate, the plate size (A1/B1, sub-scanning length: 42 inch), the exposure condition of about 20 sheets/hour and the photosensitive characteristics (photosensitive wavelength, sensitivity: about 0.1 mJ/cm$^2$) of the photosensitive composition of the invention are substituted for the above equations, it can be understood that a photosensitive material using the photosensitive composition of the invention is preferably combined with a multi-beam exposure system using a semiconductor laser, and on taking account of operability, cost and the like, most preferably combined with a semiconductor laser multi-beam exposure apparatus of an external drum system.

Examples of other light source for use in the exposure of the photosensitive composition according to the invention include an ultra-high pressure mercury lamp, a high pressure mercury lamp, a medium pressure mercury lamp, a low pressure mercury lamp, a chemical lamp, a carbon arc lamp, a xenon lamp, a metal halide lamp, various visible or ultraviolet laser lamps, a fluorescent lamp, a tungsten lamp and sunlight.

As to the use of the photosensitive composition according to the invention, it can be applied not only to the photosensitive layer of lithographic printing plate precursor for scanning exposure described in detail above but also to

the uses over a wide range known as those of photo-curable resin without limitation. For instance, when it is applied to a liquid photosensitive composition using a cationic polymerizable compound in combination, if desired, a highly sensitive material for photo-modeling can be obtained. A hologram material may also be prepared by utilizing change in the refraction index accompanied with the photopolymerization. The photosensitive composition of the invention can also be applied to various transfer materials (for example, a peelable photosensitive material or a toner development photosensitive material) by using change in the adhesive property on the surface accompanied with the photopolymerization, to photo-curing of microcapsules, to the production of an electronic material, for example, photoresist, and to a photo-curable resin material, for example, ink, paint and adhesive.

## EXAMPLES

The present invention will be described in more detail with reference to the following examples, but the invention should not be construed as being limited thereto.

<Synthesis Example>

Synthesis of Compound101

In 10 ml of methanol were dissolved 0.4 g of 4-dimethylaminobenzaldehyde and 0.7 g of 2-diphenylamino-5-thiazolidinone, and to the solution was added 0.5 ml of sodium methoxide (28% methanol solution), followed by reacting at room temperature for 3 hours. After the completion of the reaction, the crystals thus-deposited were collected by filtration, washed with methanol while stirring, filtered and dried to obtain 0.8 g (yield: 77%) of Compound 101.

Mass spectrum 400($MH^+$)

$^1H$ NMR($CDCl_3$) d 3.00(s, 6H), 6.66(d, J=8.8Hz, 2H), 7.20-7.55 (br, 12H), 7.33 (d, J=8.8Hz, 2H), 7.78 (s, 1H)

Other compounds according to the invention used in Examples were also synthesized in the same manner as above.

<Examples 1 to 13 and Comparative Examples 1 to 4>

(Preparation of support)

A 0.3 mm-thick aluminum plate was etched by immersing the plate in a 10% by weight aqueous sodium hydroxide solution at 60˚C for 25 seconds, washed with running water, neutralized and cleaned with a 20% by weight aqueous nitric acid solution and then washed with water. The aluminum plate was then subjected to an electrolytic surface roughening treatment in a 1 % by weight aqueous nitric acid solution using an alternating current with a sinusoidal waveform at an anode time electricity of 300 coulomb/$dm^2$. Subsequently, the aluminum plate was immersed in a 1% by weight aqueous sodium hydroxide solution at 40˚C for 5 seconds, immersed in a 30% by weight aqueous sulfuric acid solution at 60˚C for 40 seconds to effect a desmut treatment, and then subjected to an anodizing treatment in a 20% by weight aqueous sulfuric acid solution for 2 minutes at a current density of 2 A/$dm^2$ to form an anodic oxide film having a thickness of 2.7 g/$m^2$. The surface roughness of the aluminum plate thus-treated was measured and found to be 0.3 $\mu$m (Ra value according to JIS B0601).

On the back surface of the aluminum plate, a coating solution for backcoat layer shown below was coated by a bar coater and dried at 100˚C for 1 minute, thereby preparing an aluminum support having provided thereon a backcoat layer having a coating amount after drying of 70 mg/$m^2$.

| Sol-Gel Reaction Solution | |
|---|---|
| Tetraethyl silicate | 50 parts by weight |
| Water | 20 parts by weight |
| Methanol | 15 parts by weight |
| Phosphoric acid | 0.05 parts by weight |

The above components were mixed and stirred, and heat generation was started within about 5 minutes. After the mixture was reacted for 60 minutes, a solution having the composition shown below was added thereto to prepare the coating solution for backcoat layer.

| | |
|---|---|
| Pyrogallol formaldehyde condensed resin (molecular weight: 2,000) | 4 parts by weight |

(continued)

| | |
|---|---|
| Dimethyl phthalate | 5 parts by weight |
| Fluorine-based surfactant | 0.7 parts by weight |
| (N-butylperfluorooctane- sulfonamidoethyl acrylate/ polyoxyethylene acrylate copolymer, molecular weight: 20,000) | |
| Methanol silica sol (produced by Nissan Chemical Industries, Ltd., methanol 30% by weight) | 50 parts by weight |
| Methanol | 800 parts by weight |

(Formation of photosensitive layer)

On the aluminum support provided with the backcoat layer, a photosensitive composition having the constituents shown below was coated to have a dry coating amount of 1.6 g/$m^2$ and dried at 80˚C for 2 minutes to form a photosensitive layer.

| Photosensitive Composition | |
|---|---|
| Pentaerythritol tetraacrylate | 1-5 g |
| Allyl methacrylate/methacrylic acid/N-isopropylacrylamide copolymer (copolymerization molar ratio: 70/12/18) | 2.0 g |
| Photopolymerization initiation system (shown in Table 1) | shown in Table 1 |
| Sensitizing dye | X g |
| Initiator compound | Y g |
| Co-sensitizer | Z g |
| Fluorine-based nonionic surfactant (F-177P) | 0.03 g |
| Thermal polymerization inhibitor (N-nitrosophenylhydroxylamine aluminum salt) | 0.01 g |
| Methyl ethyl ketone | 20 g |
| Propylene glycol monomethyl ether | 20 g |
| Pigment dispersion | 2.0 g |

| Composition of Pigment Dispersion | |
|---|---|
| Pigment Blue 15:6 | 15 parts by weight |
| Allyl methacrylate/methacrylic acid copolymer (copolymerization molar ratio: 83/17) | 10 parts by weight |
| Cyclohexanone | 15 parts by weight |
| Methoxypropyl acetate | 20 parts by weight |
| Propylene glycol monomethyl ether | 40 parts by weight |

(Formation of protective layer)

On the photosensitive layer, an aqueous solution containing 3% by weight of polyvinyl alcohol (saponification degree: 98% by mole; polymerization degree: 550) was coated to have a dry coating weight of 2 g/$m^2$ and dried at 100˚C for 2 minutes to form a protective layer, thereby preparing a lithographic printing plate precursor.

[Evaluation of Sensitivity]

A Fuji Step Guide (a gray scale discontinuously changing in the transmission optical density at $\Delta D = 0.15$, produced by Fuji Photo Film Co., Ltd.) was brought into close contact with the lithographic printing plate precursor thus-obtained, and exposure was performed using a xenon lamp through an optical filter in a known exposure energy amount. For the purpose of estimating the exposure aptitude for a short wavelength semiconductor laser, KENKO BP-40 was used as the optical filter to perform the exposure with monochromic light of 400 nm.

Thereafter, development was performed by immersing the exposed lithographic printing plate precursor in a developer having the composition shown below at 25˚C for 10 seconds, and the sensitivity (unit: mJ/$cm^2$) was calculated from the exposure energy value at the highest step number where the image was completely removed. As the exposure

energy value is smaller, the sensitivity is higher. The results are shown in Table 1.

| Developer | |
|---|---|
| Aqueous solution of pH 12.0 having the following composition: | |
| Potassium hydroxide | 0.2 g |
| 1K Potassium silicate ($SiO_2/K_2O$= 1.9) | 2.4 g |
| Compound shown below | 5.0 g |
| 4Na salt of ethylenediaminetetraacetate | 0.1 g |
| Water | 92.3 g |

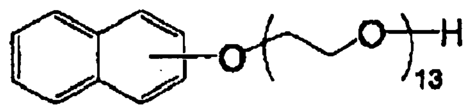

TABLE 1

| | Initiation System | | | Coating Amount ($g/m^2$) | Clear Sensitivity ($mJ/cm^2$) |
|---|---|---|---|---|---|
| | Sensitizing Dye (X g) | Initiator Compound (Y g) | Co-Sensitizer (Z g) | | |
| Example 1 | 1 (0.08) | A-1 (0.10) | C-1 (0.2) | 1.6 | 0.47 |
| Example 2 | 1 (0.08) | A-2 (0.15) | C-2 (0.2) | 1.6 | 0.49 |
| Example 3 | 1 (0.08) | A-3 (0.08) | None | 1.6 | 0.50 |
| Example 4 | 1 (0.08) | A-4 (0.08) | C-3 (0.2) | 1.6 | 0.48 |
| Example 5 | 1 (0.08) | A-10 (0.10) | None | 1.6 | 0.46 |
| Example 6 | 1 (0.08) | A-5 (0.12) | C-1 (0.2) | 1.6 | 0.44 |
| Example 7 | 11 (0.08) | A-5 (0.12) | C-2 (0.2) | 1.6 | 0.43 |
| Example 8 | 15 (0.08) | A-5 (0.10) | C-1 (0.2) | 1.6 | 0.38 |
| Example 9 | 17 (0.08) | A-5 (0.10) | C-1 (0.2) | 1.6 | 0.37 |
| Example 10 | 20(0.08) | A-5 (0.10) | C-1 (0.2) | 1.6 | 0.38 |
| Example 11 | 32 (0.08) | A-5 (0.10) | C-1 (0.2) | 1.6 | 0.44 |
| Example 12 | 35 (0.08) | A-5 (0.10) | C-1 (0.2) | 1.6 | 0.42 |
| Example 13 | 36 (0.08) | A-5 (0.10) | C-1 (0.2) | 1.6 | 0.43 |
| Comparative Example 1 | DR-1 (0.08) | None | None | 1.6 | No image formed |
| Comparative Example 2 | None | A-1 (0.08) | None | 1.6 | No image formed |
| Comparative Example 3 | None | A-2 (0.10) | C-2 (0.5) | 1.6 | No image formed |
| Comparative Example 4 | DR-1 (0.08) | A-1 (0.10) | C-1 (0.2) | 1.6 | 1.90 |

The sensitizing dyes according to the invention used in the photopolymerization initiation system of Table 1

are those described as the specific examples hereinbefore. The structures of Initiator compounds (A-1) to (A-10) and Co-sensitizers (C-1) to (C-3) are shown below. Sensitizing dye (DR-1) used in the comparative examples having the structure shown below is a dye compound outside the scope of the invention. In the formulae below, Ts represents a tosyl group.

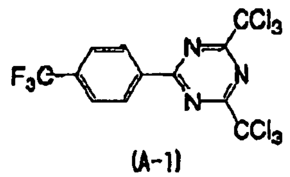

(A-1)

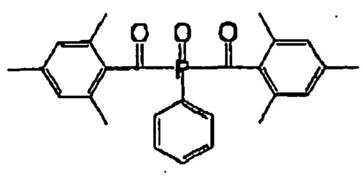

(A-2)

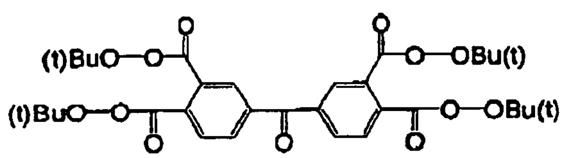

(A-3)

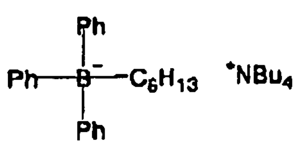

(A-4)

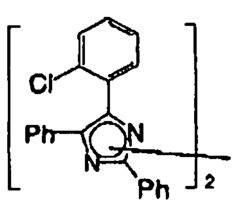

(A-5)

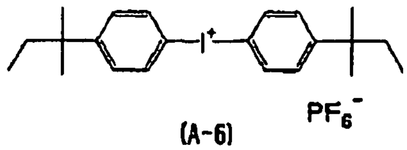

(A-6)

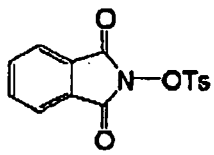

(A-7)

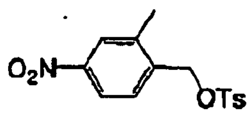

(A-8)

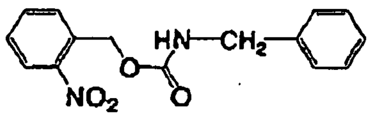

(A-9)

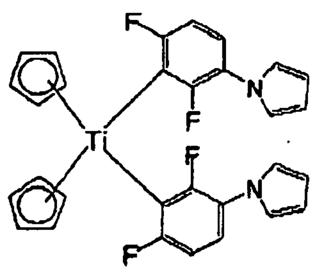

(A-10)

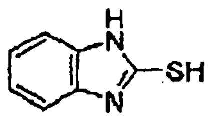

(C-1)

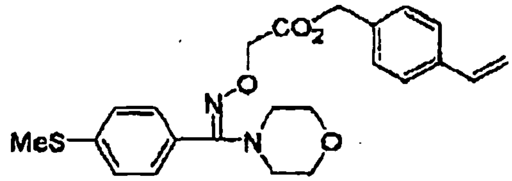

(C-2)

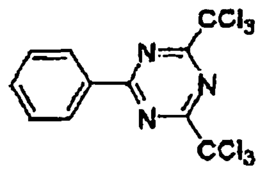

(C-3)

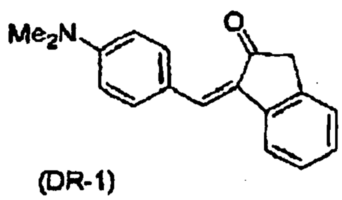

(DR-1)

From the results shown in Table 1, it can be seen that each of the lithographic printing plate precursors using the photosensitive composition according to the invention in the photosensitive layer thereof enables the image formation in high sensitivity, and the photo-initiation system exhibits the sensitivity sufficient for practical use. On the contrary, it is apparent that the image is not formed in Comparative Examples 1 to 3 wherein only the sensitizing dye is used or only the initiator compound is used and that in the lithographic printing plate precursor of Comparative Example 4 using the photo-initiation system in which the initiator compound is combined with the sensitizing dye outside the scope of the invention, the sensitivity sufficient for practical use can not be obtained. From the results of Examples 1 to 13, it can also be seen that the sensitizing dye according to the invention can be used together with the initiator compounds in the wide range irrespective of the sensitization mechanism to prepare the excellent photosensitive composition. Further, it is understood based on the comparison of Examples 6 to 13 with Comparative Example 4 that the structural feature that the sensitizing dye according to the invention exhibits high sensitivity is derived from the structure represented by formula (1) described above.

<Examples 14 to 25 and Comparative Example 5>

On the aluminum support used in each of Examples 1 to 13 were successively formed an inter layer, a photosensitive layer and a protective layer in the manner shown below to prepare a lithographic printing plate precursor.

(Coating of inter layer)

A coating solution for inter layer having the composition shown below was prepared, coated on the surface of the support using a whirler under the condition of 180 rpm so as to have the amount of phenylphosphonic acid coated of 20 mg/m$^2$ and dried at 80˚C for 30 seconds to prepare an inter layer.

| Coating Solution for Inter Layer | |
|---|---|
| Phenylphosphonic acid | 0.07 to 1.4 g |

(continued)

| Coating Solution for Inter Layer | |
|---|---|
| Methanol | 200 g |

(Formation of photosensitive layer)

A photosensitive composition having the composition shown below was coated on the inter layer using a whirler to have a coating amount of 1.6 g/$m^2$ and dried at 100°C for 1 minute to form a photosensitive layer.

| Photosensitive Composition | |
|---|---|
| Addition-polymerizable compound (compound shown in Table 2) | 1.6 g |
| Binder polymer (compound shown in Table 2) | 2.0 g |
| Sensitizing dye (compound shown in Table 2) | 0.15 g |
| Initiator compound (compound shown in Table 2) | 0.2 g |
| Co-sensitizer (compound shown in Table 2) | 0.3 g |
| Pigment dispersion shown below | 2.0 g |
| Thermal polymerization inhibitor (N-nitrosophenylhydroxylamine aluminum salt) | 0.01 g |
| Fluorine-based surfactant (Megafac F-177, produced by Dainippon Ink & Chemicals, Inc.) | 0.02 g |
| Methyl ethyl ketone | 20.0 g |
| Propylene glycol monomethyl ether | 20.0 g |

| Composition of Pigment Dispersion | |
|---|---|
| Pigment Blue 15:6 | 15 parts by weight |
| Allyl methacrylate/methacrylic acid copolymer (copolymerization molar ratio: 83/17) | 10 parts by weight |
| Cyclohexanone | 15 parts by weight |
| Methoxypropyl acetate | 20 parts by weight |
| Propylene glycol monomethyl ether | 40 parts by weight |

(Formation of protective layer)

On the photosensitive layer, an aqueous solution containing 3% by weight of polyvinyl alcohol (saponification degree: 98% by mole; polymerization degree: 550) was coated to have a dry coating weight of 2 g/$m^2$ and dried at 100°C for 2 minutes to form a protective layer, thereby preparing a lithographic printing plate precursor.

(Exposure of lithographic printing plate precursor)

The thus-obtained lithographic printing plate precursor was subjected to solid image exposure and halftone dot image exposure at 175 lines/inch increasing from 1 to 99% in 1% steps, using monochromatic light of 400 nm as a light source by adjusting the exposure power to give an exposure energy density of 200 $\mu$J/$cm^2$ on the surface of lithographic printing plate precursor.

(Development/Plate-making)

A developer (shown in Table 2) and Finisher FP-2W produced by Fuji Photo Film Co., Ltd. were charged into an automatic developing machine LP-850 produced by Fuji Photo Film Co., Ltd., and then the exposed lithographic printing plate precursor was subjected to development/plate-making under conditions of a developer temperature of 30°C and a development time of 18 seconds to obtain a lithographic printing plate.

(Printing durability test of image area)

Printing was conducted using R201 produced by Roland Co. as a printing machine and GEOS-G (N) produced by Dainippon Ink & Chemicals, Inc. as ink. While continuing the printing, the solid image area of the printed material

was observed and the printing durability was examined by a number of prints when the image started to become thin. As the numeral is larger, the printing durability is better.

(Printing durability test of halftone dot image area under forced condition)

Printing was conducted using R201 produced by Roland Co. as a printing machine and GEOS-G (N) produced by Dainippon Ink & Chemicals, Inc. as ink. After printing of 5,000 sheets, the ink on the plate surface was cleaned by wiping the halftone dot image area with a sponge for printing impregnated with PS Plate Cleaner CL-2 produced by Fuji Photo Film Co., Ltd. Thereafter, printing of 10,000 sheets was performed and the presence of cutting of halftone dots on the printed material was visually observed.

(Stain resistance test of non-image area)

Printing was conducted using R201 produced by Roland Co. as a printing machine and GEOS-G (S) produced by Dainippon Ink & Chemicals, Inc. as ink. The stain resistance was evaluated by observing the non-image area (unexposed area) of 30,000th printed material.

<Addition-polymerizable compounds described in Table 2>

(M-1) Pentaerythritol tetraacrylate (NK Ester A-TMMT, produced by Shin-Nakamura Chemical Co., Ltd.)
(M-2) Glycerin dimethacrylate hexamethylene diisocyanate urethane prepolymer (UA101H, produced by Kyoeisha Chemical Co., Ltd.)

<Binder polymers described in Table 2>

(B-1) Allyl metbacrylate/methacrylic acid/N-isopropylacrylamide (copolymerization molar ratio: 67/13/20)

Actual acid value measured by NaOH titration: 1.15 meq/g
Weight average molecular weight measured by GPC
measurement: $13 \times 10^4$

(B-2) Allyl methacrylate/methacrylic acid copolymer (copolymerization molar ratio 83/17)

Actual acid value measured by NaOH titration: 1.55 meq/g
Weight average molecular weight measured by GPC
measurement: $12.5 \times 10^4$

(B-3) Polyurethane resin of a condensation polymerization product of the following diisocyanates and diols

4,4'-Diphenylmethane diisocyanate (MDI)
Hexamethylene diisocyanate (HMDI)
Polypropylene glycol (weight average molecular weight: 1,000) (PPG 1000)
2,2-Bis(hydroxymethyl)propionic acid (DMPA)
Copolymerization molar ratio (MDI/HMDI/PPG 1000/DMPA= 40/10/15/35)
Actual acid value measured by NaOH titration: 1.05 mg/g
Weight average molecular weight measured by GPC
measurement: $4.5 \times 10^4$

<Developers described in Table 2>

(DV-1)

Aqueous solution of pH 10 having the following composition:

| | |
|---|---|
| Monoethanolamine | 0.1 part by weight |
| Triethanolamine | 1.5 parts by weight |
| Compound of Formula 1 shown below | 4.0 parts by weight |
| Compound of Formula 2 shown below | 2.5 parts by weight |
| Compound of Formula 3 shown below | 0.2 part by weight |
| Water | 91.7 parts by weight |

(DV-2)

Aqueous solution of pH 10 having the following composition:

| | |
|---|---|
| Sodium hydrogencarbonate | 1.2 parts by weight |
| Sodium carbonate | 0.8 parts by weight |
| Compound of Formula 1 shown below | 3.0 parts by weight |
| Compound of Formula 2 shown below | 2.0 parts by weight |
| Compound of Formula 3 shown below | 0.2 parts by weight |
| Water | 92.8 parts by weight |

(DV-3)

Developer of pH 12 used in Examples I to 13

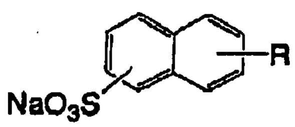

(Formula 1)

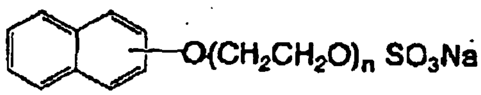

(Formula 2)

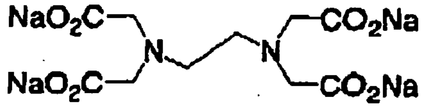

(Formula 3)

In the formulae above, R is H or $C_4H_9$ and n is about 4 (average value).

TABLE 2

| | Photosensitive Layer | | | | | | Developer | Printing Performance | | |
|---|---|---|---|---|---|---|---|---|---|---|
| | Addition-Polymerizable Compound | Binder Polymer | Sensitizing Dye | Initiator Compound | Co-Sensitizer | Coating Amount ($g/m^2$) | | Printing Durability of Image Area (sheets) | Printing Durability of Halftone Dot Image Area | Stain Resistance of Non-Image Area |
| Example 14 | M-1 | B-1 | 1 | A-5 | C-1 | 1.6 | DV-3 | 78,000 | Good | Good |
| Example 15 | M-1 | B-2 | 1 | A-5 | C-1 | 1.6 | DV-2 | 86,000 | Good | Good |
| Example 16 | M-2 | B-1 | 1 | A-10 | C-2 | 1.6 | DV-1 | 70,000 | Good | Good |
| Example 17 | M-2 | B-3 | 1 | A-10 | C-2 | 1.6 | DV-3 | 90,000 | Good | Good |
| Example 18 | M-1 | B-1 | 8 | A-5 | C-1 | 1.6 | DV-3 | 96,000 | Good | Good |
| Example 19 | M-1 | B-2 | 11 | A-5 | C-1 | 1.6 | DV-3 | 88,000 | Good | Good |
| Example 20 | M-2 | B-1 | 15 | A-5 | C-1 | 1.6 | DV-3 | 78,000 | Good | Good |
| Example 21 | M-2 | B-3 | 17 | A-5 | C-1 | 1.6 | DV-3 | 100,000 | Good | Good. |
| Example 22 | M-2 | B-3 | 20 | A-5 | C-1 | 1.6 | DV-3 | 98,000 | Good | Good |
| Example 23 | M-2 | B-3 | 32 | A-5 | C-1 | 1.6 | DV-3 | 92,000 | Good | Good |
| Example 24 | M-2 | B-3 | 35 | A-5 | C-1 | 1.6 | DV-3 | 95,000 | Good | Good |
| Example 25 | M-2 | B-3 | 36 | A-5 | C-1 | 1.6 | DV-3 | 94,000 | Good | Good |
| Comparative Example 5 | M-2 | B-3 | None | A-1 | C-2 | 1.6 | DV-3 | Blurred Image | Blurred Image | Good |

From the results shown in Table 2, it can be seen that each of the lithographic printing plate precursors using the photosensitive composition according to the invention in the photosensitive layer thereof in Examples 14 to 25 can provide an excellent lithographic printing plate even under conditions capable of plate-making by scanning exposure with high productivity, that is, under the exposure condition of extremely low energy. On the contrary, in the lithographic printing plate precursor of Comparative Example 5 in which the sensitizing dye according to the invention is not used, a lithographic printing plate suitable for practical use can not be obtained.

<Example 26>

A lithographic printing plate precursor of Example 26 was prepared in the same manner as in Example 1 except that the photo-initiation system of the photosensitive composition used in the photosensitive layer was changed to a photo-initiation system having the composition shown below and that the thickness of the photosensitive layer was changed to 1.5 g/m$^2$.

| Photo-Initiation System | |
|---|---|
| Sensitizing dye (Compound 1) | 0.1 g |
| Initiator compound (A-1) | 0.08 g |
| Co-sensitizer (C-1) | 0.2 g |

(Exposure/Development)

The thus-obtained lithographic printing plate precursor was subjected to scanning exposure using monochromatic light of 400 nm under condition of providing an exposure energy density of 0.25 mJ/cm$^2$. The exposed lithographic printing plate precursor was heated at 100˚C for 10 seconds and then subjected to the development processing in the same manner as in Example 1, As a result, a lithographic printing plate having a blue image excellent in visibility was obtained.

(Evaluation of lithographic printing plate)

The thus-obtained lithographic printing plate was subjected to offset printing using a printing machine (KOR-D, produced by Heidelberg). As a result, more than 50,000 sheets of printed materials having excellent image density and excellent image quality without occurrence of stain in the non-image area were obtained.

<Example 27>

The lithographic printing plate precursor described in Example 26 was allowed to stand under yellow light for 1 hour before the exposure and then subjected to the plate-making and printing in the same manner as in Example 26. Good results same as in Example 26 were obtained.

<Example 28>

The lithographic printing plate precursor allowed to stand under yellow light for I hour as in Example 27 was stored under forced preservation conditions of humidity of 65% and temperature of 45˚C for 3 gays and then subjected to the plate-making and printing in the same manner as in Example 26. Good results same as in Example 26 were obtained.

<Example 29>

A photosensitive layer comprising a photosensitive composition having the constituents shown below was coated on a PET film to have a coating amount of 1.5 g/m$^2$,

| Photosensitize Composition | |
|---|---|
| Binder resin (polymethyl methacrylate) | 91.5 parts by weight |
| Sensitizing dye (Compound 6) | 1.5 parts by weight |
| Initiator compound (A-6) | 5.0 parts by weight |
| Acid decoloration dye (naththalenesulfonate of Victoria Pure Blue) | 2.0 parts by weight |

The blue-colored photosensitive material thus-obtained was exposed with a metal halide lamp for 30 seconds. The blue color was completely decolored to change a transparent film of pale yellow. As described above, using the acid-generation function of the initiation system according to the invention, the photosensitive composition of the invention can be used as an image-forming material utilizing the color-change function.

<Example 3 0>

The same procedure as in Example 29 was repeated except for changing the initiator compound to Initiator compound (A-7). The photo-decoloration of dye in the exposed region was recognized similar to Example 29.

<Example 31>

The same procedure as in Example 29 was repeated except for changing the initiator compound to Initiator compound (A-8). The photo-decoloration of dye in the exposed region was recognized similar to Example 29.

<Example 32>

A photosensitive layer comprising a photosensitive composition having the constituents shown below was coated on a PET film to have a coating amount of 1.5 g/$m^2$.

| Photosensitive Composition | |
|---|---|
| Binder resin (polymethyl methacrylate) | 89 parts by weight |
| Sensitizing dye (Compound 11) | 1.3 parts by weight |
| Initiator compound (A-6) | 7.7 parts by weight |
| Oxidation color-forming dye (leuco Crystal Violet) | 2.0 parts by weight |

The pale yellow transparent photosensitive material thus-obtained was exposed with a metal halide lamp for 30 seconds. As a result, bright blue color was formed. It is believed that the coloration is based on oxidation color-formation of the leuco dye caused by radical formation in the initiation system according to the invention. As described above, using the acid-generation function of the initiation system according to the invention, the photosensitive composition of the invention can be used as an image-forming material utilizing the color-change function.

<Examples 51 to 63 and Comparative Examples 51 to 54>

(Formation of photosensitive layer)

On the aluminum support used in each of Examples 1 to 13, a photosensitive composition having the constituents shown below was coated to have a dry coating amount of 1.5 g/$m^2$ and dried at 80°C for 2 minutes to form a photosensitive layer.

| Photosensitive Composition | |
|---|---|
| Pentaerythritol tetraacrylate | 1.5 g |
| Allyl methacrylate/methacrylic acid/N-isopropylacrylamide copolymer (copolymerization molar ratio: 70/12/18) | 2.0 g |
| Photopolymerization initiation system (shown in Table 3) | shown in Table 3 |
| Sensitizing dye | X g |
| Initiator compound | Y g |
| Co-sensitizer | Z g |
| Fluorine-based nonionic surfactant (F-177P) | 0.03 g |
| Thermal polymerization inhibitor (N-nitrosophenylhydroxylamine aluminum salt) | 0.01 g |
| Methyl ethyl ketone | 20 g |
| Propylene glycol monomethyl ether | 20 g |
| Pigment dispersion shown below | 2.0 g |

| Composition of Pigment Dispersion | |
|---|---|
| Pigment Blue 15:6 | 15 parts by weight |
| Allyl methacrylate/methacrylic acid copolymer (copolymerization molar ratio: 83/17) | 10 parts by weight |
| Cyclohexanone | 15 parts by weight |
| Methoxypropyl acetate | 20 parts by weight |
| Propylene glycol monomethyl ether | 40 parts by weight |

(Formation of protective layer)

On the photosensitive layer, an aqueous solution containing 3% by weight of polyvinyl alcohol (saponification degree: 98% by mole; polymerization degree: 550) was coated to have a dry coating weight of 2 g/$m^2$ and dried at 100˚C for 2 minutes to form a protective layer, thereby preparing a lithographic printing plate precursor.

The lithographic printing plate precursors thus-obtained were subjected to the evaluation of sensitivity in the same manner as in Examples 1 to 13. The results obtained are shown in Table 3.

TABLE 3

| | Initiation System | | | Coating Amount (g/$m^2$) | Clear Sensitivity (mJ/$cm^2$) |
|---|---|---|---|---|---|
| | Sensitizing Dye (Xg) | Initiator Compound (Y g) | Co-Sensitizer (Z g) | | |
| Example 51 | 101 (0.08) | A-1 (0.10) | C-1 (0.2) | 1.5 | 0.71 |
| Example 52 | 101 (0.08) | A-2 (0.15) | C-2 (0.2) | 1.5 | 0.77 |
| Example 53 | 101 (0.08) | A-3 (0.08) | None | 1.5 | 0.80 |
| Example 54 | 101 (0.08) | A-4 (0.08) | C-3 (0.2) | 1.5 | 0.76 |
| Example 55 | 101 (0.08) | A-10 (0.10) | None | 1.5 | 0.68 |
| Example 56 | 101 (0.08) | A-5 (0.12) | C-1 (0.2) | 1.5 | 0.61 |
| Example 57 | 111 (0.08) | A-5 (0.12) | C-2 (0.2) | 1.5 | 0.65 |
| Example 58 | 116 (0.08) | A-5 (0.10) | C-1 (0.2) | 1.5 | 0.64 |
| Example 59 | 121 (0.08) | A-5 (0.10) | C-1 (0.2) | 1.5 | 0.65 |
| Example 60 | 122 (0.08) | A-5 (0.10) | C-1 (0.2) | 1.5 | 0.68 |
| Example 61 | 132 (0.08) | A-5 (0.10) | C-1 (0.2) | 1.5 | 0.70 |
| Example 62 | 135 (0.08) | A-5 (0.10) | C-1 (0.2) | 1.5 | 0.80 |
| Example 63 | 143 (0.08) | A-5 (0.1) | C-1 (0.2) | 1.5 | 0.83 |
| Comparative Example 51 | DR-2 (0.08) | None | None | 1.5 | No image formed |
| Comparative Example 52 | None | A-1 (0.08) | None | 1.5 | No image formed |
| Comparative Example 53 | None | A-2 (0.10) | C-2 (0.5) | 1.5 | No image formed |
| Comparative Example 54 | DR-2 (0.08) | A-1 (0.10) | C-1 (0.2) | 1.5 | 2.00 |

The sensitizing dyes according to the invention used in the photopolymerization initiation system of Table 3 are those described as the specific examples hereinbefore. The structures of Initiator compounds (A-1) to (A-10) and Co-sensitizers (C-1) to (C-3) are same as those described in Examples 1 to 13. Sensitizing dye (DR-2) used in the comparative examples having the structure shown below is a dye compound outside the scope of the invention.

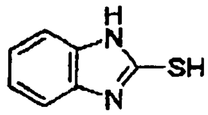

(C-1)

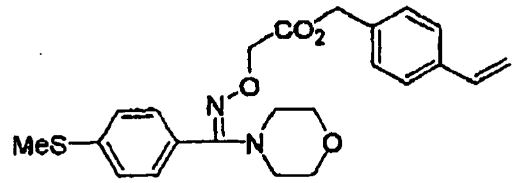

(C-2)

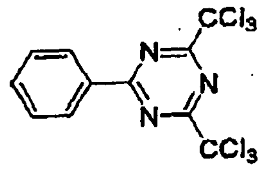

(C-3)

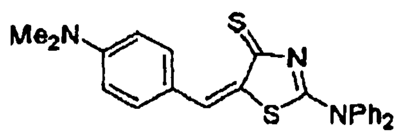

(DR-1)

From the results shown in Table 3, it can be seen that each of the lithographic printing plate precursors using the photosensitive composition according to the invention in the photosensitive layer thereof enables the image formation in high sensitivity, and the photo-initiation system exhibits the sensitivity sufficient for practical use. On the contrary, it is apparent that the image is not formed in Comparative Examples 51 to 53 wherein only the sensitizing dye is used or only the initiator compound is used and that in the lithographic printing plate precursor of Comparative Example 54 using the photo-initiation system in which the initiator compound is combined with the sensitizing dye outside the scope of the invention, the sensitivity sufficient for practical use can not be obtained. From the results of Examples 51 to 63, it can also be seen that the sensitizing dye according to the invention can be used together with the initiator compounds in the wide range irrespective of the sensitization mechanism to prepare the excellent photosensitive composition. Further, it is understood based on the comparison of Examples 56 to 63 with Comparative Example 54 that the structural feature that the sensitizing dye according to the invention exhibits high sensitivity is derived from the structure represented by formula (2) described above.

<Examples 64 to 75 and Comparative Example 55>

On the aluminum support used in each of Examples 1 to 13 were successively formed an inter layer, a photosensitive layer and a protective layer in the manner shown below to prepare a lithographic printing plate precursor.

(Coating of inter layer)

A coating solution for inter layer having the composition shown below was prepared, coated on the surface of the support using a whirler under the condition of 180 rpm so as to have the amount of phenylphosphonic acid coated of 20 mg/m$^2$ and dried at 80°C for 30 seconds to prepare an inter layer.

| Coating Solution for Inter Layer | |
|---|---|
| Phenylphosphonic acid | 0.07 to 1.4 g |
| Methanol | 200 g |

(Formation of photosensitive layer)

A photosensitive composition having the composition shown below was coated on the inter layer using a whirler to have a coating amount of 1.7 g/$m^2$ and dried at 100˚C for 1 minute to form a photosensitive layer.

| Photosensitive Composition | |
|---|---|
| Addition-polymerizable compound (compound shown in Table 4) | 1.6 g |
| Binder polymer (compound shown in Table 4) | 2.0 g |
| Sensitizing dye (compound shown in Table 4) | 0.15 g |
| Initiator compound (compound shown in Table 4) | 0.2 g |
| Co-sensitizer (compound shown in Table 4) | 0.3 g |
| Pigment dispersion shown below | 2.0 g |
| Thermal polymerization inhibitor (N-nitrosophenylhydroxylamine aluminum salt) | 0.01 g |
| Fluorine-based surfactant (Megafac F-177, produced by Dainippon Ink & Chemicals, Inc.) | 0.02 g |
| Methyl ethyl ketone | 20.0 g |
| Propylene glycol monomethyl ether | 20.0 g |

| Composition of Pigment Dispersion | |
|---|---|
| Pigment Blue 15:6 | 15 parts by weight |
| Allyl methacrylate/methacrylic acid copolymer (copolymerization molar ratio: 83/17) | 10 parts by weight |
| Cyclohexanone | 15 parts by weight |
| Methoxypropyl acetate | 20 parts by weight |
| Propylene glycol monomethyl ether | 40 parts by weight |

(Formation of protective layer)

On the photosensitive layer, an aqueous solution containing 3% by weight of polyvinyl alcohol (saponification degree: 98% by mole; polymerization degree: 550) was coated to have a dry coating weight of 2 g/$m^2$ and dried at 100˚C for 2 minutes to form a protective layer, thereby preparing a lithographic printing plate precursor.

The thus-obtained lithographic printing plate precursor was subjected to the exposure, development/plate-making and then the printing durability test of image area, printing durability test of halftone dot image area under forced condition and stain resistance test of non-image area in the same manner as in Examples 14 to 25. The results obtained are shown in Table 4.

In Table 4, the addition-polymerizable compounds, binder polymers and developers are same as those described in Examples 14 to 25, respectively.

TABLE 4

| | Photosensitive Layer | | | | | | Developer | Printing Performance | | |
|---|---|---|---|---|---|---|---|---|---|---|
| | Addition-Polymerizable Compound | Binder Polymer | Sensitizing Dye | Initiator Compound | Co-Sensitizer | Coating Amount ($g/m^2$) | | Printing Durability of Image Area (sheets) | Printing Durability Halftone Dot Image Area | of Stain Resistance Non-Image Area |
| Example 64 | M-1 | B-1 | 101 | A-5 | C-1 | 1.7 | DV-3 | 58,000 | Good | Good |
| Example 65 | M-1 | B-2 | 101 | A-5 | C-1 | 1.7 | DV-2 | 46,000 | Good | Good |
| Example 66 | M-2 | B-1 | 101 | A-10 | C-2 | 1.7 | DV-1 | 40,000 | Good | Good |
| Example 67 | M-2 | B-3 | 101 | A-10 | C-2 | 1.7 | DV-3 | 70,000 | Good | Good |
| Example 68 | M-1 | B-1 | 106 | A-5 | C-1 | 1.7 | DV-3 | 66,000 | Good | Good |
| Example 69 | M-1 | B-2 | 111 | A-5 | C-1 | 1.7 | DV-3 | 61,000 | Good | Good |
| Example 70 | M-2 | B-1 | 116 | A-5 | C-1 | 1.7 | DV-3 | 43,000 | Good | Good |
| Example 71 | M-2 | B-3 | 121 | A-3 | C-1 | 1.7 | DV-3 | 720,000 | Good | Good |
| Example 72 | M-2 | B-3 | 122 | A-5 | C-1 | 1.7 | DV-3 | 69,000 | Good | Good |
| Example 73 | M-2 | B-3 | 132 | A-5 | C-1 | 1.7 | DV-3 | 66,000 | Good | Good |
| Example 74 | M-2 | B-3 | 135 | A-5 | C-1 | 1.7 | DV-3 | 60,000 | Good | Good |
| Example 75 | M-2 | B-3 | 143 | A-5 | C-1 | 1.7 | DV-3 | 58,000 | Good | Good |
| Comparative Example 55 | M-2 | B-3 | None | A-1 | C-2 | 1.7 | DV-3 | Blurred Image | Blurred Image | Good |

From the results shown in Table 4, it can be seen that each of the lithographic printing plate precursors using the photosensitive composition according to the invention in the photosensitive layer thereof in Examples 64 to 75 can provide an excellent lithographic printing plate even under conditions capable of plate-making by scanning exposure with high productivity, that is, under the exposure condition of extremely low energy. On the contrary, in the lithographic printing plate precursor of Comparative Example 55 in which the sensitizing dye according to the invention is not used, a lithographic printing plate suitable for practical use can not be obtained.

<Example 76>

A lithographic printing plate precursor of Example 76 was prepared in the same manner as in Example 51 except that the photo-initiation system of the photosensitive composition used in the photosensitive layer was changed to a photo-initiation system having the composition shown below and that the thickness of the photosensitive layer was changed to 1.5 $g/m^2$.

| Photo-Initiation System | |
|---|---|
| Sensitizing dye (Compound 101) | 0.1 g |
| Initiator compound (A-1) | 0.08 g |
| Co-sensitizer (C-2) | 0.2 g |

(Exposure/Development)

The thus-obtained lithographic printing plate precursor was subjected to scanning exposure using monochromatic light of 400 nm under condition of providing an exposure energy density of 0.25 $mJ/cm^2$. The exposed lithographic printing plate precursor was heated at 100°C for 10 seconds and then subjected to the development processing in the same manner as in Example 51. As a result, a lithographic printing plate having a blue image excellent in visibility was obtained.

(Evaluation of lithographic printing plate)

The thus-obtained lithographic printing plate was subjected to offset printing using a printing machine (KOR-D, produced by Heidelberg). As a result, more than 50,000 sheets of printed materials having excellent image density and excellent image quality without occurrence of stain in the non-image area were obtained.

<Example 77>

The lithographic printing plate precursor described in Example 76 was allowed to stand under yellow light for 1 hour before the exposure and then subjected to the plate-making and printing in the same manner as in Example 76. Good results same as in Example 76 were obtained.

<Example 78>

The lithographic printing plate precursor allowed to stand under yellow light for 1 hour as in Example 77 was stored under forced preservation conditions of humidity of 65% and temperature of 45°C for 3 gays and then subjected to the plate-making and printing in the same manner as in Example 76. Good results same as in Example 76 were obtained.

<Example 79>

A photosensitive layer comprising a photosensitive composition having the constituents shown below was coated on a PET film to have a coating amount of 1.5 $g/m^2$.

| Photosensitive Composition | |
|---|---|
| Binder resin (polymethyl methacrylate) | 91.5 parts by weight |
| Sensitizing dye (Compound 106) | 1.5 parts by weight |
| Initiator compound (A-6) | 5.0 parts by weight |
| Acid decoloration dye (naththalenesulfonate of Victoria Pure Blue) | 2.0 parts by weight |

The blue-colored photosensitive material thus-obtained was exposed with a metal halide lamp for 30 seconds. The blue color was completely decolored to change a transparent film of pale yellow. As described above, using the acid-generation function of the initiation system according to the invention, the photosensitive composition of the invention can be used as an image-forming material utilizing the color-change function.

<Example 80>

The same procedure as in Example 79 was repeated except for changing the initiator compound to Initiator compound (A-7), The photo-decoloration of dye in the exposed region was recognized similar to Example 79.

<Example 81>

The same procedure as in Example 79 was repeated except for changing the initiator compound to Initiator compound (A-8). The photo-decoloration of dye in the exposed region was recognized similar to Example 79.

<Example82>

A photosensitive layer comprising a photosensitive composition having the constituents shown below was coated on a PET film to have a coating amount of 1.5 g/$m^2$.

| Photosensitive Composition | |
|---|---|
| Binder resin (polymethyl methacrylate) | 89 parts by weight |
| Sensitizing dye (Compound 111) | 1.3 parts by weight |
| Initiator compound (A-6) | 7.7 parts by weight |
| Oxidation color-forming dye (leuco Crystal Violet) | 2.0 parts by weight |

The pale yellow transparent photosensitive material thus-obtained was exposed with a metal halide lamp for 30 seconds. As a result, bright blue color was formed. It is believed that the coloration is based on oxidation color-formation of the leuco dye caused by radical formation in the initiation system according to the invention. As described above, using the acid-generation function of the initiation system according to the invention, the photosensitive composition of the invention can be used as an image-forming material utilizing the color-change function.

## Claims

1. A photosensitive composition comprising:

(A) a sensitizing dye selected from the group consisting of compounds represented by formulae (1) and (2) shown below;
(B) an initiator compound capable of generating a radical, an acid or a base; and
(C) a compound capable of changing irreversibly its physical or chemical property with at least one of a radical, an acid and a base:

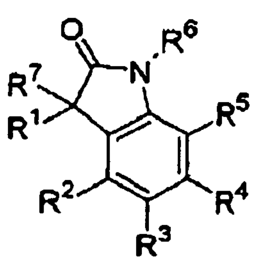

(1)

in formula (1), $R^1$, $R^2$, $R^3$, $R^4$, $R^5$, $R^6$ and $R^7$ each independently represents a hydrogen atom or a monovalent substituent, alternatively $R^1$ or $R^7$ and $R^2$. $R^5$ and $R^6$, or adjacent $R^2$ and $R^3$, $R^3$ and $R^4$, or $R^4$ and $R^5$ may be

combined with each other to form a ring, or $R^1$ and $R^7$ may come together to form an atomic group connected with a double bond to the carbon atom substituted with $R^1$ and $R^7$;

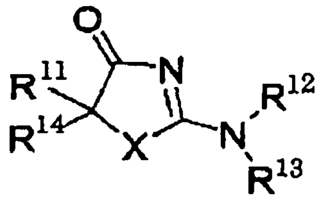 (2)

in formula (2), X represents an oxygen atom, a sulfur atom or -N($R^{15}$)-, $R^{15}$ represents a hydrogen atom or a monovalent substituent, $R^{11}$, $R^{12}$, $R^{13}$ and $R^{14}$ each independently represents a hydrogen atom or a monovalent substituent, alternatively $R^{12}$ and $R^{13}$, $R^{15}$ and $R^{12}$ or $R^{13}$, or $R^{15}$ and $R^{11}$ or $R^{14}$ may be combined with each other to form a ring, or $R^{11}$ and $R^{14}$ may come together to form an atomic group connected with a double bond to the carbon atom substituted with $R^{11}$ and $R^{14}$.

**2.** The photosensitive composition as claimed in claim 1, which further comprises a binder polymer.

**3.** The photosensitive composition as claimed in claim 1, wherein the initiator compound is a hexaarylbiimidazole compound.

**4.** The photosensitive composition as claimed in claim 1, which further comprises a chain transfer agent.

**5.** The photosensitive composition as claimed in claim 1, wherein the compound capable of changing irreversibly its physical or chemical property with at least one of a radical, an acid and a base is an addition polymerizable compound having an ethylenically unsaturated double bond.

**6.** The photosensitive composition as claimed in claim 1, wherein the sensitizing dye has an absorption maximum wavelength of from 350 to 450 nm.

**7.** A photopolymerization method comprising exposing the photosensitive composition as claimed in claim 1 with a laser beam having a wavelength of 450 nm or less.

**8.** A lithographic printing plate precursor comprising a support and a photosensitive layer comprising the photosensitive composition as claimed in claim 1.

## Patentansprüche

**1.** Lichtempfindliche Zusammensetzung die folgendes umfasst:

(A) einen Sensibilisierungsfarbstoff, der ausgewählt ist aus Verbindungen die durch Formeln (1) und (2) unten dargestellt sind;
(B) eine Starterverbindung, die zur Erzeugung eines Radikals einer Säure oder einer Base in der Lage ist; und
(C) eine Verbindung, die in der Lage ist ihre physikalischen oder chemischen Eigenschaften mit mindestens einem Radikal und/oder einer Säure und/oder einer Base irreversibel zu verändern:

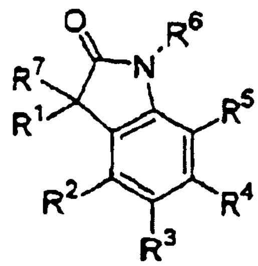

(1)

In Formel (1) ist $R^1$, $R^2$, $R^3$, $R^4$, $R^5$, $R^6$ und $R^7$ jeweils unabhängig voneinander ein Wasserstoffatom oder ein monovalenter Substituent, alternativ können $R^1$ oder $R^7$ und $R^2$, $R^5$ und $R^6$ oder die benachbarten $R^2$ und $R^3$, $R^3$ und $R^4$ oder $R^4$ und $R^5$ jeweils zur Bildung eines Rings miteinander kombiniert werden oder $R^1$ und $R^7$ können zusammen eine Atomgruppe bilden, die mit einer Doppelbindung an dem Kohlenstoffatom verknüpft ist, das mit $R^1$ und $R^7$ substituiert ist;

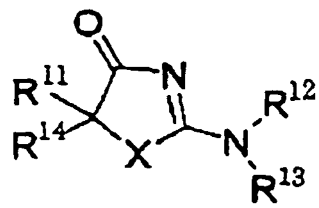

(2)

In Formel (2) ist X ein Sauerstoffatom, ein Schwefelatom oder -N($R^{15}$)-, $R^{15}$ ist ein Wasserstoffatom oder ein monovalenter Substituent, $R^{11}$, $R^{12}$, $R^{13}$ und $R^{14}$ sind jeweils unabhängig voneinander ein Wasserstoffatom oder ein monovalenter Substituent, alternativ können $R^{12}$ und $R^{13}$, $R^{15}$ und $R^{12}$ oder $R^{13}$, oder $R^{15}$ und $R^{11}$ oder $R^{14}$ zur Bildung eines Rings miteinander kombiniert werden oder $R^{11}$ und $R^{14}$ können zusammen eine Atomgruppe bilden, die mit einer Doppelbindung an das Kohlenstoffatom verknüpft ist, das mit $R^{11}$ und $R^{14}$ substituiert ist.

**2.** Lichtempfindliche Zusammensetzung gemäß Anspruch 1, die weiterhin ein Binderpolymer umfasst.

**3.** Lichtempfindliche Zusammensetzung gemäß Anspruch 1, worin die Startverbindung eine Hexaarylbiimidazolverbindung ist.

**4.** Lichtempfindliche Zusammensetzung gemäß Anspruch 1, die weiterhin ein Kettentransfermittel umfasst.

**5.** Lichtempfindliche Zusammensetzung gemäß Anspruch 1, worin die Verbindung, die zur irreversiblen Veränderung ihrer physikalischen oder chemischen Eigenschaften mit mindestens einem Radikal, und/oder einer Säure und/ oder einer Base in der Lage ist, eine additionspolymerisierbare Verbindung ist, die eine ethylenisch ungesättigte Doppelbindung aufweist.

**6.** Lichtempfindliche Zusammensetzung gemäß Anspruch 1, worin der Sensibilisierungsfarbstoff eine Absorptionsmaximumwellenlänge im Bereich von 350 bis 450 nm aufweist.

**7.** Fotopolymerisationsverfahren, das Belichten der lichtempfindlichen Zusammensetzung gemäß Anspruch 1 mit einem Laserstrahl umfasst, der eine Wellenlänge von 450 nm oder weniger aufweist.

**8.** Lithografiedruckplattenvorläufer, der einen Träger und eine lichtempfindliche Schicht umfasst, die die lichtempfindliche Zusammensetzung gemäß Anspruch 1 umfasst.

**Revendications**

1. Composition photosensible comprenant :

(A) une colorant de sensibilisation choisi parmi le groupe consistant en les composés représentés par les formules (1) et (2) ci-dessous ;
(B) un composé initiateur capable de générer un radical, un acide ou une base, et
(C) un composé capable de changer de manière irréversible, sa propriété physique ou chimique par au moins un radical, un acide ou une base :

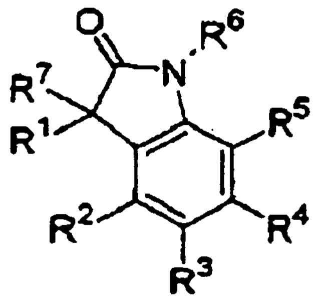

(1)

dans la formule (1), $R^1$, $R^2$ $R^3$, $R^4$, $R^5$ $R^6$ et $R^7$ représentent chacun indépendamment, l'atome d'hydrogène ou un substituant monovalent, en variante $R^1$ ou $R^7$ et $R^2$, $R^5$ et $R^6$, ou $R^2$ et $R^3$, $R^3$ et $R^4$, ou $R^4$ et $R^5$ adjacents peuvent être combinés l'un avec l'autre pour former un cycle, ou $R^1$ et $R^7$ peuvent se rassembler pour former un groupe atomique connecté par une double liaison à l'atome de carbone substitué par $R^1$ et $R^7$ ;

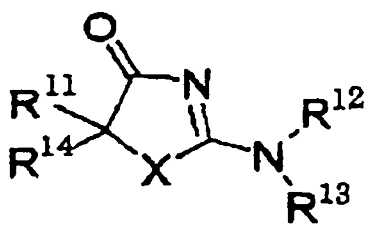

(2)

dans la formule (2), X représente l'atome d'oxygène, l'atome de soufre ou -N($R^{15}$)-, $R^{15}$ représente l'atome d'hydrogène ou un substituant monovalent, $R^{11}$, $R^{12}$, $R^{13}$ et $R^{14}$ représentent chacun indépendamment, l'atome d'hydrogène ou un substituant monovalent, en variante $R^{12}$ et $R^{13}$, $R^{15}$ et $R^{12}$ ou $R^{13}$, ou $R^{15}$ et $R^{11}$ ou $R^{14}$ peuvent être combinés l'un avec l'autre pour former un cycle, ou $R^{11}$ et $R^{14}$ peuvent se rassembler pour former un groupe atomique connecté par une double liaison à l'atome de carbone substitué par $R^{11}$ et $R^{14}$.

2. Composition photosensible selon la revendication 1, qui comprend en outre, un liant polymère.

3. Composition photosensible selon la revendication 1, où le composé initiateur est un composé hexaarylbiimidazole.

4. Composition photosensible selon la revendication 1, qui comprend en outre, un agent de transfert de chaîne.

5. Composition photosensible selon la revendication 1, où le composé capable de changer de manière irréversible sa propriété physique ou chimique par au moins un radical, un acide ou une base est un composé polymérisable par addition ayant une double liaison éthyléniquement insaturée.

6. Composition photosensible selon la revendication 1, où le colorant de sensibilisation a une longueur d'onde d'absorption maximale située dans l'intervalle allant de 350 à 450 nm.

7. Procédé de photo-polymérisation comprenant l'exposition d'une composition photosensible selon la revendication 1, a un faisceau laser ayant une longueur d'onde de 450 nm ou moins.

8. Précurseur de plaque d'impression lithographique comprenant un support et une couche photosensible comprenant la composition photosensible selon la revendication 1.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2000258910 A
- US 6322950 B1
- EP 1471387 A
- EP 1280006 A
- JP 2004272212 A
- DE 2641100
- DE 3333450
- DE 3021590A
- EP 104143 A
- US 4837124 A
- JP 2150848 A
- JP 2096514 A
- EP 370693 A
- EP 233567 A
- EP 297443 A
- EP 297442 A
- EP 279210 A
- EP 422570 A
- US 3902114 A
- US 4933377 A
- US 4760013 A
- US 4734444 A
- US 2833827 A
- US 4743528 A
- JP 63138345 A
- JP 63142345 A
- JP 63142346 A
- JP 46042363 B
- JP 52014727 B
- JP 52014728 B
- JP 52014729 B
- EP 290750 A
- EP 46083 A
- EP 156153 A
- EP 271851 A
- EP 388343 A
- US 3901710 A
- US 4181531 A
- JP 60198538 A
- JP 53133022 A
- EP 199672 A
- EP 84515 A
- EP 441115 A
- EP 101122 A
- US 4618564 A
- US 4371605 A
- US 4431774 A
- JP 6418143 A
- JP 2245756 A
- JP 4365048 A
- JP 62006223 B
- JP 63014340 B
- JP 59174831 A
- JP 1304453 A
- JP 1152109 A
- JP 61166544 A
- GB 1388492 A
- JP 53133428 A
- DE 3337024
- JP 62058241 A
- JP 5281728 A
- US 3567453 A
- US 4343891 A
- EP 109772 A
- EP 109773 A
- JP 59152396 A
- JP 61151197 A
- JP 63041484 A
- JP 2000249 A
- JP 2004705 A
- JP 60003625 A
- US 5102771 A
- US 5206317 A
- US 5212047 A
- JP 4026850 A
- JP 31921731 A
- JP 60010247 A
- JP 62040450 A
- JP 46027926 B
- JP 51047334 B
- JP 57196231 A
- JP 59005240 A
- JP 59005241 A
- JP 2226149 A
- JP 1165613 A
- JP 54021726 B
- JP 48041708 B
- JP 51037193 A
- JP 2032293 B
- JP 2016765 B
- JP 58049860 B
- JP 56017654 B
- JP 62039417 B
- JP 62039418 B
- JP 63277653 A
- JP 63260909 A
- JP 1103238 A
- JP 48064183 A

- JP 49043191 B
- JP 52030490 B
- JP 46043946 B
- JP 1040337 B
- JP 1040336 B
- JP 2025493 A
- JP 61022048 A
- JP 59044615 A
- JP 54034327 B
- JP 58012577 B
- JP 54025957 B
- JP 54092723 A
- JP 59053836 A
- JP 59071048 A
- JP 7120040 B
- JP 7120041 B
- JP 7120042 B
- JP 8012424 B
- JP 63287944 A
- JP 63287947 A
- JP 1271741 A
- JP 10116232 A
- JP 11171909 A
- JP 9236913 A
- JP 48018327 B
- JP 54063902 A
- JP 47005125 B
- US 3658662 A
- JP 46027481 B
- JP 52058602 A
- JP 52030503 A
- JP 56028893 A
- JP 7159983 A
- US 3055295 A
- JP 56013168 A
- JP 9080744 A
- JP W8507727 B
- US 3458311 A
- JP 55049729 A
- JP 57007427 B
- US 3375171 A
- US 3615480 A
- JP 50026601 A
- JP 58054341 A
- JP 56039464 B
- JP 56042860 B
- JP 2002202616 A


**Non-patent literature cited in the description**


- **Bruce M. Monroe et al.** *Chemical Review,* 1993, vol. 93, 435-448
- **R S. Davidson.** *Journal of Photochemistry and Biology A: Chemistry,* 1993, vol. 73, 81-96
- **J. P. Faussier.** Photoinitiated Polymerization-Theory and Applications: Rapra Review. *Rapra Technology,* 1998, vol. 9
- **M. Tsunooka et al.** *Prog. Polym. Sci.,* 1996, vol. 21, 1
- *J. Chem. Soc.,* 1941, 620
- *J. Am. Chem. Soc,* 1951, vol. 73, 5326
- *J. Med. Chem,* 1998, vol. 41, 2588
- *Yakugaku Zasshi,* 1994, vol. 74, 199, 1326
- **Bruce M Monroe et al.** *Chemical Review,* 1993, vol. 93, 435
- **R. S. Davidson.** *Journal of Photochemistry and Biology A: Chemistry,* 1993, vol. 73, 81
- **J. P. Faussier.** Photoinitiated Polymerization- Theory and Applications: Rapra Review. *Report, Rapra Technology,* 1998, 9
- **M. Tsunooka et al.** *Prog. Polym Sci.,* 1996, vol. 21, 1
- **F. D. Saeva.** *Topics in Current Chemistry,* 1990, vol. 156, 59
- **G. G. Maslak.** *Topics in Current Chemistry,* 1993, vol. 168, 1
- **H. B. Shuster et al.** *JACS,* 1990, vol. 112, 6329
- **I. D. F. Eaton et al.** *JACS,* 1980, vol. 102, 3298
- *Polymer Preprints. Jpn.,* 1992, vol. 41 (3), 542
- **M. P. Hutt ; E. F. Elslager ; L. M Merbel.** *Journal of Heterocyclic Chemistry,* 1970, vol. 7, 511
- *J. Pys. Chem.,* 1992, vol. 96, 207
- *J. Imaging Sci.,* 1986, vol. 30, 215
- *Polym. Adv. Technol.,* 1990, vol. 1, 287
- *J. Photopolym. Sci. Technol.,* 1990, vol. 3, 149
- *J. Am. Chem. Soc,* 1990, vol. 112, 6329
- *J. Am. Chem. Soc.,* 1994, vol. 116, 4211
- **Wakabayashi et al.** *Bull. Chem. Soc. Japan,* 1969, vol. 42, 2924
- **F. C. Schaefer et al.** *J. Org. Chem.,* 1964, vol. 29, 1527
- *J. Am. Chem. Soc,* 1986, vol. 108, 128
- *Israel. J. Chem.,* 1986, vol. 25, 264
- Photopolymer Handbook. Kogyo Chosakai, 1989
- *Kobunshi,* 1996, vol. 45, 786
- *ACS. Symp. Ser.,* 1984, vol. 242, 11
- *Nippon Secchaku Kyokaishi,* 1984, vol. 20 (7), 300-308
- **C. Hansch ; A Leo.** Substituent Constants for Correlation Analysis in Chemistry and Biology. J. Wiley & Sons, 1979
- **A. K. Ghose et al.** *J. Comput. Chem.,* 1988, vol. 9, 80